(19) Europäisches Patentamt
European Patent Office
Office européen des brevets

(11) **EP 3 949 018 B1**

(12) **EUROPÄISCHE PATENTSCHRIFT**

(45) Veröffentlichungstag und Bekanntmachung des Hinweises auf die Patenterteilung:
**26.02.2025  Patentblatt 2025/09**

(21) Anmeldenummer: **20715017.8**

(22) Anmeldetag: **25.03.2020**

(51) Internationale Patentklassifikation (IPC):
***H01Q 7/00*** *(2006.01)*

(52) Gemeinsame Patentklassifikation (CPC):
**H01Q 7/005**

(86) Internationale Anmeldenummer:
**PCT/EP2020/058381**

(87) Internationale Veröffentlichungsnummer:
**WO 2020/193639 (01.10.2020 Gazette 2020/40)**

(54) **ERZEUGUNG EINES ABSTIMMSIGNALS ZUR ABSTIMMUNG EINER MAGNETISCHEN ANTENNE**

GENERATION OF A TUNING SIGNAL FOR TUNING A MAGNETIC ANTENNA

GÉNÉRATION D'UN SIGNAL D'ACCORD POUR ACCORDER UNE ANTENNE MAGNÉTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.03.2019  DE 102019204163**

(43) Veröffentlichungstag der Anmeldung:
**09.02.2022  Patentblatt 2022/06**

(73) Patentinhaber: **Fraunhofer-Gesellschaft zur Förderung der angewandten Forschung e.V.
80686 München (DE)**

(72) Erfinder:
- **KILIAN, Gerd
  91058 Erlangen (DE)**
- **BERNHARD, Josef
  91058 Erlangen (DE)**
- **DRÄGER, Tobias
  91058 Erlangen (DE)**
- **LASKE, Christopher
  91058 Erlangen (DE)**
- **OPPELT, Ralph
  91058 Erlangen (DE)**
- **KAMPER, Michael
  91058 Erlangen (DE)**
- **AUER, Felix
  91058 Erlangen (DE)**
- **ERETH, Stefan
  91058 Erlangen (DE)**
- **ULBRICHT, Gerald
  91058 Erlangen (DE)**

(74) Vertreter: **Schlenker, Julian
Schoppe, Zimmermann, Stöckeler Zinkler, Schenk & Partner mbB Patentanwälte
Radlkoferstraße 2
81373 München (DE)**

(56) Entgegenhaltungen:
WO-A1-91/15878      DE-A1- 4 327 917
US-A- 5 225 847      US-A1- 2013 016 018

EP 3 949 018 B1

**Beschreibung**

Ausführungsbeispiele der vorliegenden Erfindung beziehen sich auf eine Abstimmung einer magnetischen Antenne, und im speziellen, auf die Erzeugung eines Abstimmsignals zur Abstimmung der magnetischen Antenne. Manche Ausführungsbeispiele beziehen sich auf einen Teilnehmer eines Kommunikationssystems mit einer magnetischen Antenne und einer Abstimmeinrichtung zur Erzeugung des Abstimmsignals zur Abstimmung der magnetischen Antenne. Manche Ausführungsbeispiele beziehen sich auf eine Erzeugung einer Abstimmspannung.

Herkömmlicherweise werden, vor allem im Bereich der Sensorknoten, elektrische Antennen bzw. elektrisch kurze Antennen eingesetzt. Wird z.B. bei 868 MHz eine heute übliche elektrische Antenne verwendet, wird als ½ Lambda Strahler eine Länge von etwa 15 cm benötigt. Werden kürzere Antennen eingesetzt, sinkt der Gewinn der Antenne. Weiterhin wird die Handhabbarkeit der Geräte mit Antennen eingeschränkt, da die verwendeten Antennen sich bei Annäherung an elektrisch leitende oder dielektrisch wirkende Gegenstände verstimmen und somit ihr Gewinn weiter sinkt. Damit gibt es Anforderungen an die Umgebung von z.B. Sensorknoten. Mit elektrischen Antennen ist es weiterhin nicht möglich, aus elektrisch abgeschirmten Umgebungen (Faraday'scher Käfig) heraus zu senden.

Ferner sind magnetische Antennen bekannt. Durch die hohe Güte sind magnetische Antennen aber sehr schmalbandig. Deshalb müssen magnetische Antennen z.B. bei Annäherung an metallische oder dielektrische Gegenstände auf die gewünschte Frequenz abgestimmt werden.

Wird eine magnetische Antenne in unmittelbarer Nähe zu Materialien betrieben, so können diese, je nach Materialeigenschaft (z.B. leitfähig, dielektrisch, isolierend), die Eigenschaften der Antenne positiv oder negativ beeinflussen. In der Regel werden die magnetischen Antennen durch die umgebenden Materialien verstimmt. D.h. die Resonanzabstimmung ist nicht mehr optimal auf der Betriebsfrequenz oder aber die Anpassung an den Speisewiderstand ist nicht mehr optimal. In der Regel wird beides beeinträchtigt, kann aber durch ein Nachstimmen der Antenne (z.B. durch Änderung des Resonanzkondensators oder Änderung der Ankopplung) korrigiert werden. Dazu ist jedoch ein Nutzereingriff notwendig sowie eine Messgröße mit der eine optimale Einstellung ermittelt werden kann.

Die US 5,225,847 A beschreibt ein automatisches Abstimmsystem für eine Antenne, bei dem mit einem einzelnen variablen Reaktanzelement die an die Antenne übertragene Leistung und die von der Antenne auf der Speiseleitung reflektierte Leistung erfasst werden. Das variable Reaktanzelement der Antenne wird eingestellt, bis das Verhältnis zwischen der gesendeten und der reflektierten Leistung auf der Speiseleitung anzeigt, dass das Stehwellenverhältnis auf der Speiseleitung minimal ist, woraufhin die Antenne abgestimmt wird. Die Einstellung des variablen Reaktanzelements erfolgt durch einen Schrittmotor, der von einem Mikroprozessor gesteuert wird, der so programmiert ist, dass er Berechnungen durchführt, um zu bestimmen, wann das Stehwellenverhältnis ein Minimum erreicht.

Die US 2013/016018 A1 beschreibt ein automatisches Abstimmsystem für eine Schleifenantenne mit einem einzigen elektronisch variablen Reaktanzelement. Die elektronisch variable Reaktanzkomponente der Antenne wird automatisch durch eine Rückkopplungsschleife minimiert, die eine spannungsvariable Kapazität antreibt, bis die reaktive Komponente der Antennenimpedanz praktisch Null ist und die Antennenimpedanz daher resistiv ist. Die Einstellung der elektronisch variablen Kapazität erfolgt durch eine variable Hochspannungsversorgung, die durch einen Rückkopplungsverstärker oder durch einen Hochspannungsrückkopplungsverstärker gesteuert wird.

Der vorliegenden Erfindung liegt die Aufgabe zugrunde, die automatische Abstimmung einer magnetischen Antenne zu verbessern.

Diese Aufgabe wird durch die unabhängigen Patentansprüche gelöst.

Vorteilhafte Weiterbildungen finden sich in den abhängigen Patentansprüchen.

Ausführungsbeispiele schaffen eine magnetisch selbstabgestimmte Antenne.

Ausführungsbeispiele schaffen eine Antennenanordnung mit einer magnetischen Antenne und einer Abstimmeinrichtung. Die magnetische Antenne umfasst eine einfach oder mehrfach unterbrochene Schleife und zumindest ein Abstimmelement [z.B. ein variabler Kondensator oder eine Kapazitätsdiode] zur Abstimmung der magnetischen Antenne. Die Abstimmeinrichtung ist mit dem Abstimmelement verbunden, wobei die Abstimmeinrichtung ausgebildet ist, um ein Steuersignal [z.B. Abstimmspannung] zur Abstimmung der magnetischen Antenne in Abhängigkeit von einer Phasenlage eines in die magnetische Antenne vorlaufenden Signals bereitzustellen, und um das Abstimmelement mit dem Steuersignal anzusteuern, um die magnetische Antenne abzustimmen.

Bei Ausführungsbeispielen kann ein Schleifenumfang der einfach oder mehrfach unterbrochenen Schleife 1/2 bis 1/10 einer Wellenlänge des in die magnetische Antenne vorlaufenden Signals bzw. eines mit der magnetischen Antenne auszusendenden Sendesignals oder zu empfangenden Empfangssignals betragen. Beispielsweise kann die Wellenlänge kleiner gleich als 1,999 m (z.B. bei Frequenzen größer gleich 149 MHz), oder kleiner gleich 0,749 m (z.B. bei Frequenzen größer gleich 400 MHz), oder kleiner gleich 0,375 m (z.B. bei Frequenzen größer gleich 800 MHz) sein.

Bei Ausführungsbeispielen kann eine Frequenz des in die magnetische Antenne vorlaufenden Signals bzw. eines mit der magnetischen Antenne auszusendenden Sendesignals oder zu empfangenden Empfangssignals größer gleich 149 MHz, 400 MHz oder 800 MHz sein oder im Bereich von 149 MHz bis 930 MHz liegen.

Bei Ausführungsbeispielen kann eine Frequenz des in die magnetische Antenne vorlaufenden Signals bzw. eines mit der magnetischen Antenne auszusendenden Sendesignals oder zu empfangenden Empfangssignals innerhalb eines ISM Bands (ISM = Industrial, Scientific and Medical Band) oder SRD Bands (SRD = Short Range Device) liegen, wie z.B. im Bereich von 169,4000-169,8125 MHz, oder im Bereich von 433,05 MHz bis 434,79 MHz, oder im Bereich von 863-870 MHz, oder im Bereich von 902 bis 928 MHz.

Bei Ausführungsbeispielen kann die magnetische Antenne schmalbandig sein. So kann bei Ausführungsbeispielen die magnetische Antenne eine Güte von 20 bis 500 aufweisen. (Hinweis: Bei magnetischen Antennen wird die Bandbreite über die Güte definiert).

Bei Ausführungsbeispielen kann die Abstimmeinrichtung ausgebildet sein, um das Steuersignal zur Abstimmung der magnetischen Antenne in Abhängigkeit von einer Phasenbeziehung zwischen des in die magnetische Antenne vorlaufenden Signals und einem Phasensignal bereitzustellen.

Bei Ausführungsbeispielen kann das Phasensignal auf einem in zumindest einem Abschnitt der Schleife fließenden Strom basieren.

Bei Ausführungsbeispielen kann das Phasensignal auf einem durch die Schleife [bzw. magnetische Antenne] erzeugten Magnetfeld [z.B. im Nahfeld] basieren.

Bei Ausführungsbeispielen kann das Phasensignal eine aus der magnetischen Antenne [z.B. induktiv] ausgekoppelte Leistung sein.

Bei Ausführungsbeispielen kann das Phasensignal ein aus einem Magnetfeld der magnetischen Antenne ausgekoppeltes Signal sein.

Bei Ausführungsbeispielen kann die Antennenanordnung oder die Abstimmeinrichtung eine Koppelschleife aufweisen, die ausgebildet ist, um das Phasensignal bereitzustellen.

Bei Ausführungsbeispielen kann die Abstimmeinrichtung eine Koppelschleife aufweisen, die ausgebildet ist, um Leistung aus der magnetischen Antenne auszukoppeln, um die aus der magnetischen Antenne [z.B. induktiv] ausgekoppelte Leistung zu erhalten.

Beispielsweise können die Schleife der magnetischen Antenne und die Koppelschleife auf derselben Leiterplatte angeordnet bzw. implementiert sein.

Bei Ausführungsbeispielen kann die Abstimmeinrichtung ausgebildet sein, um das Abstimmelement mit dem Steuersignal anzusteuern, um eine Phasendifferenz zwischen des in die magnetische Antenne vorlaufenden Signals und dem Phasensignal auf einen vorgegebenen Sollwert hin zu regeln.

Beispielsweise kann die Abstimmeinrichtung ausgebildet sein, um durch Ansteuerung des Abstimmelements mit dem Steuersignal die Phasendifferenz zwischen des in die magnetische Antenne vorlaufenden Signals und dem Phasensignal auf den vorgegebenen Sollwert hin zu regeln.

Zum Beispiel kann die Abstimmeinrichtung ausgebildet sein, um das Steuersignal nachzuführen, um einer Abweichung der Phasendifferenz zwischen des in die magnetische Antenne vorlaufenden Signals und dem Phasensignal von dem vorgegebenen Sollwert entgegenzuwirken.

Bei Ausführungsbeispielen kann die Abstimmeinrichtung ausgebildet sein, um die Regelung der Phasendifferenz zwischen des in die magnetische Antenne vorlaufenden Signals und dem Phasensignal auf den vorgegebenen Sollwert hin unter Verwendung einer Regelschleife oder einer Feed-Forward-Regelung zu bewirken.

Bei Ausführungsbeispielen kann die Abstimmeinrichtung ausgebildet sein, um von dem in die magnetische Antenne vorlaufenden Signals ein Signal abzuleiten, um ein abgeleitetes Signal zu erhalten, wobei die Abstimmeinrichtung ausgebildet, um das Steuersignal zur Abstimmung der magnetischen Antenne in Abhängigkeit von einer Phasenbeziehung zwischen dem abgeleiteten Signal und dem Phasensignal bereitzustellen.

Beispielsweise kann die Abstimmeinrichtung ausgebildet sein, um das Abstimmelement mit dem Steuersignal anzusteuern, um die Phasendifferenz zwischen dem abgeleiteten Signal und dem Phasensignal auf einen vorgegebenen Sollwert hin zu regeln.

Bei Ausführungsbeispielen kann die Abstimmeinrichtung einen Signalkombinierer [z.B. Multiplizierer] aufweisen, der ausgebildet ist, um

- das Phasensignal oder eine phasenverschobene Version des Phasensignals, und
- das abgeleitete Signal oder eine phasenverschobene Version des abgeleiteten Signals,

zu kombinieren, um ein kombiniertes Signal zu erhalten, wobei die Abstimmeinrichtung ausgebildet ist, um das Abstimmelement mit dem Steuersignal anzusteuern, um einen Gleichanteil des kombinierten Signals oder eine tiefpassgefilterte Version des kombinierten Signals auf einen vorgegebenen Sollwert hin zu regeln.

Bei Ausführungsbeispielen kann die Abstimmeinrichtung einen Phasenschieber aufweisen, der ausgebildet ist, um eines aus dem abgeleiteten Signal und dem Phasensignal phasenzuverschieben, um ein phasenverschobenes Signal zu erhalten, wobei der Signalkombinierer [z.B. Multiplizierer] ausgebildet ist, um das phasenverschobene Signal und das andere aus dem abgeleiteten Signal und dem Phasensignal zu kombinieren, um das kombinierte Signal zu erhalten, wobei der Phasenschieber ausgebildet ist, um das eine aus dem abgeleiteten Signal oder dem Phasensignal derart phasenzuverschieben, dass, im Resonanzfall der magnetischen Antenne, das phasenverschobene Signal und das andere aus dem abgeleiteten Signal und dem Phasensignal am Signalkombinierer eine vordefinierte Phasendifferenz [z.B. 90°] aufweisen.

Bei Ausführungsbeispielen kann die Abstimmeinrichtung einen Energieauskoppler [z.B. einen Richtkoppler oder eine andere Vorrichtung zum Auskoppeln von Energie] aufweisen, der ausgebildet ist, um einen Teil von dem in die magnetische Antenne vorlaufenden Signal auszukoppeln, um das abgeleitete Signal zu erhalten.

Bei Ausführungsbeispielen kann die Abstimmeinrichtung einen Regelverstärker aufweisen, der ausgebildet ist, um das Steuersignal zur Abstimmung der magnetischen Antenne bereitzustellen, wobei der Regelverstärker ausgebildet ist, um das Abstimmelement mit dem Steuersignal anzusteuern, um einen Gleichanteil des kombinierten Signals oder eine tiefpassgefilterte Version des kombinierten Signals auf einen vorgegebenen Sollwert hin zu regeln.

Bei Ausführungsbeispielen kann der Richtkoppler einen ersten Anschluss, einen zweiten Anschluss, einen dritten Anschluss und einen vierten Anschluss aufweisen, wobei der Richtkoppler einen ersten Widerstand [z.B. der Größe Z0/N] aufweist, der zwischen dem ersten Anschluss und dem zweiten Anschluss geschaltet ist, wobei der Richtkoppler einen zweiten Widerstand [z.B. der Größe 2N*Z0] aufweist, der zwischen dem ersten Anschluss und dem dritten Anschluss geschaltet ist, wobei der Richtkoppler einen dritten Widerstand [z.B. der Größe 2N*Z0] aufweist, der zwischen dem zweiten Anschluss und dem vierten Anschluss geschaltet ist, wobei der Richtkoppler einen Transformator aufweist, wobei eine erste Spule des Transformators zwischen dem ersten Anschluss und dem dritten Anschluss geschaltet ist, und wobei eine zweite Spule des Transformators zwischen dem zweiten Anschluss und dem vierten Anschluss geschaltet ist [z.B. wobei die erste Spule und die zweite Spule die gleiche Anzahl an Wicklungen aufweisen].

Bei Ausführungsbeispielen kann der Richtkoppler einen ersten Anschluss, einen zweiten Anschluss, einen dritten Anschluss und einen vierten Anschluss aufweisen, wobei der Richtkoppler einen ersten Widerstand [z.B. der Größe Z0/N] aufweist, der zwischen dem ersten Anschluss und dem zweiten Anschluss geschaltet ist, wobei der Richtkoppler einen zweiten Widerstand [z.B. der Größe 2N*Z0] aufweist, der zwischen dem ersten Anschluss und dem dritten Anschluss geschaltet ist, wobei der Richtkoppler einen dritten Widerstand [z.B. der Größe 2N*Z0] aufweist, der zwischen dem zweiten Anschluss und dem vierten Anschluss geschaltet ist, wobei der Richtkoppler einen Transformator aufweist, wobei eine erste Spule des Transformators zwischen dem ersten Anschluss und dem zweiten Anschluss geschaltet ist, und wobei eine zweite Spule des Transformators zwischen dem dritten Anschluss und dem vierten Anschluss geschaltet ist [z.B. wobei die erste Spule und die zweite Spule die gleiche Anzahl an Wicklungen aufweisen].

Weitere Ausführungsbeispiele umfassen eine Antennenanordnung mit einer magnetischen Antenne und einer Abstimmeinrichtung. Die magnetische Antenne umfasst eine einfach oder mehrfach unterbrochene Schleife und zumindest ein Abstimmelement [z.B. einen variablen Kondensator oder eine Kapazitätsdiode] zur Abstimmung der magnetischen Antenne. Die Abstimmeinrichtung ist mit dem Abstimmelement verbunden, wobei die Abstimmeinrichtung ausgebildet ist, um ein Steuersignal [z.B. Abstimmspannung] zur Abstimmung der magnetischen Antenne in Abhängigkeit einer Amplitude eines Signals, das auf einem durch die Schleife [bzw. magnetische Antenne] erzeugten Magnetfeld [z.B. im Nahfeld] basiert, bereitzustellen, und um das Abstimmelement mit dem Steuersignal anzusteuern, um die magnetische Antenne abzustimmen.

Bei Ausführungsbeispielen kann die Abstimmeinrichtung eine Induktionsschleife oder Induktionsspule aufweisen, die ausgebildet ist, um das Signal, das auf dem durch die Schleife erzeugten Magnetfeld basiert, bereitzustellen.

Bei Ausführungsbeispielen kann die Schleife der magnetischen Antenne und die Induktionsschleife oder die Induktionsspule auf derselben Leiterplatte angeordnet [z.B. implementiert] sein.

Bei Ausführungsbeispielen kann die Abstimmreinrichtung ausgebildet sein, um das Abstimmelement mit dem Steuersignal anzusteuern, um die Amplitude des Signals, das auf dem durch die Schleife erzeugten Magnetfeld basiert, auf einen vorgegebenen Sollwert hin zu regeln [z.B. so dass die Amplitude größer oder gleich einem vorgegebenen Sollwert ist].

Beispielsweise kann die Abstimmeinrichtung ausgebildet sein, um durch Ansteuerung des Abstimmelements mit dem Steuersignal die Amplitude des Signals, das auf dem durch die Schleife erzeugten Magnetfeld basiert, auf den vorgegebenen Sollwert hin zu regeln.

Zum Beispiel kann die Abstimmeinrichtung ausgebildet sein, um das Steuersignal nachzuführen, um einer Abweichung der Amplitude des Signals, das auf dem durch die Schleife erzeugten Magnetfeld basiert, von dem vorgegebenen Sollwert entgegenzuwirken.

Bei Ausführungsbeispielen kann der vorgegebene Sollwert im Vorfeld [z.B. bei einer werkseitigen Kalibrierung] durch eine Referenzmessung im ungestörten Fall der magnetischen Antenne und/oder im Resonanzfall der magnetischen Antenne ermittelt sein.

Bei Ausführungsbeispielen kann die Abstimmeinrichtung ausgebildet sein, um den vorgegebenen Sollwert durch eine Referenzmessung im ungestörten Fall der magnetischen Antenne und/oder im Resonanzfall der magnetischen Antenne zu ermitteln.

Bei Ausführungsbeispielen kann bei der Referenzmessung ein vorgegebenes Signal mit der magnetischen Antenne ausgesendet werden.

Beispielsweise kann das vorgegebene Signal eine vorgegebene Signalform, vorgegebene Sendefrequenz, vorgegebene Bandbreite, vorgegebene Amplitude und/oder vorgegebene Modulationsart aufweisen.

Beispielsweise kann das vorgegebene Signal ein Sinussignal mit einer normierten Sendespannung sein.

Bei Ausführungsbeispielen kann die Abstimmeinrichtung ausgebildet sein, um in Abhängigkeit der Amplitude des Signals, das auf dem durch die Schleife erzeugten Magnetfeld basiert, ein Steuersignalparameter aus einem Satz von hinterlegten Steuersignalparametern, die mit entsprechenden Amplitudenwerten verknüpft sind, auszuwählen, und um das Steuersignal in Abhängigkeit von dem Steuersignalparameter [z.B. Steuersignalamplitude] bereitzustellen.

Bei Ausführungsbeispielen kann die Abstimmeinrichtung ausgebildet sein, um, bei einer breitbandigen Aussendung eines Sendesignals oder einer Aussendung des Sendesignals auf mehreren Frequenzen, eine frequenzabhängige Amplitudenverteilung des Signals, das auf dem durch die Schleife erzeugten Magnetfeld basiert, zu ermitteln, und um das Steuersignal in Abhängigkeit von der frequenzabhängigen Amplitudenverteilung bereitzustellen.

Bei Ausführungsbeispielen kann die Abstimmeinrichtung ausgebildet sein, um, bei einer Aussendung eines Sendesignals auf zumindest zwei unterschiedlichen Frequenzen, eine Abstimmrichtung, in der das Abstimmsignal nachzuregeln ist, basierend auf zumindest zwei durch die zumindest zwei unterschiedlichen Frequenzen des Sendesignals resultierenden Amplituden des Signals, das auf dem durch die Schleife erzeugten Magnetfeld basiert, zu ermitteln, und um das Abstimmsignal in Abhängigkeit der ermitteln Abstimmrichtung nachzuregeln.

Weitere Ausführungsbeispiele schaffen eine Antennenanordnung mit einer Antenne und einer Abstimmeinrichtung. Die Antenne umfasst zumindest ein Abstimmelement [z.B. einen variablen Kondensator oder einer Kapazitätsdiode] zur Abstimmung der Antenne. Die Abstimmeinrichtung ist mit dem Abstimmelement verbunden, wobei die Abstimmeinrichtung ausgebildet ist, um ein Steuersignal zur Abstimmung der Antenne in Abhängigkeit von einer Leistungs- oder Stromaufnahme einer mit der Antenne verbundenen Sendeeinrichtung oder zumindest eines aktiven Bauelements [z.B. Leistungstransistors] der Sendeeinrichtung bereitzustellen, und um das Abstimmelement mit dem Steuersignal anzusteuern, um die Antenne abzustimmen.

Bei Ausführungsbeispielen kann die Antenne eine elektrische Antenne sein.

Bei Ausführungsbeispielen kann die Antenne eine magnetische Antenne mit einer einfach oder mehrfach unterbrochenen Schleife sein.

Bei Ausführungsbeispielen kann die Abstimmeinrichtung ausgebildet sein, um das Abstimmelement mit dem Steuersignal anzusteuern, um die Leistungs- oder Stromaufnahme der Sendeinrichtung oder des zumindest eines aktiven Bauelements der Sendeeinrichtung auf einen vorgegebenen Sollwertebereich hin zu regeln.

Beispielsweise kann die Abstimmeinrichtung ausgebildet sein, um durch Ansteuerung des Abstimmelements mit dem Steuersignal die Leistungs- oder Stromaufnahme der Sendeinrichtung oder des zumindest eines aktiven Bauelements der Sendeeinrichtung auf den vorgegebenen Sollwertebereich hin zu regeln.

Zum Beispiel kann die Abstimmeinrichtung ausgebildet sein, um das Steuersignal nachzuführen, um einer Abweichung der Leistungs- oder Stromaufnahme der Sendeinrichtung oder des zumindest eines aktiven Bauelements der Sendeeinrichtung von dem vorgegebenen Wertebereich entgegenzuwirken.

Bei Ausführungsbeispielen kann der vorgegebene Sollwertebereich [z.B. im Vorfeld / werkseitig] durch eine Systemsimulation unter Annahme einer idealen oder nahezu idealen Anpassung der Antenne ermittelt sein.

Bei Ausführungsbeispielen kann der vorgegebene Sollwertebereich [z.B. im Vorfeld / werkseitig] bei Abschluss der Sendeeinrichtung mit einer vordefinierten Impedanz [z.B. 50 Ohm] ermittelt sein.

Beispielsweise kann die Sendeeinrichtung mit einer vordefinierten Impedanz [z.B. 50 Ohm] abgeschlossen werden und hierbei die Leistungs- oder Stromaufnahme der Sendeeinrichtung ermittelt [z.B. gemessen] werden, um den vorgegebenen Sollwertebereich zu erhalten. Der vorgegebene Sollwertebereich kann beispielsweise der ermittelten Leistungs- oder Stromaufnahme mit einer Toleranz von $\pm$ 10% (oder $\pm$ 5% oder $\pm$3%) entsprechen.

Bei Ausführungsbeispielen kann der vorgegebene Sollwertebereich basierend auf einer Antennenmessung [z.B. mittels eines Antennentuners] ermittelt sein.

Beispielsweise kann bei der Antennenmessung der Punkt der maximalen Abstrahlungsleistung ermittelt werden und die Leistungs- oder Stromaufnahme der Sendeeinrichtung in diesem Punkt ermittelt werden, um den vorgegebene Sollwertebereich zu erhalten. Der vorgegebene Sollwertebereich kann beispielsweise der ermittelten Leistungs- oder Stromaufnahme mit einer Toleranz von $\pm$ 10% (oder $\pm$ 5% oder $\pm$3%) entsprechen.

Bei Ausführungsbeispielen kann der vorgegebene Sollwertebereich [z.B. im Vorfeld / werkseitig] basierend auf einem Mittelwert der Leistungs- oder Stromaufnahme bei kurzgeschlossenem Abschluss und offenem Abschluss der Sendeeinrichtung ermittelt sein.

Beispielsweise kann die Leistungs- oder Stromaufnahme der Sendeeinrichtung bei kurzgeschlossenem Abschluss und mit offenem Anschluss ermittelt und der Mittelwert der Leistungs- oder Stromaufnahme der Sendeeinrichtung bei kurzgeschlossenem Abschluss und mit offenem Anschluss gebildet werden, um den vorgegebene Sollwertebereich zu erhalten.

Der vorgegebene Sollwertebereich kann beispielsweise dem Mittelwert der Leistungs- oder Stromaufnahme mit einer Toleranz von ± 10% (oder ± 5% oder ±3%) entsprechen.

Bei Ausführungsbeispielen kann der vorgegebene Sollwertebereich [z.B. im Vorfeld / werkseitig] basierend auf einer Messung einer Abstrahlungsleistung ermittelt sein.

Beispielsweise kann bei der Messung der Abstrahlungsleistung die maximale Abstrahlungsleistung ermittelt werden und die Leistung- oder Stromaufnahme bei der maximalen Abstrahlungsleistung ermittelt [z.B. gemessen] werden, um den vorgegebene Sollwertebereich zu erhalten. Der vorgegebene Sollwertebereich kann beispielsweise der ermittelten Leistungs- oder Stromaufnahme mit einer Toleranz von ± 10% (oder ± 5% oder ±3%) entsprechen.

Bei Ausführungsbeispielen kann die Abstrahlungsleistung mit einer externen Antenne oder durch die Abstimmeinrichtung selber mit einer Antenne der Abstimmeinrichtung gemessen werden.

Beispielsweise kann die Antenne der Abstimmeinrichtung eine Koppelschleife sein, die auf derselben Platine angeordnet [z.B. implementiert] ist wie die Schleife der magnetischen Antenne.

Bei Ausführungsbeispielen kann die Abstimmeinrichtung ausgebildet sein, um das Steuersignal zur Abstimmung der Antenne in Abhängigkeit einer Stromaufnahme zumindest eines Leistungstransistors eines Verstärkers der Sendeeinrichtung bereitzustellen.

Bei Ausführungsbeispielen kann die Abstimmeinrichtung ausgebildet sein, um das Steuersignal zur Abstimmung der Antenne in Abhängigkeit einer Differenz von Versorgungsströmen von zwei Leistungstransistoren des Verstärkers der Sendeeinrichtung bereitzustellen.

Bei Ausführungsbeispielen kann die Abstimmeinrichtung ausgebildet sein, um das Steuersignal zur Abstimmung der Antenne in Abhängigkeit eines Biasstroms zumindest eines Leistungstransistors des Verstärkers der Sendeeinrichtung bereitzustellen.

Bei Ausführungsbeispielen kann die Abstimmeinrichtung ausgebildet sein, um den Biasstrom des zumindest einen Leistungstransistors durch eine Messung einer Spannung über einen Widerstand im Biaszweig des Leistungstransistors zu ermitteln.

Bei Ausführungsbeispielen kann die Abstimmeinrichtung ausgebildet sein, um das Steuersignal zur Abstimmung der Antenne in Abhängigkeit einer Differenz zwischen Biasströmen zumindest zweier Leistungstransistoren des Verstärkers der Sendeeinrichtung bereitzustellen.

Bei Ausführungsbeispielen kann die Abstimmeinrichtung ausgebildet sein, um das Steuersignal zur Abstimmung der Antenne in Abhängigkeit einer Differenz von Versorgungsströmen eines Balanced-Verstärkers der Sendeeinrichtung bereitzustellen.

Bei Ausführungsbeispielen kann die Abstimmeinrichtung ausgebildet sein, um das Steuersignal zur Abstimmung der Antenne in Abhängigkeit einer Differenz von Versorgungsströmen eines Doherty-Verstärkers der Sendeeinrichtung bereitzustellen.

Bei Ausführungsbeispielen kann die Abstimmeinrichtung ausgebildet sein, um das Steuersignal zur Abstimmung der Antenne in Abhängigkeit einer Differenz von Versorgungsströmen eines Gegentakt-Verstärkers der Sendeeinrichtung bereitzustellen.

Bei Ausführungsbeispielen kann die Abstimmeinrichtung ausgebildet sein, um das Steuersignal zur Abstimmung der Antenne in Abhängigkeit einer Gleichtaktimpedanz der Antenne bereitzustellen.

Bei Ausführungsbeispielen kann die Abstimmeinrichtung ausgebildet sein, um die Gleichtaktimpedanz der Antenne mittels eines Messsignals zu ermitteln.

Bei Ausführungsbeispielen kann die Abstimmeinrichtung ausgebildet sein, um den Stromverbrauch der Sendeeinrichtung bei abwechselnder Einspeisung eines Gegentaktsignals und Gleichtaktsignals in die Antenne zu ermitteln.

Bei Ausführungsbeispielen kann das Gleichtaktsignal mittels eine Baluns, das einen Zugriff auf die Gleichtaktmode ermöglicht, eingespeist werden.

Bei Ausführungsbeispielen kann die Abstimmeinrichtung ausgebildet sein, um das Steuersignal zur Abstimmung der Antenne in Abhängigkeit eines reflektierten Gleichtaktsignals der Antenne bereitzustellen.

Bei Ausführungsbeispielen kann die Abstimmeinrichtung ausgebildet sein, um das reflektierte Gleichtaktsignal mittels eines Baluns, das einen Zugriff auf die Gleichtaktmode ermöglicht, zu ermitteln [z.B. zu messen].

Bei Ausführungsbeispielen kann die Abstimmeinrichtung ausgebildet sein, um das reflektierte Gleichtaktsignal über nichtlineare Eigenschaften eines Magnetkerns des Baluns zu ermitteln [z.B. zu messen].

Bei Ausführungsbeispielen kann die Abstimmeinrichtung ausgebildet sein, um einen magnetischen Gleichstrom des Magnetkerns mittels eines Hallsensors zu ermitteln [z.B. zu messen].

Bei Ausführungsbeispielen kann die Abstimmeinrichtung ausgebildet sein, um einen magnetischen Gleichstrom des Magnetkerns mittels einer Messwicklung am Magnetkern zu ermitteln [z.B. zu messen].

Bei Ausführungsbeispielen kann der Balun ein Ringkoppler sein.

Bei Ausführungsbeispielen kann die Schleife einfach unterbrochen sein, wobei die Schleife durch das Abstimmelement unterbrochen ist.

Bei Ausführungsbeispielen kann die Schleife mehrfach unterbrochen sein, wobei die Schleife durch das Abstimmelement und durch ein oder mehrere Kapazitätselemente unterbrochen ist.

Bei Ausführungsbeispielen kann das Abstimmelement ein variabler Kondensator oder eine Kapazitätsdiode sein.

Weitere Ausführungsbeispiele schaffen einen Teilnehmer eines drahtlosen Kommunikationssystems, wobei der Teilnehmer eine Sende- und/oder Empfangseinrichtung und eine mit der Sende- und/oder-Empfangseinrichtung verbundene Antennenanordnung gemäß einem der hierin beschrieben Ausführungsbeispielen aufweist.

Weitere Ausführungsbeispiele schaffen ein Verfahren zum Abstimmen einer magnetischen Antenne mit einer einfach oder mehrfach unterbrochenen Schleife. Das Verfahren umfasst einen Schritt des Bereitstellens eines Steuersignals zur Abstimmung der magnetischen Antenne in Abhängigkeit von einer Phasenlage eines in die magnetische Antenne vorlaufenden Signals. Ferner umfasst das Verfahren einen Schritt des Ansteuerns eines Abstimmelements der magnetischen Antenne mit dem Steuersignal, um die magnetische Antenne abzustimmen.

Weitere Ausführungsbeispiele schaffen ein Verfahren zum Abstimmen einer magnetischen Antenne mit einer einfach oder mehrfach unterbrochenen Schleife. Das Verfahren umfasst einen Schritt des Bereitstellens eines Steuersignals zur Abstimmung der magnetischen Antenne in Abhängigkeit einer Amplitude eines Signals, das auf einem durch die Schleife erzeugten Magnetfeld basiert. Ferner umfasst das Verfahren einen Schritt des Ansteuerns eines Abstimmelements der magnetischen Antenne mit dem Steuersignal, um die magnetische Antenne abzustimmen.

Weitere Ausführungsbeispiele schaffen ein Verfahren zum Abstimmen einer Antenne. Das Verfahren umfasst einen Schritt des Bereitstellens eines Steuersignals zur Abstimmung der Antenne in Abhängigkeit von einer Leistungs- oder Stromaufnahme einer mit der Antenne verbundenen Sendeeinrichtung oder zumindest eines aktiven Bauelements der Sendeeinrichtung. Ferner umfasst das Verfahren einen Schritt des Ansteuerns eines Abstimmelements der Antenne mit dem Steuersignal, um die Antenne abzustimmen.

Mit den in Ausführungsbeispielen adressierten magnetischen Antennen kann (1) die Baugröße von Teilnehmern eines Kommunikationssystems, wie z.B. von Sensorknoten, verringert werden, (2) durch die automatische Abstimmung eine Unabhängigkeit von der Umgebung geschaffen werden, und/oder (3) aus (teilweise) elektrisch abgeschirmten Umgebungen (besser) herausgesendet/empfangen werden.

Ausführungsbeispiele der vorliegenden Erfindung werden bezugnehmend auf die beiliegenden Figuren näher beschrieben. Es zeigen:

Fig. 1a    eine schematische Ansicht eines Teilnehmers eines Kommunikationssystems, gemäß einem Ausführungsbeispiel der vorliegenden Erfindung,

Fig. 1b    eine schematische Ansicht eines Teilnehmers eines Kommunikationssystems, gemäß einem Ausführungsbeispiel der vorliegenden Erfindung,

Fig. 1c    eine schematische Ansicht eines Endpunkts eines Kommunikationssystems, gemäß einem Ausführungsbeispiel der vorliegenden Erfindung,

Fig. 2    eine schematische Ansicht einer magnetischen Antenne,

Fig. 3    eine schematische Ansicht einer magnetischen Antenne mit einer mehrfach unterbrochenen (z.B. kapazitiv verkürzten) Schleife, gemäß einem Ausführungsbeispiel der vorliegenden Erfindung,

Fig. 4    eine schematische Ansicht einer magnetischen Antenne mit einer mehrfach unterbrochenen Schleife, wobei die Schleife achteckförmig ist, gemäß einem Ausführungsbeispiel der vorliegenden Erfindung,

Fig. 5    eine schematische Ansicht einer Antennenanordnung mit einer ersten magnetischen Antenne und einer zweiten magnetischen Antenne, gemäß einem Ausführungsbeispiel der vorliegenden Erfindung,

Fig. 6a    ein schematisches Blockschaltbild einer Antennenanordnung, gemäß einem Ausführungsbeispiel der vorliegenden Erfindung,

Fig. 6b    ein schematisches Blockschaltbild einer Antennenanordnung, gemäß einem Ausführungsbeispiel der vorliegenden Erfindung,

Fig. 7    ein schematisches Blockschaltbild einer Antennenanordnung, gemäß einem Ausführungsbeispiel der vorliegenden Erfindung,

Fig. 8    in einem Diagramm Phasengänge eines Resonanzkreises aus [1] bei geringer Dämpfung und starker Dämpfung,

Fig. 9 ein schematisches Blockschaltbild einer Antennenanordnung, gemäß einem Ausführungsbeispiel der vorliegenden Erfindung,

Fig. 10a ein schematisches Blockschaltbild eines herkömmlichen Richtkopplers,

Fig. 10b ein schematisches Blockschaltbild eines Richtkopplers, gemäß einem Ausführungsbeispiel der vorliegenden Erfindung,

Fig. 10c ein schematisches Blockschaltbild eines Richtkopplers, gemäß einem weiteren Ausführungsbeispiel der vorliegenden Erfindung,

Fig. 11a ein schematisches Blockschaltbild eines Transformators gemäß einer ersten Anordnung,

Fig. 11b ein schematisches Blockschaltbild eines Transformators gemäß einer zweiten Anordnung,

Fig. 12 ein schematisches Blockschaltbild einer Antennenanordnung, gemäß einem Ausführungsbeispiel der vorliegenden Erfindung,

Fig. 13 ein schematisches Blockschaltbild eines Messaufbaus zur Bestimmung einer Ausgangsleistung und einer reflektierten Leistung einer Antenne,

Fig. 14 ein schematisches Blockschaltbild eines Messaufbaus zur Bestimmung einer idealen Antennenanpassung,

Fig. 15 in einem Smith-Diagramm die Stromaufnahme der Sendeeinrichtung aufgetragen über die Antennenimpedanz,

Fig. 16 in einem Smith-Diagramm die Ausgangsleistung aufgetragen über der Antennenimpedanz,

Fig. 17a in einem Diagramm einen Verlauf eines Realteils R und eines Imaginärteils X der Antennenimpedanz aufgetragen über den Eingangsstrom,

Fig. 17b in einem Diagramm einen Verlauf der Ausgangsleistung aufgetragen über den Eingangsstrom,

Fig. 18 in einem Diagramm einen Verlauf eines Realteils R und eines Imaginärteils X der Antennenimpedanz sowie einen Verlauf der Ausgangsleistung aufgetragen über den Eingangsstrom,

Fig. 19 ein schematisches Blockschaltbild einer Antennenanordnung, gemäß einem Ausführungsbeispiel der vorliegenden Erfindung,

Fig. 20 einen Messaufbau zum Bestimmen der idealen Antennenanpassung, gemäß einem Ausführungsbeispiel der vorliegenden Erfindung,

Fig. 21 ein schematisches Blockschaltbild einer Sendeeinrichtung mit einem Leistungsverstärker, gemäß einem Ausführungsbeispiel der vorliegenden Erfindung,

Fig. 22 ein schematisches Blockschaltbild einer Antennenanordnung, gemäß einem Ausführungsbeispiel der vorliegenden Erfindung,

Fig. 23 ein schematisches Blockschaltbild eines Ringkopplers, der einen Zugriff auf eine Gleichtaktmode eines differentiellen Ports ermöglicht,

Fig. 24 eine schematische Ansicht eines Magnetkerns eines Baluns sowie einer Messwicklung um den Magnetkern zur Erfassung der Gleichtakteigenschaften des Baluns über die nichtlinearen Eigenschaften des Magnetkerns mithilfe der Messwicklung,

Fig. 25    ein Flussdiagramm eines Verfahrens zum Abstimmen einer magnetischen Antenne mit einer einfach oder mehrfach unterbrochenen Schleife, gemäß einem Ausführungsbeispiel der vorliegenden Erfindung,

Fig. 26    ein Flussdiagramm eines Verfahrens zum Abstimmen einer magnetischen Antenne mit einer einfach oder mehrfach unterbrochenen Schleife, gemäß einem Ausführungsbeispiel der vorliegenden Erfindung, und

Fig. 27    ein Flussdiagramm eines Verfahrens zum Abstimmen einer magnetischen oder elektrischen Antenne, gemäß einem Ausführungsbeispiel der vorliegenden Erfindung.

In der nachfolgenden Beschreibung der Ausführungsbeispiele der vorliegenden Erfindung werden in den Figuren gleiche oder gleichwirkende Elemente mit dem gleichen Bezugszeichen versehen, so dass deren Beschreibung untereinander austauschbar ist.

Bevor Ausführungsbeispiele der Erzeugung eines Abstimmsignals zur Abstimmung einer magnetischen Antenne in Abschnitt 2 beschrieben werden, werden zunächst Ausführungsbeispiele einer magnetischen Antenne in Abschnitt 1 beschrieben.

In der nachfolgenden Beschreibung wird dabei beispielhaft davon ausgegangen, dass die magnetische Antenne in einen Teilnehmer eines Kommunikationssystems implementiert werden kann.

1. Ausführung einer magnetischen Antenne

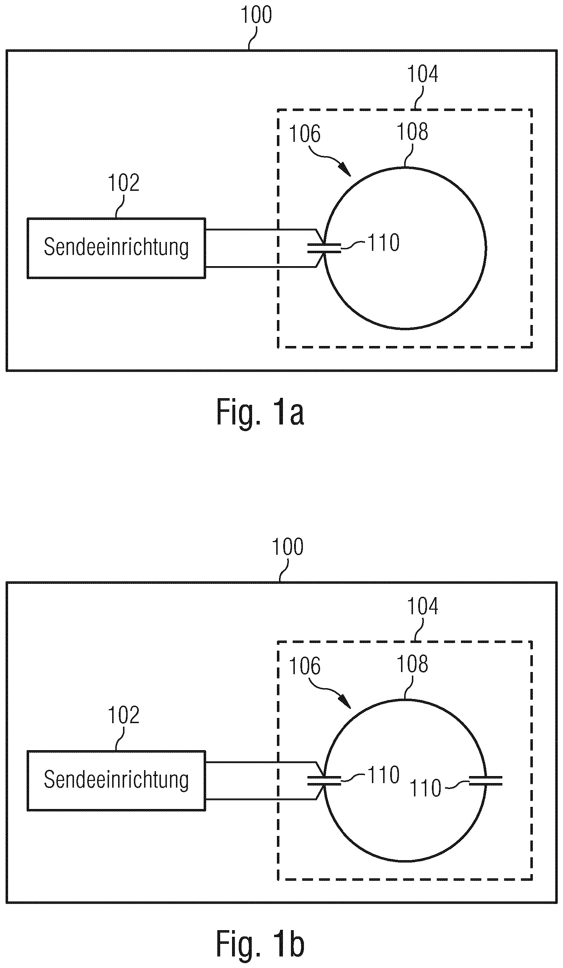

Fig. 1a zeigt eine schematische Ansicht eines Teilnehmers 100 eines Kommunikationssystems, gemäß einem Ausführungsbeispiel der vorliegenden Erfindung. Der Teilnehmer 100 umfasst eine Sende- und/oder Empfangseinrichtung 102 (z.B. einen Transmitter) und eine mit der Sende- und/oder Empfangseinrichtung 102 verbundene Antennenanordnung 104, wobei die Antennenanordnung 104 eine magnetische Antenne 106 mit einer einfach (d.h. nur einmal) unterbrochenen Schleife 108 aufweist.

Fig. 1b zeigt eine schematische Ansicht eines Teilnehmers 100 eines Kommunikationssystems, gemäß einem Ausführungsbeispiel der vorliegenden Erfindung. Der Teilnehmer 100 umfasst eine Sende- und/oder Empfangseinrichtung 102 (z.B. einen Transmitter) und eine mit der Sende- und/oder Empfangseinrichtung 102 verbundene Antennenanordnung 104, wobei die Antennenanordnung 104 eine magnetische Antenne 106 mit einer mehrfach unterbrochenen Schleife 108 aufweist.

Im Folgenden werden primär Ausführungsbeispiele der in Fig. 1b gezeigten Antennenanordnung 104 mit der magnetischen Antenne 106 mit der mehrfach unterbrochenen Schleife beschrieben. Es sei jedoch darauf hingewiesen, dass die im folgenden beschriebenen Ausführungsbeispiele genauso auf die in Fig. 1a gezeigte Antennenanordnung 104 mit der magnetischen Antenne 106 mit der einfach unterbrochenen Schleife anwendbar sind.

Bei Ausführungsbeispielen kann die Schleife 108 der magnetischen Antenne 106 durch Kapazitätselemente 110, wie z.B. Resonanzkapazitäten (Resonanzkondensatoren), unterbrochen sein. Beispielsweise kann die Schleife 108 der magnetischen Antenne 106, wie dies in Fig. 1b zur Veranschaulichung gezeigt ist, durch zwei Kapazitätselemente 110 zweifach unterbrochen (z.B. kapazitiv verkürzt) sein. Es sei jedoch darauf hingewiesen, dass bei Ausführungsbeispielen die Schleife 108 der magnetischen Antenne 106 auch durch eine andere Anzahl von Kapazitätselementen 110 mehrfach unterbrochen sein kann. So kann bei Ausführungsbeispielen die Schleife 108 der magnetischen Antenne 106 durch n Kapazitätselemente 110 in n Segmente (oder Teile, oder Abschnitte) unterteilt sein, wobei n eine natürliche Zahl größer gleich zwei ist. Als Segmente werden dabei hierin die Teile bzw. Abschnitte der Schleife zwischen den jeweiligen Kapazitätselementen 110 bezeichnet.

Bei Ausführungsbeispielen können die Segmente der mehrfach unterbrochenen Schleife 108 durch die Kapazitätselemente 110 verbunden sein. Im Detail können jeweils zwei Segmente der mehrfach unterbrochenen Schleife durch jeweils ein Kapazitätselement, das in Reihe zwischen den zwei Segmenten geschaltet ist, verbunden sein. Mit anderen Worten, die Segmente der Schleife 108 der magnetischen Antenne 106 und die Kapazitätselemente 110 sind abwechselnd in Reihe zu einer Schleife verschaltet.

Die Sende- und/oder Empfangseinrichtung 102 kann dabei mit der magnetischen Antenne 106 über eines der Kapazitätselemente 110 verbunden sein. Das eine Kapazitätselement auf der einen Seite und die mehrfach unterbrochene Schleife 108 mit den anderen (bzw. übrigen) Kapazitätselementen auf der anderen Seite können (z.B. aus Sicht der Sende- und/oder Empfangseinrichtung 102) einen Parallelschwingkreis bilden.

Bei Ausführungsbeispielen kann die Antennenanordnung 102 ferner eine Abstimmeinrichtung zum Abstimmen der magnetischen Antenne 106 aufweisen. Die Abstimmeinrichtung kann dabei ausgebildet sein, um die magnetische Antenne 106 automatisch abzustimmen.

Bedingt durch die geometrische Form der Schleife 108 der magnetischen Antenne 106 wird die Strahlungsenergie von der magnetischen Antenne 106 nicht gleichmäßig in alle Richtungen einer Ebene abgestrahlt. Vielmehr weist das Antennendiagramm der in Fig. 1b gezeigten magnetischen Antenne 106 Nullstellen auf, d.h. es gibt Bereiche (z.B.

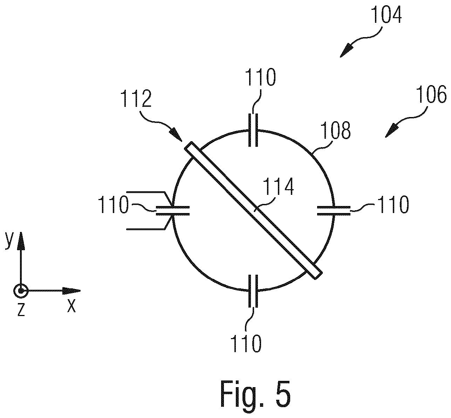

Punkte) im Antennendiagramm, an denen die Strahlungsenergie der magnetischen Antenne praktisch null ist. Bei Ausführungsbeispielen kann die Antennenanordnung 104 daher eine zweite magnetische Antenne aufweisen, wie dies unten anhand von Fig. 5 näher erläutert wird, oder aber auch eine zusätzliche elektrische Antenne. Die zweite magnetische Antenne und/oder die zusätzliche elektrische Antenne können dabei so angeordnet sein, dass die Nullstellen der magnetischen Antenne 106 kompensiert werden.

Bei Ausführungsbeispielen kann der Teilnehmer 100 des Kommunikationssystems natürlich nicht nur ausgebildet sein, um Signale mittels der magnetischen Antenne 106 zu anderen Teilnehmern des Kommunikationssystems zu senden, sondern auch um Signale von anderen Teilnehmern des Kommunikationssystems mittels der magnetischen Antenne 106 zu empfangen. Hierzu kann der Teilnehmer 100 beispielsweise eine Empfangseinrichtung (z.B. einen Receiver) aufweisen, die mit der Antennenanordnung 104 verbunden ist. Natürlich kann der Teilnehmern 100 auch eine kombinierte Sendeempfangseinrichtung (z.B. ein Transceiver) 102 aufweisen.

Bei Ausführungsbeispielen kann der Teilnehmer 100 (bzw. das Kommunikationssystem des Teilnehmers) ausgebildet sein, um im ISM-Band (ISM = Industrial, Scientific and Medical Band) zu kommunizieren, d.h. um Signale im ISM-Band zu senden und/oder zu empfangen.

Bei Ausführungsbeispielen kann der Teilnehmer 100 (bzw. das Kommunikationssystem des Teilnehmers) ausgebildet sein, um Daten basierend auf dem Telegram-Splitting-Verfahren zu übertragen. Beim Telegram-Splitting-Verfahren werden Daten, wie z.B. ein Telegramm oder Datenpaket, in eine Mehrzahl von Sub-Datenpakete (oder Teildatenpakte, oder Teilpakete) aufgeteilt und die Sub-Datenpakete unter Verwendung eines Zeit- und/oder Frequenzsprungmusters in der Zeit und/oder in der Frequenz verteilt (d.h. nicht zusammenhängend) von einem Teilnehmer zu einem anderen Teilnehmer (z.B. von der Basisstation zum Endpunkt, oder vom Endpunkt zur Basisstation) des Kommunikationssystems übertragen, wobei der Teilnehmer, der die Sub-Datenpakete empfängt, diese wieder zusammenfügt (oder kombiniert), um das Datenpaket zu erhalten. Jedes der Sub-Datenpakete enthält dabei nur einen Teil des Datenpakets. Das Datenpaket kann ferner kanalcodiert sein, so dass zum fehlerfreien Decodieren des Datenpakets nicht alle Sub-Datenpakete, sondern nur ein Teil der Sub-Datenpakete erforderlich ist.

Bei Ausführungsbeispielen kann das Kommunikationssystem ein persönliches Netzwerk (engl. Personal Area Network, PAN) oder ein Niedrigenergie-Weitverkehrsnetzwerk (engl. Low Power Wide Area Network, LPWAN) sein.

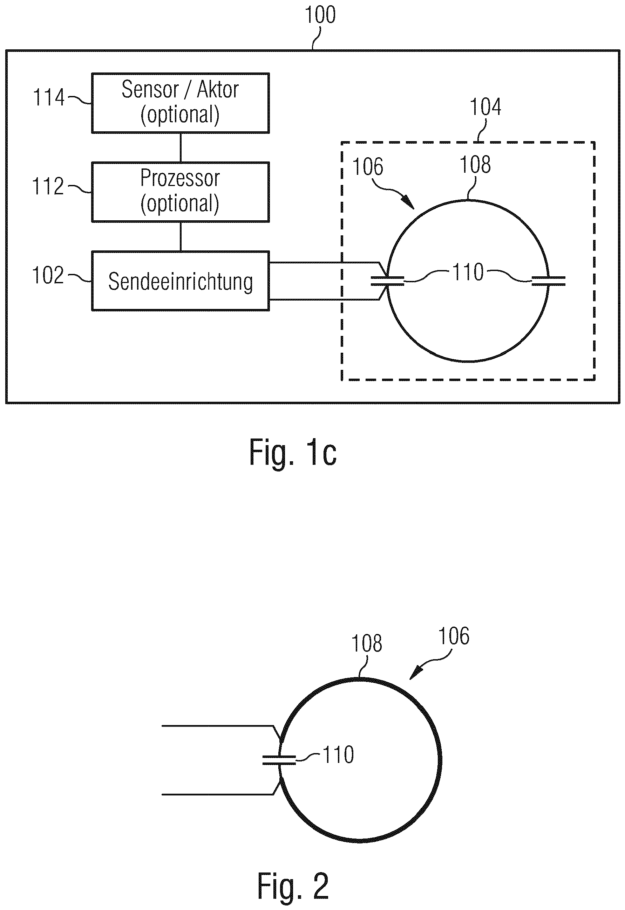

Der in Fig. 1b gezeigte Teilnehmer 100 des Kommunikationssystems kann eine Basisstation des Kommunikationssystems sein. Alternativ kann der in Fig. 1b gezeigte Teilnehmer 100 des Kommunikationssystems auch ein Endpunkt des Kommunikationssystems sein, wie dies nachfolgend anhand von Fig. 1c erläutert wird.

Im Detail zeigt Fig. 1c eine schematische Ansicht eines Teilnehmers 100 des Kommunikationssystems, wobei der Teilnehmer 100 ein Endpunkt ist, gemäß einem Ausführungsbeispiel der vorliegenden Erfindung.

Wie in Fig. 1c beispielhaft gezeigt ist, kann der Endpunkt 100 bei Ausführungsbeispielen ein Sensorknoten sein. Beispielsweise kann der Endpunkt 100 im Falle eines Sensorknotens einen Sensor 114, wie z.B. einen Temperatursensor, Drucksensor, Feuchtigkeitssensor oder irgendeinen anderen Sensor aufweisen, wobei die von dem Sensorknoten 100 gesendeten Signale von einem von dem Sensor bereitgestellten Sensorsignal abhängig sind. Zum Beispiel kann der Sensor einen Mikroprozessor 112 aufweisen, der das von dem Sensor bereitgestellte Sensorsignal verarbeitet, um basierend auf dem Sensorsignal zu übertragene Daten zu generieren, die von der Sendeeinrichtung (z.B. Sende- und Empfangseinrichtung) 102 gesendet werden, z.B. basierend auf dem Telegram Splitting Übertragungsverfahren.

Natürlich kann der Endpunkt 100 auch ein Aktorknoten sein, wobei der Aktorknoten einen Aktor 114 aufweist. In diesem Fall kann der Prozessor 112 beispielsweise ausgebildet sein, um den Aktor 114 basierend auf einem empfangenen Signal bzw. empfangenen Daten anzusteuern.

Bei Ausführungsbeispielen kann der Endpunkt 100 batteriebetrieben sein. Alternativ oder zusätzlich kann der Endpunkt 100 ein Energy Harvesting Element zur elektrischen Energiegewinnung aufweisen.

Im Folgenden werden detaillierte Ausführungsbeispiele der magnetischen Antenne 106 bzw. der Antennenanordnung 104 (z.B. für Sensorknoten oder Basisstationen) beschrieben. Die magnetische Antenne 106 bzw. die Antennenanordnung 104 können dabei für den Sende- und/oder Empfangsfall verwendet werden.

### 1.1. Anwendung von Magnetischen Antennen bei Sensorknoten

Eine magnetische Antenne 106 weist eine ein- oder mehrwindigen Stromschleife 108 auf. Im Empfangsfall induziert ein magnetisches Wechselfeld in der Schleife 108 eine Spannung (Induktionsgesetz), im Sendefall erzeugt ein in der Schleife 108 fließender Strom ein Magnetfeld (Gesetz von Biot-Savart). Soll die magnetische Antenne 106 nur bei einer Frequenz oder einem Bereich kleiner relativer Bandbreite betrieben werden, so kann die magnetische Antenne 106 mittels einer Resonanzkapazität in ihrer Effizienz deutlich gesteigert werden. Der Stromfluss in der Schleife 108 steigt in dem Maße der Resonanzüberhöhung (ausgedrückt durch den Gütefaktor Q), d.h. doppeltes Q bewirkt doppelten Stromfluss (und damit doppeltes Magnetfeld (geht nur mit der Wurzel bei P = konst.; nur bei U = konst. ginge es linear) bei gleicher eingespeister Leistung. Somit ist es erstrebenswert, einen möglichst hohen Q-Faktor zu erzielen, was gleichbedeutend damit ist, dass sowohl die Schleife 108, als auch die Kapazität möglichst geringe Verluste haben müssen. In der Regel überwiegen die Verluste in der Schleife 108 aufgrund der endlichen Leitfähigkeit des verwendeten Metalls (meist Cu).

Fig. 2 zeigt eine schematische Ansicht einer solchen magnetischen Antenne 106. Die magnetische Antenne 106 umfasst, wie bereits erwähnt, die Schleife 108 mit einer oder mehreren Windungen und die Resonanzkapazität 110 (C0). Die magnetische Antenne 106 kann dabei über den aus Resonanzkapazität 110 und Schleife 108 (Spule) gebildeten Parallelschwingkreis z.B. an die Sende- und/oder Empfangseinrichtung 102 (siehe Fig. 1) angekoppelt werden.

Die magnetische Antenne 106 hat den Vorteil einer hohen Antennengüte bei geringer Bauform.

Zudem hat die magnetische Antenne 106 den Vorteil, dass diese an unterschiedliche Umgebungsbedingungen angepasst werden kann, z.B. durch automatische Abstimmung.

Ausführungsbeispiele der vorliegenden Erfindung beziehen sich somit auf einen Sensorknoten mit einer magnetischen Antenne. Die magnetische Antenne kann dabei automatische abgestimmt werden.

<u>1.2 Mehrfache Verkürzung der Schleife (engl. loop) der magnetischen Antenne</u>

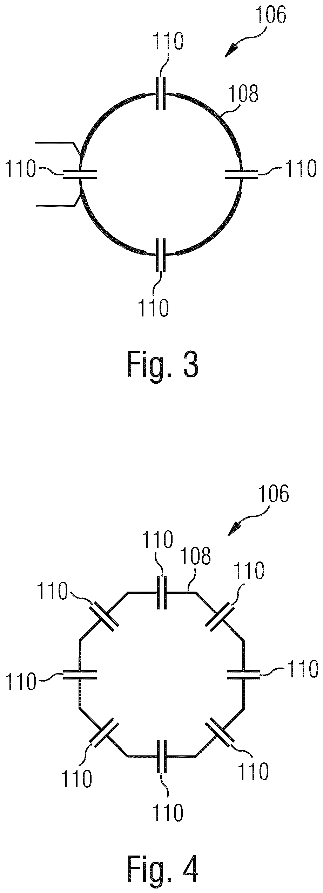

Fig. 3 zeigt eine schematische Ansicht einer magnetischen Antenne 106 mit einer mehrfach unterbrochenen (z.B. kapazitiv verkürzten) Schleife 108. Wie in Fig. 3 beispielhaft gezeigt ist, kann die Schleife 108 durch vier Kapazitätselemente 110 (4C0), wie beispielsweise Resonanzkapazitäten (z.B. Resonanzkondensatoren), in vier Segmente unterteilt sein. Es sei jedoch darauf hingewiesen, dass die Schleife 108 der magnetischen Antenne 106 auch in eine andere Anzahl von Segmenten unterteilt sein kann. So kann die Schleife 108 der magnetischen Antenne 106 bei Ausführungsbeispielen durch n Kapazitätselemente 110 in n Segmente unterteilt sein, wobei n eine natürliche Zahl größer gleich zwei ist.

Bei Ausführungsbeispielen kann die Schleife 108 der magnetischen Antenne in äquidistante Segmente unterteilt sein. Die Unterteilung der Schleife 108 in äquidistante Segmente hat den Vorteil, dass so insgesamt gesehen die niedrigsten E-Feldanteile erzielt werden. Natürlich kann die Schleife aber auch in nicht-äquidistante Segmente unterteilt werden.

Die niedrigeren elektrischen Felder bzw. die mehrfach kapazitive Verkürzung haben zum Vorteil, dass dielektrisches Material in direkter Umgebung der Antenne diese in ihrer Resonanzfrequenz entsprechend weniger verstimmt.

Ferner haben die niedrigeren elektrischen Felder bzw. die mehrfach kapazitive Verkürzung den Vorteil, dass dielektrisches, verlustbehaftetes Material in direkter Umgebung der Antenne deren Gütefaktor weniger herabsetzt.

Ferner haben die niedrigeren elektrischen Felder bzw. die mehrfach kapazitive Verkürzung den Vorteil, dass die Spannung an den Resonanzkapazitäten entsprechend geringer ausfällt (also z.B. halbe Spannung bei doppelter Verkürzung, dann aber auch doppelter Kapazitätswert). Dies ist insbesondere dann von Vorteil, wenn eine oder mehrere der Resonanzkapazitäten abstimmbar ausgeführt werden sollen, da dann die Abstimmorgane eine niedrigere Spannungsfestigkeit aufweisen können

Bei Ausführungsbeispielen kann die magnetische Antenne 106 (bzw. die Schleife 108 der magnetischen Antenne 106) mehrfach kapazitiv verkürzt sein.

Bei Ausführungsbeispielen befinden sich in der Magnetschleife seriell mehrere Kondensatoren 110.

<u>1.3 Besondere Ausführung der Schleife (engl. loop) der magnetischen Antenne</u>

Schleifen 108 mit einer runden Form haben das beste Verhältnis von Leiterbahnlänge zu aufgespannter (oder umschlossener) Fläche. Jedoch ist die Platzausnutzung auf einer üblicherweise rechteckigen Platine (Leiterbahnen) nicht optimal.

Formen mit mehr als vier Ecken, insbesondere die achteckige Form, bieten hier Vorteile. Es verschlechtert sich zwar das Verhältnis von Fläche zu Umfang und damit die Güte der magnetischen Antenne 106, allerdings steigt die Effizienz der magnetischen Antenne 106 bei einer gegebenen rechteckigen Platinenfläche, da die aufgespannte (oder umschlossene) Fläche größer wird. Fig. 4 zeigt eine symmetrische Ausführung (der Schleife 108) der magnetischen Antenne 106, es sind aber auch unsymmetrische Ausführungen (der Schleife 108) denkbar, bei denen z. B. die oberen und unteren Teilstücke (z.B. Segmente der Schleife 108) länger sind.

Im Detail zeigt Fig. 4 eine schematische Ansicht einer magnetischen Antenne 106 mit einer mehrfach unterbrochenen Schleife 108, wobei die Schleife 108 achteckförmig ist.

Wie in Fig. 4 beispielhaft gezeigt ist, kann die Schleife 108 durch (z.B. acht) Kapazitätselemente 110 in acht Segmente unterteilt sein, wobei die acht Segmente eckig sein können, so dass die Schleife 108 eine achteckige Form aufweist. Es sei jedoch darauf hingewiesen, dass die Schleife 108 auch in eine andere Anzahl von Segmenten unterteilt sein kann und/oder eine andere Form aufweisen kann. So kann die Schleife 108 der magnetischen Antenne bei Ausführungsbeispielen m-eckförmig sein, wobei m eine natürliche Zahl größer gleich drei ist, wie z.B. 3, 4, 5, 7, 8, 9, 10, 11 oder 12.

Bei Ausführungsbeispielen kann die magnetische Antenne 106 auf einer Leiterplatte (PCB, printed circuit board) ausgeführt sein.

Bei Ausführungsbeispielen kann die magnetische Antenne 106 (bzw. die Schleife 108 der magnetischen Antenne 106) Teilabschnitte (oder Segmente) aufweisen, die nicht rund sind.

Bei Ausführungsbeispielen kann eine Leitungsführung der Segmente der magnetischen Antenne 106 (bzw. der Schleife 108 der magnetischen Antenne 106) in den Bereichen (oder in den Stellen) mit Bauteilen gerade sein.

Bei Ausführungsbeispielen kann die magnetische Antenne 106 (bzw. die Schleife 108 der magnetischen Antenne 106) eine mehreckige Form oder mehr als vier Ecken aufweisen.

Eine solche magnetische Antenne 106 hat den Vorteil, dass das Layout leichter auf verschiedene Layoutprogramme übertragbar ist.

Ferner hat eine solche magnetische Antenne 106 den Vorteil, dass eine Platzierung der Bauteile einfacher ist, da an den Stellen mit den Bauteilen die Leitungsführung (der Schleife 108 der magnetischen Antenne 106) gerade ist.

Bei manchen Ausführungsbeispielen können die diagonal verlaufenden Seiten (Segmente der Schleife 108 der magnetischen Antenne 106) anstelle einer eckigen Form eine kreisbogenförmige Form aufweisen, um die Fläche noch etwas zu vergrößern und die Platinenfläche optimal auszunutzen. Man würde im Gegenzug die Vorteile der leichteren Bauteilplatzierung und des einfachen Layouts verlieren.

Obwohl die in Fig. 4 gezeigte Antennenanordnung 104 eine magnetische Antenne 106 mit einer mehrfach unterbrochenen Schleife 108 aufweist, sei darauf hingewiesen, dass die beschriebenen Ausführungsbeispiele genauso auf eine Antennenanordnung 104 mit einer magnetische Antennen 106 mit einer einfach unterbrochenen Schleife 108 (vgl. Fig. 1a) anwendbar sind.

### 1.4. Die Schleife wird auf einer Platine realisiert

Bei Ausführungsbeispielen kann die Schleife auf einer Platine (Leiterplatte, engl. printed circuit board (PCB)) realisiert werden.

Bei Ausführungsbeispielen kann auf der gleichen Platine (Leiterplatte) die Abstimmungsschaltung realisiert werden.

### 1.5. Mehrere Antennen

Bei Ausführungsbeispielen kann die Antennenanordnung 104 mehrere magnetische Antennen aufweisen.

Dies hat den Vorteil, dass die Nullstelle (z.B. Punkte im Antennendiagramm, an denen die Strahlungsenergie der magnetischen Antenne praktisch null ist) einer magnetischen Antenne umgangen werden kann.

### 1.5.1 Kreuzfeldloop mit Diversität

Bei Ausführungsbeispielen können zwei magnetische Antennen verwendet werden, wobei die zwei magnetischen Antennen möglichst (z.B. im Wesentlichen) orthogonal sind.

### 1.5.2 Plattgedrückte zweite Schleife (engl. loop) um aus Nullstelle zu kommen

Um ein möglichst flaches Gehäuse zu bekommen, kann die zweite magnetische Antenne (bzw. die Schleife der zweiten magnetischen Antenne) "plattgedrückt" ausgeführt werden. Bei Schleifen (engl. loops), die nicht rund sind, steigt der Widerstand der Wicklung im Vergleich zur aufgespannten (oder umschlossenen) Fläche, wodurch die Güte sinkt. Da bei der plattgedrückten Schleife (engl. loop) eine kleinere Fläche aufspannt wird, sinkt deren Abstrahleffizienz. Das erhöht zwar die Güte wieder etwas, trägt aber nicht zur Abstrahlung bei. Um den ersten gütereduzierenden Effekt zumindest teilweise zu kompensieren, kann ein breiterer Leiter (weniger Verluste) verwendet werden.

Fig. 5 zeigt eine schematische Ansicht einer Antennenanordnung 104 mit einer ersten magnetischen Antenne 106 und einer zweiten magnetischen Antenne 112, gemäß einem Ausführungsbeispiel der vorliegenden Erfindung.

Die erste magnetische Antenne 106 umfasst eine mehrfach unterbrochene Schleife 108. Wie in Fig. 5 beispielhaft gezeigt ist, kann die Schleife 108 der ersten magnetischen Antenne durch vier Kapazitätselemente 110, in vier Segmente unterteilt sein. Es sei jedoch darauf hingewiesen, dass die Schleife 108 der ersten magnetischen Antenne 106 auch in eine andere Anzahl von Segmenten unterteilt sein kann. So kann die Schleife 108 der ersten magnetischen Antenne 106 bei Ausführungsbeispielen durch n Kapazitätselemente 110 in n Segmente unterteilt sein, wobei n eine natürliche Zahl größer gleich zwei ist.

Die zweite magnetische Antenne 112 umfasst ebenfalls eine Schleife 114, wobei die Schleife 108 der ersten magnetischen Antenne 106 und die Schleife 114 der zweiten magnetischen Antenne 112 im Wesentlichen orthogonal zueinander angeordnet sein können.

Wie in Fig. 5 beispielhaft gezeigt ist, verläuft eine durch die Schleife 114 der zweiten magnetische Antenne 112 aufgespannten Fläche orthogonal zu einer durch die Schleife 108 der ersten magnetischen Antenne 106 aufgespannten Fläche. Im Detail verläuft in Fig. 5 die durch die Schleife 108 der ersten magnetischen Antenne 106 aufgespannten Fläche parallel zu der durch das Koordinatensystem definierten xy-Ebene, während die durch die Schleife 114 der zweiten magnetische Antenne 112 aufgespannten Fläche parallel zur oder in der z-Achse des Koordinatensystems verläuft.

Bei Ausführungsbeispielen kann eine aufgespannte (oder umschlossene) Fläche der Schleife 114 der zweiten magnetischen Antenne 112 zumindest um den Faktor zwei (z.B. um den Faktor drei, vier, fünf, oder zehn) kleiner sein als eine aufgespannte (oder umschlossene) Fläche der Schleife 108 der ersten magnetischen Antenne 106.

Mit anderen Worten, die Schleife 114 der zweiten magnetischen Antenne 112 kann "plattgedrückt" sein.

Wie in Fig. 5 ferner angedeutet ist, kann bei Ausführungsbeispielen ein Leiter der Schleife 114 der zweiten magnetischen Antenne 112 zumindest um den Faktor zwei (z.B. um den Faktor drei, vier oder fünf) dicker bzw. breiter sein als ein Leiter der Schleife 108 der ersten magnetischen Antenne 106.

Natürlich kann die Schleife 114 der zweiten magnetischen Antenne 112 ebenfalls mehrfach unterbrochen sein, beispielsweise durch zumindest zwei Kapazitätselemente.

Bei Ausführungsbeispielen kann die Antennenanordnung 104 eine zweite, möglichst orthogonale Schleife 114 aufweisen.

Bei Ausführungsbeispielen kann eine Drahtstärke/Breite der zweiten Schleife (engl. loop) 114 größer sein (als eine Drahtstärke/Breite der ersten Schleife 108), allerdings kann die zweite Schleife 114 flacher sein (als die erste Schleife 108).

Obwohl die in Fig. 5 gezeigte Antennenanordnung 104 magnetische Antennen mit mehrfach unterbrochenen Schleifen aufweist, sei darauf hingewiesen, dass die beschriebenen Ausführungsbeispiele genauso auf eine Antennenanordnung mit magnetischen Antennen mit einfach unterbrochenen Schleifen anwendbar sind.

### 1.5.3 Kombinierte Magnetische / elektrische Antenne um aus Nullstelle zu kommen

Um die Nullstelle (z.B. Punkte im Antennendiagramm, an denen die Strahlungsenergie der magnetischen Antenne praktisch null ist) der magnetischen Antenne 106 zu umgehen, kann zusätzlich zur magnetischen Antenne 106 eine elektrische Antenne auf der Leiterplatte (z.B. PCB) integriert werden, z.B. in Form einer PCB F-Antenne, als "Erweiterung" der Schleife 108 (z.B. des magnetischen Ringes/8-Ecks).

Bei Ausführungsbeispielen können eine elektrische und eine magnetische Antenne (z.B. auf einer Leiterplatte (z.B. PCB)) kombiniert werden.

### 1.5.4. Umschaltung der Schleifen (engl. loops)

Werden mehrere magnetischen Schleifen (bzw. magnetische Antennen) ohne weitere Maßnahmen zusammengeführt, so ergibt sich eine neue Nullstelle aus einer anderen Richtung.

Daher macht die Verwendung mehrerer magnetischer Schleifen (bzw. mehrerer magnetischer Antennen) nur Sinn, wenn die nichtbenutze(n) Schleife(n) (bzw. magnetische(n) Antenne(n)) ausgeschalten werden können.

### 1.5.4.1. Ausschalten durch Unterbrechung des Resonanzstroms

Bei Ausführungsbeispielen kann der Stromfluss der nicht gewünschten magnetischen Antenne beispielsweise mittels eines Schalters unterbrochen werden. Da jeder Schalter aber eine gewisse Restkapazität aufweist, kommt dies letztlich einer starken Verstimmung der Resonanzfrequenz gleich.

### 1.5.4.2. Ausschalten durch zusätzliche Induktivität (L)

Bei Ausführungsbeispielen können einer oder mehrere Resonanzkondensatoren parallel mit einer Spule versehen werden. Diese bilden bei der ursprünglichen Resonanzfrequenz der Schleife (engl. loop) einen Parallelschwingkreis, der den Stromfluss darin unterbricht.

### 1.5.4.3 Ansteuerverhältnis ändern

Bei Ausführungsbeispielen kann durch eine leichte Verstimmung der Eigenresonanz einer der beiden Schleifen die Abstimmung der Schleifen und damit die Hauptabstrahlrichtung und damit die Nullstelle verschoben werden, da die Schleifen dann bei unverändert hohen Ansteuerleistungen unterschiedlich stark abstrahlen. Der nicht abgestrahlte Anteil der leicht verstimmten Schleife wird zurück reflektiert und im Sender absorbiert.

### 1.5.4.4. Phasenverschobene Ansteuerung von mag. Loops

Die Nullstelle einer Schleife hängt von ihrer Struktur im dreidimensionalen Raum ab. Diese ändert sich nicht, wenn beispielweise nur die Kapazität einer Resonanzkapazität geändert wird. Bei planaren Schleifen gibt es also immer eine Stellung, in der diese keine B-Feldlinien durchdringen, nämlich dann, wenn diese in der Ebene der Schleife verlaufen. Aber selbst bei einer dreidimensionalen Schleife (oder gekrümmten B-Linien), also z.B. bei einem nicht exakt in einer Ebene verlaufenden leicht verbogenen Kreisring, findet man immer eine Stellung in der sich Feldlinien, die von einer Seite und von der anderen Seite der Schleife eindringen, die Waage halten. Dies führt zu einer Kompensation, d.h. einer Nullstelle. Selbst orthogonale Schleifen würden unter 45° eine Nullstelle aufweisen, wenn deren Signale nur direkt zusammengeschaltet sind. Um dies vermeiden können deren Empfangssignale unter 90° Phasenversatz zusammengeführt werden, weil dann keine geometrische Auslöschung der Zeitsignale mehr möglich ist.

Bei Ausführungsbeispielen können mehrere magnetische Schleifen (engl. loops) phasenversetzt angesteuert werden.

Bei Ausführungsbeispielen können mehrere selbst abgestimmte magnetische Schleifen (engl. loops) phasenversetzt angesteuert werden.

### 1.5.5. Variation des Abstrahlverhältnisses über der Hop-Nummer

In Zusammenhang mit dem Telegram Splitting Übertragungsverfahren [6] kann Sende-Diversität (also aussenden mit verschiedenen Antennen) pro Telegram durchgeführt werden, da beim Telegram Splitting Übertragungsverfahren ein aussenden jedes Sub-Datenpaketes (Hops) auf einer anderen Antenne / mit unterschiedlicher Stärke auf den Antennen möglich ist.

Dies hat den Vorteil, dass die Übertragungssicherheit eines Telegramms erhöht werden kann.

Bei Ausführungsbeispielen können daher unterschiedliche Sub-Datenpakte (Hops) auf unterschiedlichen Antennen unterschiedlich stark abgestrahlt werden, so dass unterschiedliche Sub-Datenpakte mit unterschiedlichen Antennen-Nullstellen gesendet werden.

### 1.5.5,1. Ausführung der Schleife, bei der die Nullstelle von der Frequenz abhängt

Bei Ausführungsbeispielen können mehr oder weniger orthogonale Schleifen mit unterschiedlicher Resonanzfrequenz, deren Signale beispielsweise per entkoppelten Kombinierer (engl. combinier) zusammengefasst werden, verwendet werden. Liegen die Resonanzfrequenzen dicht beieinander, so müssen die Schleifen bereits gute geometrisch Orthogonalität (d.h. magnetische Entkopplung) aufweisen. Andernfalls gibt es Güteeinbußen und Resonanzverwerfungen. Daher wird die Resonanzfrequenz mit Absicht etwas verstimmt. Unterschiedliche Sub-Datenpakete (Hops) liegen auf unterschiedlichen Frequenzen und werden dadurch von den Schleifen mit unterschiedlichen Resonanzen unterschiedlich stark ausgesendet, dadurch ist die Nullstelle der mag. Antenne jeweils verschoben.

Bei Ausführungsbeispielen ändert sich das Abstrahlverhältnis der magnetischen Antennen über der Frequenz.

Bei Ausführungsbeispielen verschiebt sich die Nullstelle der Antenne über der Frequenz.

### 2. Erzeugung eines Abstimmsignals

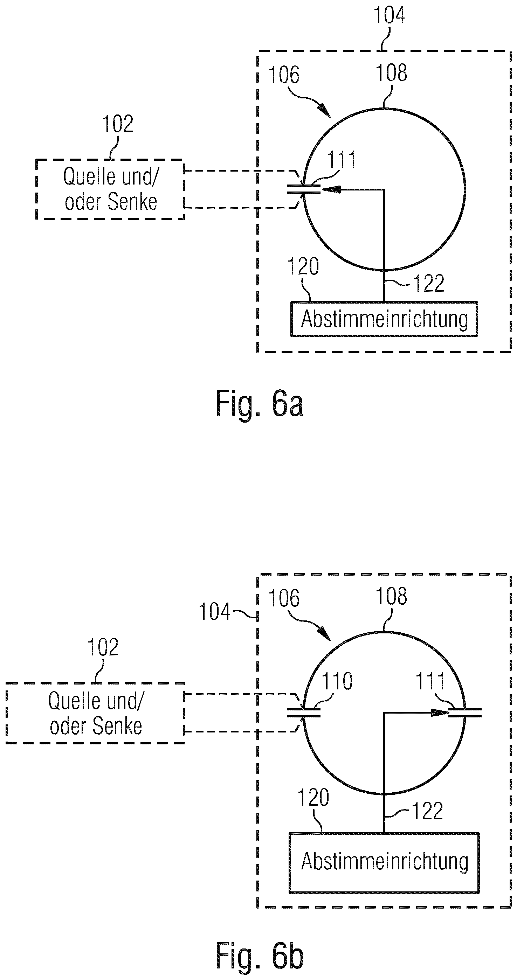

Fig. 6a zeigt ein schematisches Blockschaltbild einer Antennenanordnung 104, gemäß einem Ausführungsbeispiel der vorliegenden Erfindung.

Die Antennenanordnung 104 umfasst eine magnetische Antenne 104 mit einer einfach (d.h. nur einmal) unterbrochenen Schleife 108 und einem Abstimmelement 111 zur Abstimmung der magnetischen Antenne 104.

Die Abstimmeinrichtung 120 ist ausgebildet, um ein Abstimmsignal (z.B. ein Steuersignal) 122 zur Abstimmung der magnetischen Antenne 106 bereitzustellen, und um das Abstimmelement 111 mit dem Abstimmsignal 122 anzusteuern, um die magnetische Antenne 106 abzustimmen.

Bei Ausführungsbeispielen kann die Schleife 108 der magnetischen Antenne durch das Abstimmelement 111 unterbrochen sein, wobei das Abstimmelement 111 eine variable (oder einstellbare) Kapazität (z.B. variable Resonanzkapazität) sein kann. Beispielsweise kann das Abstimmelement 111 ein variabler Kondensator oder eine Kapazitätsdiode sein.

Fig. 6b zeigt ein schematisches Blockschaltbild einer Antennenanordnung 104, gemäß einem Ausführungsbeispiel der vorliegenden Erfindung.

Die Antennenanordnung 104 umfasst eine magnetische Antenne 104 mit einer mehrfach unterbrochenen Schleife 108 und zumindest einem Abstimmelement 111 zur Abstimmung der magnetischen Antenne 104.

Die Abstimmeinrichtung 120 ist ausgebildet, um ein Abstimmsignal (z.B. Steuersignal) 122 zur Abstimmung der magnetischen Antenne 106 bereitzustellen, und um das Abstimmelement 111 mit dem Abstimmsignal 122 anzusteuern, um die magnetische Antenne 106 abzustimmen.

Bei Ausführungsbeispielen kann die Schleife 108 der magnetischen Antenne 106 durch Kapazitätselemente 110, wie z.B. Resonanzkapazitäten (Resonanzkondensatoren), mehrfach unterbrochen sein. Beispielsweise kann die Schleife 108 der magnetischen Antenne 106, wie dies in Fig. 6b zur Veranschaulichung gezeigt ist, durch zwei Kapazitätselemente 110 zweifach unterbrochen (z.B. kapazitiv verkürzt) sein. Es sei jedoch darauf hingewiesen, dass bei Ausführungsbeispielen die Schleife 108 der magnetischen Antenne 106 auch durch eine andere Anzahl von Kapazitätselementen 110 mehrfach unterbrochen sein kann. So kann bei Ausführungsbeispielen die Schleife 108 der magnetischen Antenne 106 durch n Kapazitätselemente 110 in n Segmente (oder Teile, oder Abschnitte) unterteilt sein, wobei n eine natürliche Zahl größer gleich zwei ist. Als Segmente werden dabei hierin die Teile bzw. Abschnitte der Schleife 108 zwischen den jeweiligen Kapazitätselementen 110 bezeichnet.

Das zumindest eine Abstimmelement 111 kann dabei eines der Kapazitätselemente 110 sein, wobei das Abstimmelement 111 als variables Kapazitätselement, z.B. als variable Resonanzkapazität, ausgeführt sein kann. Beispielsweise kann das Abstimmelement 111 ein variabler Kondensator oder eine Kapazitätsdiode sein. Natürlich können auch eine echte Teilmenge oder alle der Kapazitätselemente 110 Abstimmelemente 111 sein, wie z.B. variable Kapazitätselemente (z.B. variable Kondensatoren oder Kapazitätsdioden). Mit anderen Worten, es können auch mehrere Abstimmelemente, z.B. Kapazitätsdioden, sein, wie z.B. an n-1 von n Unterbrechungen.

Wie in den Fig. 6a und 6b beispielhaft angedeutet ist, kann die Antennenanordnung 104 mit einer Quelle und/oder Senke 102, wie z.B. einer Sende- und/oder Empfangseinrichtung (z.B. eines Teilnehmers 100 eines Kommunikationssystems), verbunden sein. Es sei jedoch darauf hingewiesen, dass sich Ausführungsbeispiele der vorliegenden Erfindung primär auf die Antennenanordnung 104 beziehen, welche in einer Vielzahl von unterschiedlichen Anwendungsgebieten implementiert werden kann.

Bei Ausführungsbeispielen kann ein Schleifenumfang der einfach oder mehrfach unterbrochenen Schleife 1/2 bis 1/10 einer Wellenlänge des in die magnetische Antenne vorlaufenden Signals bzw. eines mit der magnetischen Antenne auszusendenden Sendesignals oder zu empfangenden Empfangssignals betragen. Beispielsweise kann die Wellenlänge kleiner gleich als 1,999 m (z.B. bei Frequenzen größer gleich 149 MHz), oder kleiner gleich 0,749 m (z.B. bei Frequenzen größer gleich 400 MHz), oder kleiner gleich 0,375 m (z.B. bei Frequenzen größer gleich 800 MHz) sein.

Bei Ausführungsbeispielen kann eine Frequenz des in die magnetische Antenne vorlaufenden Signals bzw. eines mit der magnetischen Antenne auszusendenden Sendesignals oder zu empfangenden Empfangssignals größer gleich 149 MHz, 400 MHz oder 800 MHz sein oder im Bereich von 149 MHz bis 930 MHz liegen.

Bei Ausführungsbeispielen kann eine Frequenz des in die magnetische Antenne vorlaufenden Signals bzw. eines mit der magnetischen Antenne auszusendenden Sendesignals oder zu empfangenden Empfangssignals innerhalb eines ISM Bands (ISM = Industrial, Scientific and Medical Band) oder SRD Bands (SRD = Short Range Device) liegen, wie z.B. im Bereich von 169,4000 MHz bis 169,8125 MHz, oder im Bereich von 433,05 MHz bis 434,79 MHz, oder im Bereich von 863 MHz bis 870 MHz, oder im Bereich von 902 bis 928 MHz.

Bei Ausführungsbeispielen kann die magnetische Antenne schmalbandig sein. So kann bei Ausführungsbeispielen die magnetische Antenne eine Güte von 20 bis 500 aufweisen. (Hinweis: Bei magnetischen Antennen wird die Bandbreite über die Güte definiert).

Eine magnetische Antenne kann bezüglich ihrer nutzbaren Bandbreite in erster Näherung als Resonanzkreis aufgefasst werden, der am Resonanzpunkt bei der Frequenz $\omega_0 = 2\pi f_0$ definitionsgemäß gleich hohen kapazitiven wie induktiven Blindanteil aufweist:

$$X_C = \frac{1}{\omega_0 C} = X_L = \omega_0 L \coloneqq X_0$$

Die Verluste der Antennen können in einen parallelen oder seriellen Verlustwiderstand $R_p$ bzw. $R_s$ zusammengefasst werden, wobei beide Ersatzmodelle gemäß $R_p R_s = X_0^2$ ineinander umgerechnet werden können. Wenig Verluste bedeuten ein hohes $R_p$ bzw. ein niedriges $R_s$. Als Güte $Q$ bezeichnet man die dimensionslose Größe $Q = \frac{R_p}{X_0} = \frac{X_0}{R_s}$, welche also mit abnehmenden Verlusten steigt. Als nutzbare Bandbreite $\Delta\omega$ einer magnetischen Antenne wird i.a. der Wert

$$\Delta\omega = \frac{\omega_0}{Q}$$

angesehen. Diese verringert sich also bei steigender Güte.

Prinzipiell wird eine hohe Güte angestrebt, weil sich bei gleicher eingespeister Leistung ein entsprechend höherer Resonanzstrom einstellt, welcher wiederum direkt proportional zur Höhe des erwünschten magnetischen Feldes ist. Man muss allerdings zwischen zwei Effekten unterscheiden:

1) Güteeinbuße aufgrund von Verlusten der Antennenelemente selbst. Diese sind im Wesentlichen über die Verluste des Leitermaterials (meist Cu) gegeben. Dieser z.B. seriell zu denkende Verlustwiderstand kann über den skineffektbedingten reduzierten Leiterquerschnitt und die Leiterlänge nach den bekannten Gesetzen ermittelt werden. Bei stark unregelmäßig geformtem Leiterquerschnitt spielt auch die Stromverteilung darin eine Rolle. Im Vergleich dazu sind die vorwiegend dielektrischen Verluste in dem/den Resonanzkondensator(en) vernachlässigbar, solange man ausreichend hochwertige Kondensatoren verwendet.

2) Güteeinbuße aufgrund der Abstrahlung der Antenne ("Abstrahlverluste"). Dieser Effekt ist ja erwünscht. Sie werden im Modell als (seriell zu denkender) Strahlungswiderstand $R_s$ bezeichnet und errechnen sich für aus einer Windung bestehende Loop-Antennen ohne Zusatz von ferromagnetischem Material, mit einem Umfang $U \ll \frac{\lambda_0}{4}$ gemäß [8]

$$R_S = \frac{\pi}{6} Z_0 \left( \frac{U}{\lambda_0} \right)^4$$

Hierbei ist $Z_0 = 120\pi\,\Omega$ der Wellenwiderstand des Vakuums und $\lambda_0$ die Vakuumwellenlänge bei der Resonanzfrequenz. Verdoppelung des Loopdurchmessers bedeutet also 16-fach höheres $R_s$. Je kleiner nun der Strahlungswiderstand $R_s$ desto mehr fallen die Verluste der Antennenelemente ins Gewicht. Doch selbst bei einer ideal verlustfreien Antenne verbleibt das Problem, dann einen sehr kleinen Wert $R_s$ an die Quellimpedanz des Senders (meist ca. 50 Ohm) anzupassen. Die Verluste des dazu nötigen Anpassnetzwerkes fallen dann immer mehr ins Gewicht. Letztlich wandert fast die ganze eingespeiste Leistung in das Anpassnetzwerk. Ein Beispiel: Eine Loop mit $U \ll \frac{\lambda_0}{8}$ hat nur einen Strahlungswiderstand von 0,048 Ohm.

Auch wenn diese Formel für größere Antennen, die obiger Voraussetzung $U \ll \frac{\lambda_0}{4}$ nicht mehr genügen, nicht mehr exakt gilt, so bewirkt dennoch eine Durchmesser- bzw. Umfangsvergrößerung einen Anstieg des Strahlungswiderstandes.

Im Folgenden werden detaillierte Ausführungsbeispiele der Erzeugung des Abstimmsignals 122 (z.B. Abstimmregelgröße bzw. Abstimmspannung) beschrieben.

Obwohl in den folgenden Ausführungsbeispielen manchmal auf eine magnetische Antenne 106 mit einer einfach unterbrochenen Schleife 108 und manchmal auf eine magnetische Antenne 106 mit einer mehrfach unterbrochen Schleife 108 Bezug genommen wird, sei darauf hingewiesen, dass diese Ausführungsbeispiele genauso auch auf die jeweils andere Ausführung der magnetischen Antenne 106 anwendbar sind.

2.1. Erzeugung eines Abstimmsignals (z.B. Abstimmspannung) durch Phasenauswertung

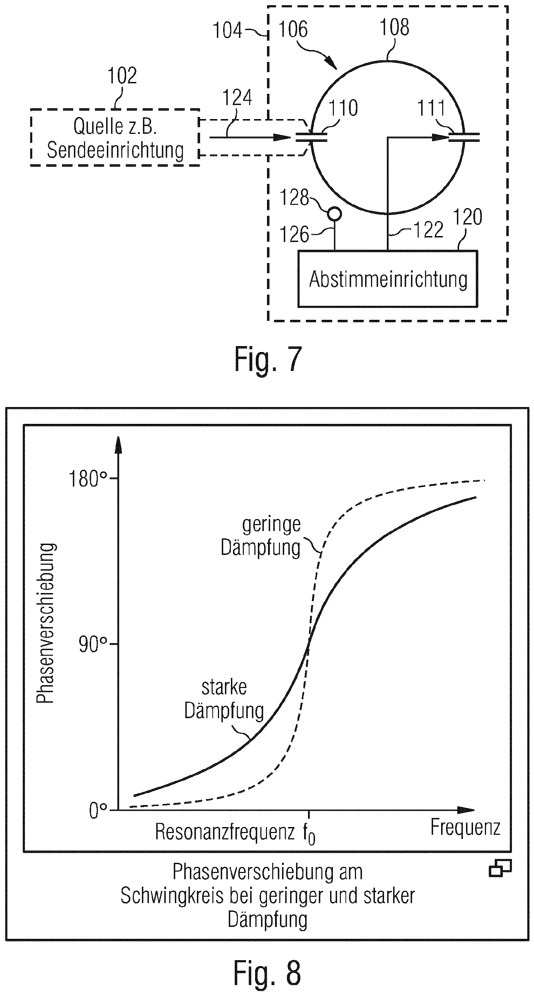

Fig. 7 zeigt ein schematisches Blockschaltbild einer Antennenanordnung 104, gemäß einem Ausführungsbeispiel der vorliegenden Erfindung. Die Antennenanordnung 104 umfasst die magnetische Antenne 106 mit dem Abstimmelement 111 und die Abstimmeinrichtung 120 zur Abstimmung der magnetischen Antenne 106.

Die Abstimmeinrichtung 120 ist ausgebildet, um das Abstimmsignal 122 zur Abstimmung der magnetischen Antenne 106 in Abhängigkeit von einer Phasenlage eines in die magnetische Antenne 106 vorlaufenden Signals 124 (z.B. vorlaufenden Leistung oder vorlaufenden Welle) bereitzustellen, und um das Abstimmelement 111 mit dem Abstimmsignal 122 anzusteuern, um die magnetische Antenne 106 abzustimmen.

Bei Ausführungsbeispielen kann die Abstimmeinrichtung 120 ausgebildet sein, um das Abstimmsignal 122 zur Abstimmung der magnetischen Antenne 106 in Abhängigkeit von einer Phasenbeziehung zwischen des in die magnetische Antenne vorlaufenden Signals 124 (z.B. vorlaufenden Leistung) und einem Phasensignal 126 bereitzustellen.

Das Phasensignal 126 kann auf einem in zumindest einem Abschnitt der Schleife 108 fließenden Strom und/oder auf einem durch die Schleife 108 bzw. magnetische Antenne 106 erzeugten Magnetfeld (z.B. im Nahfeld) basieren.

Das Phasensignal 126 kann eine aus der magnetischen Antenne 106 (z.B. induktiv) ausgekoppelte Leistung sein.

Beispielsweise kann die Antennenanordnung 104 eine Koppelschleife 128 aufweisen, die ausgebildet ist, um Leistung aus der magnetischen Antenne 106 auszukoppeln, um die aus der magnetischen Antenne (z.B. induktiv)

ausgekoppelte Leistung zu erhalten. Die Schleife 108 der magnetischen Antenne 106 und die Koppelschleife 128 können auf derselben Leiterplatte angeordnet bzw. implementiert sein.

Bei Ausführungsbeispielen kann die Abstimmeinrichtung 120 ausgebildet sein, um das Abstimmelement 111 mit dem Abstimmsignal 122 anzusteuern, um eine Phasendifferenz zwischen des in die magnetische Antenne vorlaufenden Signals 124 (z.B. vorlaufenden Leistung oder vorlaufenden Welle) und dem Phasensignal 126 auf einen vorgegebenen Sollwert hin zu regeln.

Beispielsweise kann die Abstimmeinrichtung ausgebildet sein, um durch Ansteuerung des Abstimmelements mit dem Steuersignal die Phasendifferenz zwischen des in die magnetische Antenne vorlaufenden Signals 124 (z.B. vorlaufenden Leistung) und dem Phasensignal auf den vorgegebenen Sollwert hin zu regeln.

Zum Beispiel kann die Abstimmeinrichtung ausgebildet sein, um das Steuersignal nachzuführen, um einer Abweichung der Phasendifferenz zwischen des in die magnetische Antenne vorlaufenden Signals 124 (z.B. vorlaufenden Leistung) und dem Phasensignal von dem vorgegebenen Sollwert entgegenzuwirken.

Bei Ausführungsbeispielen kann die Abstimmeinrichtung ausgebildet sein, um die Regelung der Phasendifferenz zwischen des in die magnetische Antenne vorlaufenden Signals 124 (z.B. vorlaufenden Leistung) und dem Phasensignal auf den vorgegebenen Sollwert hin unter Verwendung einer Regelschleife oder einer Feed-Forward-Regelung zu bewirken.

Im Folgenden wird die Funktionsweise des in Fig. 7 gezeigten Ausführungsbeispiels der Erzeugung des Abstimmsignals 122 detailliert beschrieben.

Die Transmissionsmessung eines Resonanzkreises weist an der Resonanzstelle ein Betragsmaximum und einen Phasenwendepunkt auf. Je nach Kopplungsgrad der speisenden Quelle mit dem Kreis kann dieser zwischen 90° (lose Kopplung, siehe [1]) und 0° (feste Kopplung, siehe [2] bzw. Fig. 8) liegen.

Im Detail zeigt Fig. 8 in einem Diagramm Phasengänge eines Resonanzkreises aus [1] bei geringer Dämpfung und starker Dämpfung. Dabei beschreibt in Fig. 8 die Ordinate die Phasenverschiebung in Grad und die Abszisse die Frequenz.

Der Phasengang ist eine monoton steigende *arctan*-Funktion, die von einem Wert $\varphi 0$ (bei $f = 0$) bis zu einem Wert $\varphi 0 + 180°$ (bei $f \rightarrow \infty$) verläuft (siehe Fig. 8). Der Wert bei Resonanz ist dann $\varphi R = \varphi 0 + 90°$ und ist ein Wendepunkt. Bisweilen wird die Phase mit negativem Vorzeichen gezählt, dann gilt obenstehendes entsprechend (aus monoton steigend wird monoton fallend usw., (siehe [2]).

Ausführungsbeispiele nutzen diesen Sachverhalt für eine automatische Frequenznachregelung aus, indem die Phasenlage des in die Schleife 108 (engl. loop) vorlaufenden Signals 124 (z.B. vorlaufenden Leistung) mit einer z.B. über eine kleine Koppelschleife 128 von der Schleife 108 induktiv ausgekoppelten Leistung verglichen wird. Zur Ermittlung der Phasenlage des vorlaufenden Signals 124 (z.B. vorlaufenden Leistung) kann beispielsweise ein Richtkoppler herangezogen werden. Zudem entsteht über unterschiedliche Leitungslängen bis zu dem Ort, wo der Phasenvergleicher auf der Platine angeordnet ist, ein weiterer Phasenversatz. Bei manchen Ausführungsbeispielen wird daher in eine der beiden zum Phasenvergleicher laufenden Leitungen einen Phasenschieber $\Delta\varphi 0$ eingefügt, sodass bei Resonanz dort die beiden Signale genau eine Phasendifferenz von z.B. 90° aufweisen.

Phasenvergleicher sind aus der Literatur hinreichend bekannt. Die dafür häufig eingesetzte Gilbert-Zelle (siehe [4]) wirkt im Prinzip wie ein Multiplizierer. Zwei sinusförmige Zeitsignale mit um $\Delta\varphi$ von 90° abweichender Phasenverschiebung ergeben nach Multiplikation folgendes Ausgangssignal:

$$\sin(\omega t + \Delta\varphi)\cos(\omega t) = \frac{1}{2}\left[\sin(\Delta\varphi) + \sin(2\omega t + \Delta\varphi)\right]$$

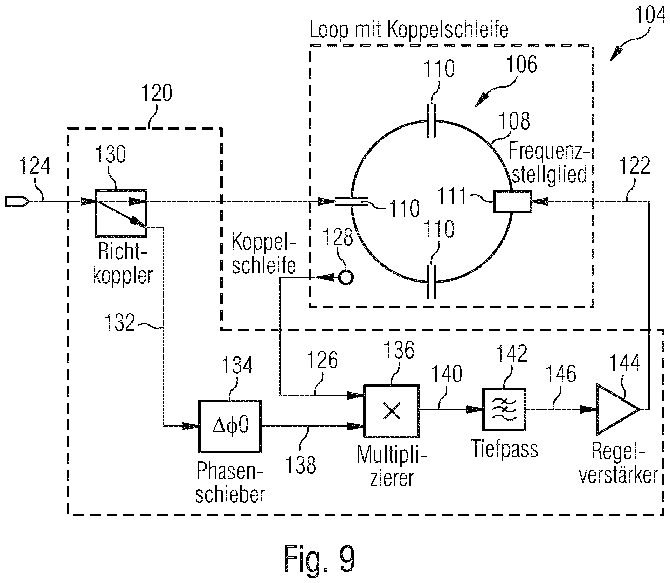

(die Amplituden sind hier der Einfachheit halber auf 1 normiert). Der Anteil mit der doppelten Frequenz $2\omega t$ lässt sich leicht mit einem Tiefpass ausblenden, so dass der Gleichanteil $\sim\sin(\Delta\varphi)$ übrig bleibt. Da die Sinusfunktion eine ungerade Funktion ist, resultiert also eine Regelgröße, die um den Arbeitspunkt 90° herum ihr Vorzeichen wechselt und nur bei exakt 90° Null ergibt. Bei vorzeichenrichtig geschlossener Regelschleife wird die Resonanzfrequenz der Schleife 108 also aufgrund der quasi unendliche hohen Regelverstärkung so lange nachgeregelt, bis die Spannung am Multiplizierausgang verschwindet, was gleichbedeutend damit ist, dass die beiden Spannungen am Multipliziereingang 90° Phasenverschiebung aufweisen. Nach den obigen Ausführungen ist die Schleife 108 bei der eingespeisten Frequenz dann in Resonanz. Fig. 9 zeigt ein Blockschaltbild der beschriebenen Anordnung. Der Phasenschieber ist hier im Auskoppelpfad des Richtkopplers eingezeichnet. Wie schon erwähnt, kann er auch im Pfad der Koppelschleife eingeschleift sein. Dies kann vorzugsweise so gewählt werden, dass die jeweils kleinere Phasenverschiebung benötigt wird.

Im Detail zeigt Fig. 9 ein schematisches Blockschaltbild einer Antennenanordnung 108, gemäß einem Ausführungsbeispiel der vorliegenden Erfindung. Die Antennenanordnung 108 umfasst die magnetische Antenne 106 und die Abstimmeinrichtung 120.

Wie in Fig. 9 gezeigt ist, kann die Abstimmeinrichtung 120 ausgebildet sein, um von dem in die magnetische Antenne 106 vorlaufenden Signal 124 (z.B. vorlaufenden Leistung) ein Signal abzuleiten (z.B. abzuzweigen), um ein abgeleitetes (z.B. abgezweigtes) Signal 132 zu erhalten. Die Abstimmeinrichtung 120 kann dabei ausgebildet sein, um das Abstimmsignal 122 zur Abstimmung der magnetischen Antenne 106 in Abhängigkeit von einer Phasenbeziehung zwischen dem abgeleiteten Signal 132 und dem Phasensignal 126 bereitzustellen.

Beispielsweise kann die Abstimmeinrichtung 120 ausgebildet sein, um das Abstimmelement 111 mit dem Abstimmsignal 122 anzusteuern, um die Phasendifferenz zwischen dem abgeleiteten Signal 132 und dem Phasensignal 126 auf einen vorgegebenen Sollwert hin zu regeln.

Bei Ausführungsbeispielen kann die Abstimmeinrichtung 120 ferner einen Signalkombinierer 136 (z.B. Multiplizierer oder Subtrahierer) aufweisen, der ausgebildet ist, um (1) das Phasensignal 126 oder eine phasenverschobene Version des Phasensignals, und (2) das abgeleitete Signal 132 oder eine phasenverschobene Version 138 des abgeleiteten Signals 132, zu kombinieren, um ein kombiniertes Signal 140 zu erhalten. Die Abstimmeinrichtung 120 kann dabei ausgebildet sein, um das Abstimmelement 111 mit dem Abstimmsignal 122 anzusteuern, um (1) einen Gleichanteil des kombinierten Signals 140 oder (2) eine tiefpassgefilterte Version 146 des kombinierten Signals 140 auf einen vorgegebenen Sollwert hin zu regeln.

Bei Ausführungsbeispielen kann die Abstimmeinrichtung 120 ferner einen Phasenschieber 134 aufweisen, der ausgebildet sein kann, um eines aus dem abgeleiteten Signal 132 und dem Phasensignal 126 phasenzuverschieben, um ein phasenverschobenes Signal 138 zu erhalten. Der Signalkombinierer (z.B. Multiplizierer oder Subtrahierer) 136 kann ausgebildet sein kann, um das phasenverschobene Signal 138 und das andere aus dem abgeleiteten Signal 132 und dem Phasensignal 126 zu kombinieren, um ein kombiniertes Signal 140 zu erhalten. Der Phasenschieber 134 kann dabei ausgebildet sein, um das eine aus dem abgeleiteten Signal 132 oder dem Phasensignal 126 derart phasenzuverschieben, dass, im Resonanzfall der magnetischen Antenne 106, das phasenverschobene Signal 138 und das andere aus dem abgeleiteten Signal 132 und dem Phasensignal 126 am Signalkombinierer 136 eine vordefinierte Phasendifferenz (z.B. 90° $\pm$ 3° oder $\pm$ 1° oder 0,1°) aufweisen.

In dem in Fig. 9 gezeigten Ausführungsbeispiel ist der Phasenschieber 134 beispielhaft ausgebildet, um das abgeleitete Signal 132 phasenzuverschieben, um das phasenverschobene Signal 138 zu erhalten, wobei der Signalkombinierer 136 in diesem Fall ausgebildet sein kann, um das phasenverschobene Signal 138 und das Phasensignal 126 zu kombinieren, um das kombinierte Signal 140 zu erhalten. Gemäß einem anderen Ausführungsbeispiel kann der Phasenschieber 134 ausgebildet sein, um das Phasensignal 126 phasenzuverschieben, um das phasenverschobene Signal 138 zu erhalten, wobei der Signalkombinierer 136 in diesem Fall ausgebildet sein kann, um das phasenverschobene Signal 138 und das abgeleitete Signal 132 zu kombinieren, um das kombinierte Signal 140 zu erhalten.

Bei Ausführungsbeispielen kann die Abstimmeinrichtung ferner einen Energieauskoppler 130 (z.B. einen Richtkoppler oder eine andere Vorrichtung zum Auskoppeln von Energie) aufweisen, der ausgebildet sein kann, um einen Teil des in die magnetische Antenne 106 vorlaufenden Signals 124 (z.B. vorlaufenden Leistung) auszukoppeln, um das abgeleitete Signal 132 zu erhalten.

Bei Ausführungsbeispielen kann die Abstimmeinrichtung 120 ferner einen Regelverstärker 144 aufweisen, der ausgebildet ist, um das Abstimmsignal 122 (z.B. Steuersignal) zur Abstimmung der magnetischen Antenne 106 bereitzustellen, wobei der Regelverstärker 144 ausgebildet sein kann, um das Abstimmelement 111 mit dem Abstimmsignal 122 anzusteuern, um (1) einen Gleichanteil des kombinierten Signals 140 oder (2) eine tiefpassgefilterte Version 146 des kombinierten Signals 140 auf einen vorgegebenen Sollwert hin zu regeln.

Bei Ausführungsbeispielen kann die Abstimmeinrichtung 120 ferner einen Tiefpassfilter 142 aufweisen, der ausgebildet sein kann, um das kombinierte Signal 140 tiefpasszufiltern, um ein tiefpassgefiltertes Signal 146 zu erhalten, das den Gleichanteil des kombinierten Signals 140 aufweist.

Mit anderen Worten, Fig. 9 zeigt ein Blockschaltbild zur automatischen Frequenzregelung unter Auswertung der transmittierten Phase. Der Regelverstärker 144 kann im Allgemeinen als I-Regler oder PI-Regler ausgeführt sein. Insbesondere bei Frequency-Hopping-Systemen [6] ist darauf zu achten, dass dessen Einschwingzeit kurz genug ist. Dies lässt sich durch Wahl einer entsprechend kurzen Regelzeitkonstante (z.B. $\leq$10 μs) erreichen.

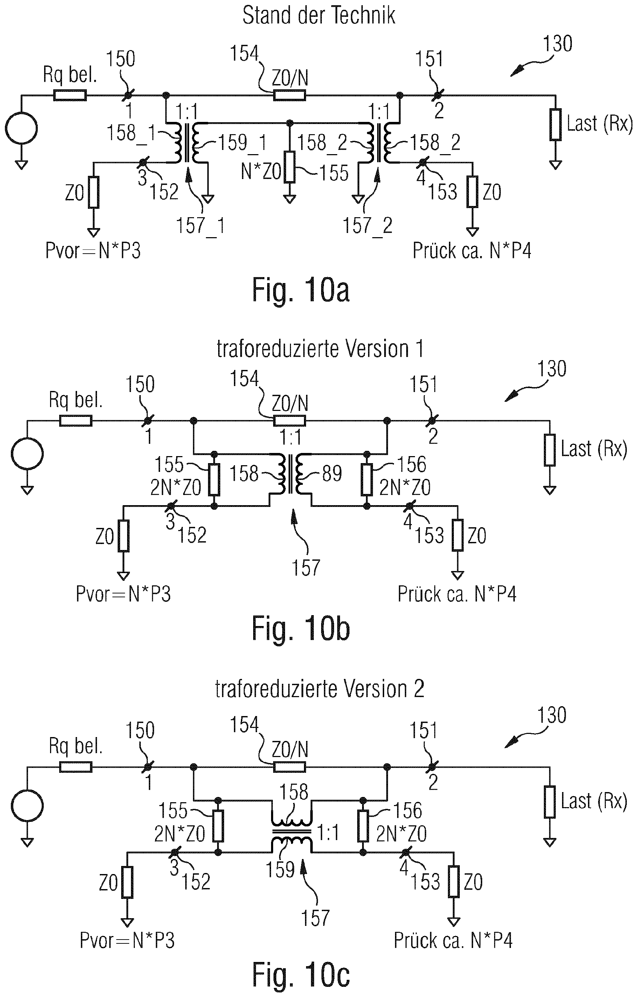

Für den in Fig. 9 gezeigten Richtkoppler 130 sind in der Literatur diverse Ausführungen bekannt. Eine davon ist in [5, Seite 88, Bild 7.3] in einer speziellen Ausführungsform zu finden. Sie ist hier in Fig. 10a in allgemeiner Form dargestellt.

Im Detail zeigt Fig. 10a ein schematisches Blockschaltbild eines herkömmlichen Richtkopplers 130. Der Richtkoppler 130 umfasst einen ersten Anschluss 150, einen zweiten Anschluss 151, einen dritten Anschluss 152 und einen vierten Anschluss 153. Ferner umfasst der Richtkoppler 130 einen ersten Widerstand 154 (z.B. der Größe Z0/N), der zwischen dem ersten Anschluss 150 und dem zweiten Anschluss 151 geschaltet ist, und einen zweiten Widerstand 155 der zwischen einem Zwischenknoten zwischen zwei Transformatoren 157_1 und 157_2 und Masse geschaltet ist. Der erste Transformator 157_1 umfasst eine erste Spule 158_1, die zwischen dem ersten Anschluss 150 und dem dritten Anschluss 152 geschaltet ist, und eine zweite Spule 159_1, die zwischen dem Zwischenknoten und Masse geschaltet ist. Der zweite Transformator 157_2 umfasst eine erste Spule 158_2, die zwischen dem zweiten Anschluss 151 und dem vierten Anschluss 153 geschaltet ist, und eine zweite Spule 159_2, die zwischen dem Zwischenknoten und Masse geschaltet ist.

Im Gegensatz zu dem in Fig. 10a gezeigten Richtkoppler 130 mit zwei Transformatoren, schaffen Ausführungsbeispiele der vorliegenden Erfindung einen Richtkoppler 130 mit nur einem Transformator (reduzierter Übertrageranzahl). Ausführungsbeispiele des Richtkopplers 130 mit nur einem Transformator sind in den Fig. 10b und 10c gezeigt.

Fig. 10b zeigt ein schematisches Blockschaltbild eines Richtkopplers 130, gemäß einem Ausführungsbeispiel der vorliegenden Erfindung. Der Richtkoppler 130 umfasst einen ersten Anschluss 150, einen zweiten Anschluss 151, einen dritten Anschluss 152 und einen vierten Anschluss 153. Ferner umfasst der Richtkoppler 130 einen ersten Widerstand 154 (z.B. der Größe Z0/N), der zwischen dem ersten Anschluss 150 und dem zweiten Anschluss 151 geschaltet ist, einen zweiten Widerstand 155 (z.B. der Größe 2N*Z0), der zwischen dem ersten Anschluss 150 und dem dritten Anschluss 152 geschaltet ist, und einen dritten Widerstand 156 (z.B. der Größe 2N*Z0), der zwischen dem zweiten Anschluss 151 und dem vierten Anschluss 153 geschaltet ist. Ferner umfasst der Richtkoppler 130 einen Transformator 157, wobei eine erste Spule 158 des Transformators 157 zwischen dem ersten Anschluss 150 und dem dritten Anschluss 152 geschaltet ist, und wobei eine zweite Spule 159 des Transformators 157 zwischen dem zweiten Anschluss 151 und dem vierten Anschluss 153 geschaltet ist. Die erste Spule 158 und die zweite Spule 159 können dabei die gleiche Anzahl an Wicklungen aufweisen.

Fig. 10c zeigt ein schematisches Blockschaltbild eines Richtkopplers 130, gemäß einem Ausführungsbeispiel der vorliegenden Erfindung. Der Richtkoppler 130 umfasst einen ersten Anschluss 150, einen zweiten Anschluss 151, einen dritten Anschluss 152 und einen vierten Anschluss 153. Ferner umfasst der Richtkoppler 130 einen ersten Widerstand 154 (z.B. der Größe Z0/N), der zwischen dem ersten Anschluss 150 und dem zweiten Anschluss 151 geschaltet ist, einen zweiten Widerstand 155 (z.B. der Größe 2N*Z0), der zwischen dem ersten Anschluss 150 und dem dritten Anschluss 152 geschaltet ist, und einen dritten Widerstand 156 (z.B. der Größe 2N*Z0), der zwischen dem zweiten Anschluss 151 und dem vierten Anschluss 153 geschaltet ist. Ferner umfasst der Richtkoppler 130 einen Transformator 157, wobei eine erste Spule 158 des Transformators 157 zwischen dem ersten Anschluss 150 und dem zweiten Anschluss 151 geschaltet ist, und wobei eine zweite Spule 159 des Transformators 157 zwischen dem dritten Anschluss 152 und dem vierten Anschluss 153 geschaltet ist. Die erste Spule 158 und die zweite Spule 159 können dabei die gleiche Anzahl an Wicklungen aufweisen.

Der in Fig. 10b gezeigte Richtkoppler 130 geht aus dem in Fig. 10a gezeigten Richtkoppler hervor, indem die beiden festgekoppelten Übertrager 157_1 und 157_2 von Fig. 10a zu einem zusammengefasst werden und der in der Mitte befindliche Widerstand 155 der Größe N·Z_0 zu gleichen Teilen auf beide Seiten des noch verbleibenden Übertragers 157 in Fig. 10b verschoben wird, was in zwei Widerstände 155 und 156 mit dem Wert 2N·Z_0 resultiert. Da Widerstände im Vergleich zu Transformatoren weder von den Kosten noch vom Volumen ins Gewicht fallen ist dieser minimale Mehraufwand irrelevant. Tatsächlich kann die Verschiebung des inneren Widerstandes auch zu ungleichen Teilen erfolgen, solange der Wert einer gedachten Parallelschaltung dieser beiden Widerstände immer den Wert N·Z_0 ergibt. Im Grenzfall würde also auch nur ein Widerstand mit dem Wert N·Z_0 genügen, der auf der linken oder rechten Seite des Übertragers 157 von Fig. 10b angebracht wäre. Allerdings haben reale Transformatoren nie 100% Koppelfaktor, so dass die streng symmetrische Version von Fig. 10b auch zu einem möglichst symmetrischen Richtkopplerverhalten führt (d.h. die beiden Ausgänge für vor- und rücklaufende Leistung haben dann bei Vor- oder Rückwärtsspeisung auch möglichst gleiche Eigenschaften).

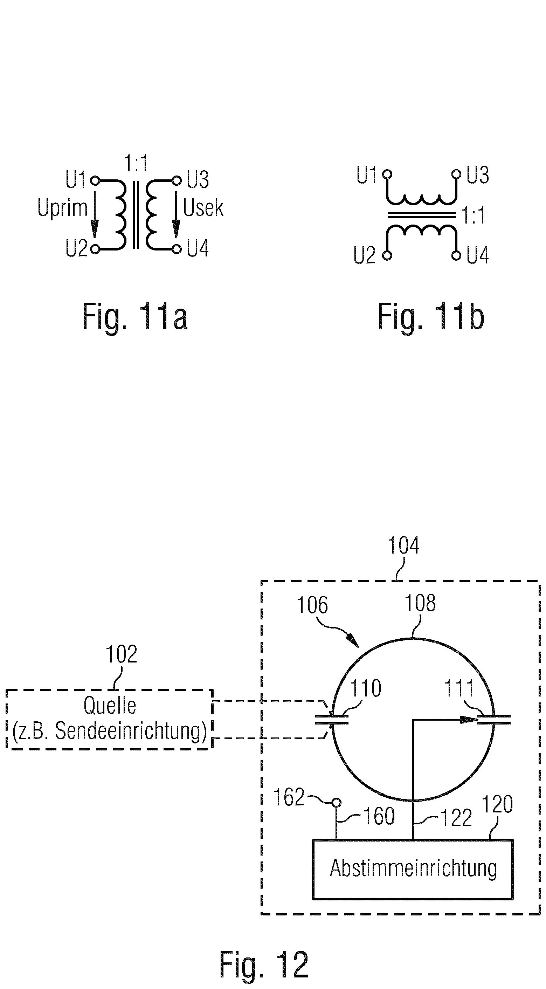

Fig. 10c zeigt eine Abwandlung des in Fig. 10b gezeigten Richtkopplers 130, bei der der Übertrager 157 um 90° gedreht angeordnet ist. Es lässt sich zeigen, dass dies bei idealen Übertragern mit einem Übersetzungsverhältnis von 1:1 immer möglich ist, solange eine galvanische Trennung keine Rolle spielt. Beweis dazu siehe Fig. 11a und 11b.

Gegeben sei ein festgekoppelter (k = 100%) Übertrager mit dem Übersetzungsverhältnis 1:1 und unendlich hoher Hauptinduktivität (idealer Trafo). Er sei wie in Fig. 11a in einem Netzwerk eingebunden, wo an drei Knoten die auf Masse bezogenen Spannungen $U_1$, $U_2$ und $U_3$ vorliegen mögen. Die Spannung $U_4$ ist nun nicht mehr frei wählbar, denn sie unterliegt aufgrund des Schaltungszwangs $U_{prim} = U_{sek}$ der Bedingung

$$U_4 = U_3 - U_{sek} = U_3 - (U_1 - U_2) = U_2 + U_3 - U_1$$

Wenn es nicht auf eine galvanische Trennung ankommt (und nur dann!) kann der Übertrager auch um 90° gedreht werden, wie dies in Fig. 11b gezeigt ist. Auch hier seien vom Netzwerk die Potenziale $U_1$, $U_2$ und $U_3$ in gleicher Weise vorgegeben. Nun sei $U_{prim} = U_1 - U_3$. Wegen $U_{prim} = U_{sek} = U_2 - U_4$ muss für $U_4$ also gelten:

$$U_4 = -U_{prim} + U_2 = U_2 - (U_1 - U_3) = U_2 + U_3 - U_1$$

Die vierte per Schaltungszwang festgelegte Spannung ergibt also in beiden Fällen den gleichen Wert, somit sind die Netzwerke äquivalent. qed.

Da nun aber reale Übertrager nichtideal sind, d.h. die Hauptinduktivität ist nicht unendlich groß, die Streuinduktivität ist nicht Null und der Koppelfaktor ist kleiner als 100%, kann je nach vorhandenem Übertrager und beabsichtigten Frequenzbereich die Version aus Fig. 10b oder Fig. 10c bessere Ergebnisse liefern.

Bei Ausführungsbeispielen erfolgt eine Auswertung der Phasenlage des in die magnetische Schleife 108 (engl. magnetic Loop) vorlaufenden Signals 124 (z.B. vorlaufenden Leistung), beispielsweise mittels eines Vergleichs zwischen der Phasenlage des in die magnetische Schleife 108 vorlaufenden Signals 124 (z.B. vorlaufenden Leistung) mit der z.B. über eine kleine Koppelschleife 128 von der Schleife 108 induktiv ausgekoppelten Leistung.

Da die Abstimmrichtung durch diese Methode der Phasenauswertung bekannt ist (im Verfahren im nächsten Abschnitt ist die Richtung, in die abgestimmt werden muss, nicht bekannt), ist eine sehr schnelle Nachführung der Resonanz möglich, dadurch ist bei Frequency-Hopping-Systemen eine Abstimmung pro Hop möglich, magnetische Antennen können somit für Frequency-Hopping-Systeme oder für Telegram-Splitting-Systeme [6] und [7] verwendet werden.

Ausführungsbeispiele schaffen eine Richtkopplerversion mit reduzierter Übertrageranzahl.

2.2. Erzeugung einer Abstimminformation / Anpassinformation durch Amplitudenauswertung bei Selbstempfang

Fig. 12 zeigt ein schematisches Blockschaltbild einer Antennenanordnung 104, gemäß einem Ausführungsbeispiel der vorliegenden Erfindung. Die Antennenanordnung 104 umfasst die magnetische Antenne 106 mit dem Abstimmelement 111 und die Abstimmeinrichtung 120 zur Abstimmung der magnetischen Antenne 106.

Die Abstimmeinrichtung 120 ist ausgebildet, um das Abstimmsignal 122 (z.B. Abstimmspannung) zur Abstimmung der magnetischen Antenne 106 in Abhängigkeit einer Amplitude eines Signals 160, das auf einem durch die Schleife 108 bzw. durch die magnetische Antenne 106 erzeugten Magnetfeld (z.B. im Nahfeld) basiert, bereitzustellen, und um das Abstimmelement 111 mit dem Abstimmsignal 122 anzusteuern, um die magnetische Antenne 106 abzustimmen.

Bei Ausführungsbeispielen kann die Antennenanordnung 104 eine Induktionsschleife 162 (oder Induktionsspule) aufweisen, die ausgebildet ist, um das Signal 160, das auf dem durch die Schleife erzeugten Magnetfeld basiert, bereitzustellen. Die Schleife 108 der magnetischen Antenne 106 und die Induktionsschleife 162 (oder Induktionsspule) können auf derselben Leiterplatte angeordnet (z.B. implementiert) sein.

Bei Ausführungsbeispielen kann die Abstimmreinrichtung 120 ausgebildet sein, um das Abstimmelement 111 mit dem Abstimmsignal 122 anzusteuern, dass um die Amplitude des Signals 160 auf einen vorgegebenen Sollwert hin zu regeln, beispielsweise derart, dass die Amplitude größer oder gleich dem vorgegebenen (z.B. vordefinierten) Sollwert (z.B. Referenzwert) ist.

Beispielsweise kann die Abstimmeinrichtung 120 ausgebildet sein, um durch Ansteuerung des Abstimmelements 111 mit dem Abstimmsignal 122 (z.B. Steuersignal) die Amplitude des Signals, das auf dem durch die Schleife erzeugten Magnetfeld basiert, auf den vorgegebenen Sollwert hin zu regeln.

Zum Beispiel kann die Abstimmeinrichtung 120 ausgebildet sein, um das Abstimmsignal 122 (z.B. Steuersignal) nachzuführen, um einer Abweichung der Amplitude des Signals, das auf dem durch die Schleife erzeugten Magnetfeld basiert, von dem vorgegebenen Sollwert entgegenzuwirken.

Der vorgegebene Sollwert kann im Vorfeld (z.B. bei einer werkseitigen Kalibrierung) durch eine Referenzmessung im ungestörten Fall der magnetischen Antenne 106 und/oder im Resonanzfall der magnetischen Antenne 106 ermittelt werden.

Ferner oder alternativ kann die Abstimmeinrichtung ausgebildet sein, um den vorgegebenen Sollwert durch eine Referenzmessung im ungestörten Fall der magnetischen Antenne 106 und/oder im Resonanzfall der magnetischen Antenne 106 zu ermitteln.

Bei der Referenzmessung kann ein vorgegebenes Signal mit der magnetischen Antenne 106 ausgesendet werden. Beispielsweise kann das vorgegebene Signal eine vorgegebene Signalform, vorgegebene Sendefrequenz, vorgegebene Bandbreite, vorgegebene Amplitude und/oder vorgegebene Modulationsart aufweisen. Beispielsweise kann das vorgegebene Signal ein Sinussignal mit einer normierten Sendespannung sein.

Bei magnetischen Empfangsantennen wird in der Regel auf maximalen Empfangspegel abgestimmt (Resonanzfrequenz) bzw. angepasst (Leistungsanspassung). Bei magnetischen Sendeantennen auf maximale Abstrahlleistung. Die Abstimminformation bzw. Anpassinformation kann, wie nachfolgend in den Abschnitten 2.2.1. und 2.2.2. detailliert beschrieben wird, erhalten werden, womit die Abstimmung bzw. Anpassung der magnetischen Antenne 106 bei Ausführungsbeispielen auch automatisch nachführbar ist.

Im Folgenden wird für eine magnetische Sendeantenne ein detailliertes Ausführungsbeispiel zur Ermittlung einer Regelgröße durch Selbstempfang beschrieben.

2.2.1. Selbstempfang

Um eine messtechnisch erfassbare Größe zu erhalten, welche eine Aussage über die Anpassung der magnetischen Antenne 106 gibt, kann bei Ausführungsbeispielen eine kleine Induktionsschleife 162 oder eine kleine SMD Spule 162 neben der eigentlichen magnetischen Antenne 106 auf der Leiterplatte platziert werden. Für den Fall, dass die magnetische Antenne 106 gut angepasst ist, wird in dieser Schleife 162 eine Spannung mit einer bestimmten Amplitude induziert. Wenn anschließend die magnetische Antenne 106 bei der geforderten Frequenz durch einen Körper in der Nähe nicht mehr resonant und angepasst ist, verringert sich die Amplitude der induzierten Spannung. Dieser Spannungsunterschied kann anschließend entsprechend detektiert werden. Nach Abgriff und Gleichrichtung kann daraus z.B. eine analoge Regelgröße gewonnen werden oder durch A/D Wandlung eine entsprechende digitale Regelung aufgebaut werden.

Werden verschiedene Materialen in die Nähe der magnetischen Antenne 106 gebracht so lässt sich der Einfluss der Materialien auf die Antenneneigenschaften entsprechend qualitativ anhand der induzierten Messspannung bewerten. Als Referenz dient ein im ungestörten Fall ermittelter Wert mit normierter Sendespannung. Diese Referenzmessung kann im Einsatzfall auch durch Aussenden eines Sinustones auf einer oder mehrerer Frequenzen durch die magnetische Sendeantenne 106 und Empfang an der Induktionsschleife 162 wiederholt werden. Dadurch ist ein Nachmessen und Überprüfen der Resonanzkurve der verbauten magnetischen Antenne 106 am Einsatzort möglich. Wird die gewonnene Induktionsschleife 162 z.B. nach Gleichrichtung und A/D Wandlung beispielsweise in einem Mikrocontroller mit entsprechenden Tabellen oder Richtwerten verglichen, so können damit Strategien zur Optimierung der Antenneneigenschaften (Nachstimmen, Anpassen) speziell für die aktuelle Einsatzsituation umgesetzt werden.

Bei Ausführungsbeispielen erfolgt somit eine Erzeugung eines Abstimmsignals (z.B. von Abstimminformation bzw. Anpassinformation) durch Selbstempfang.

Bei Ausführungsbeispielen kann hierzu eine kleine Induktionsschleife 162 oder eine kleine SMD Spule 160 auf der gleichen (oder derselben) Leiterplatte (engl. printed circuit board (PCB)) wie die magnetische Sendeantenne 106 platziert werden.

Bei Ausführungsbeispielen kann aus der Empfangsleistung der Induktionsschleife 162 bzw. der SMD Spule 162 eine Aussage über die Abstimmung bzw. Anpassung erzeugt werden, beispielsweise durch einen Vergleich mit einer abgelegten Kalibrierinformation.

### 2.2.2. Abstimmrichtung bzw. Anpassungsrichtung durch senden auf mehreren Frequenzen

In Abschnitt 2.2.1. wurde aufgezeigt, wie der Grad der aktuellen Abstimmung bzw. Anpassung gemessen werden kann.

Nach einmaligem Erfassen einer oder mehrerer Größen kann allerdings nicht eindeutig festgestellt werden, in welche Richtung die (magnetische) Antenne 106 verstimmt bzw. falsch angepasst ist. Also ob aktuell für eine zu hohe oder zu niedrige Frequenz abgestimmt ist bzw. zu induktiv oder kapazitiv abgepasst ist. Normalerweise würde in einem Kalibrierschritt häufiger gesendet, jedes Mal gemessen und die Anpassung der magnetischen Antenne 106 verändert werden, bis ein Sollwert bzw. Sollwertbereich (z.B. Optimum) erreicht ist.

Dieses Problem kann gelöst werden, indem auf verschieden Frequenzen gesendet wird und dabei eine oder mehrere Messgrößen erfasst werden. Mithilfe dieser Information kann eine Messkurve erzeugt werden, die die Anpassung über die Frequenz darstellt (oder es wird der beste Punkt ausgewählt).

Bei Ausführungsbeispielen kann eine Ausstrahlung eines "Kalibriertones" oder eines Sendesignals auf mehreren Frequenzen erfolgen.

Bei Ausführungsbeispielen kann eine Messung einer Selbstempfangsleistung auf mehreren Frequenzen erfolgen.

Bei Ausführungsbeispielen kann eine Generierung der "Abstimmrichtung bzw. Anpassungsrichtung" durch Auswertung des Verlaufs der Empfangsleistung auf den verschiedenen Frequenzen erfolgen.

### 2.3. Abstimmung durch Messung des Leistungs- oder Stromverbrauches der Sendeeinrichtung (Sende-ICs)

Eine Antenne 106 ist dann am besten abgestimmt, wenn keine Leistung reflektiert ($P_{reflekt}$) wird, bzw. das Verhältnis der in die Antenne 106 transmittierten Leistung ($P_{aus}$) zur reflektierten Leistung ($P_{reflekt}$) maximal wird. Unter Anpassung versteht man sowohl die Anpassung an eine gewünschte Impedanz, als auch eine Abstimmung auf die gewünschte Sendefrequenz. Durch ein Anpass Netzwerk (engl. Matching Network) kann die Impedanz verändert werden. Dies verändert die Angepasste-Frequenz der Antenne und die Effizienz der Verstärker. Bei magnetischen Antennen werden die Empfangsfrequenz und die Anpassung gleichermaßen verstimmt. Dies kann z.B. durch umschalten von Kondensatoren erfolgen. Bei elektrischen Antennen kann z.B. durch Schalter die elektrische Länge und so die Frequenz verstimmt werden. In diesem Kapitel wird beschrieben, wie ein Abstimmsignal zur Reduktion der reflektierten Leistung bestimmt werden kann.

2.3.1. Messaufbau

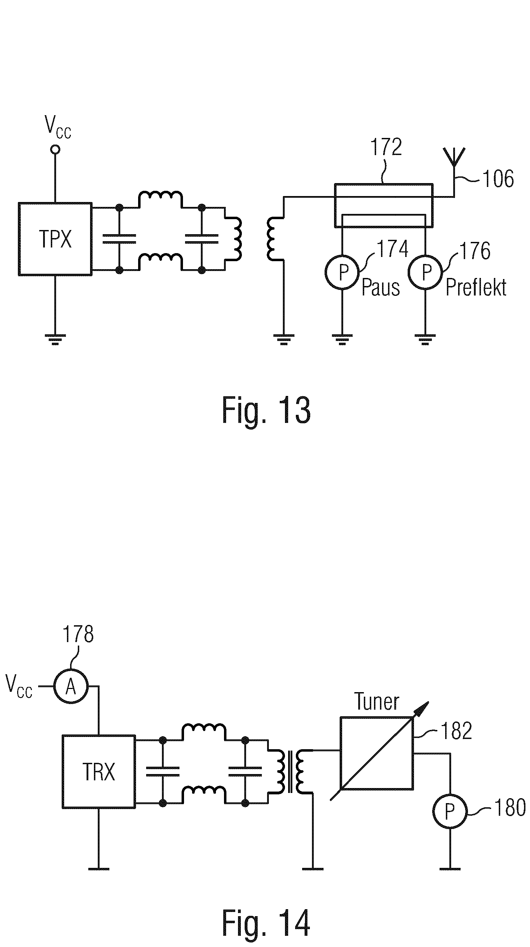

Zur Bestimmung der Leistung, die in die Antenne 170 hinein bzw. herausgeht, können beispielsweise ein Richtkoppler 172 und zwei Powermeter 174 und 176 verwendet werden, wie dies in Fig. 13 gezeigt ist.

Mithilfe des in Fig. 14 gezeigten Messaufbaus konnte gezeigt werden, dass bei typischen Sendeeinrichtungen 102 (z.B. Senderschaltkreisen), wie sie z.B. für drahtlose Sensorknoten verwendet werden, der Eingangsstrom sich je nach Antennenanpassung ändert. Der Messaufbau umfasst ein Amperemeter 178, das den Eingangsstrom der Sendeeinrichtung 102 (z.B. Sendeschaltung) misst, ein Powermeter 180, das die Ausgangsleistung misst, und einen koaxialen Tuner 182.

Mit dem koaxialen Tuner 182 können für die benötigte Frequenz alle gewünschten Impedanzen nachgebildet werden. Um dies zu bewerkstelligen kann der Tuner 182 beispielsweise mit Hilfe eines Vector Netzwerkanalysators (VNA) kalibriert und anschließend mit dem Testobjekt verbunden werden.

Mit dem in Fig. 14 gezeigten Messaufbau kann der aufgenommene Strom der Sendeeinrichtung 102 (z.B. Sendesystem) und die abgegebene Sendeleistung für alle eingestellten komplexen Impedanzen ermittelt werden. Wie in Fig. 14 gezeigt ist, kann nun die Sendeeinrichtung 102 (z.B. Frontend) vermessen werden und der Verlauf zwischen Ausgangsleistung und Eingangsstrom abgetragen werden.

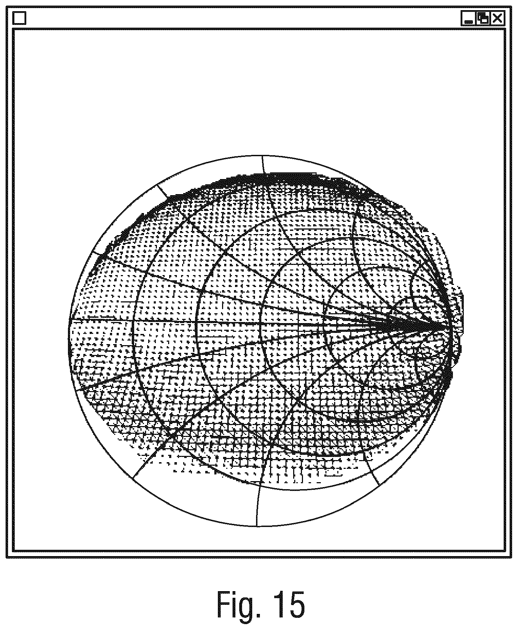

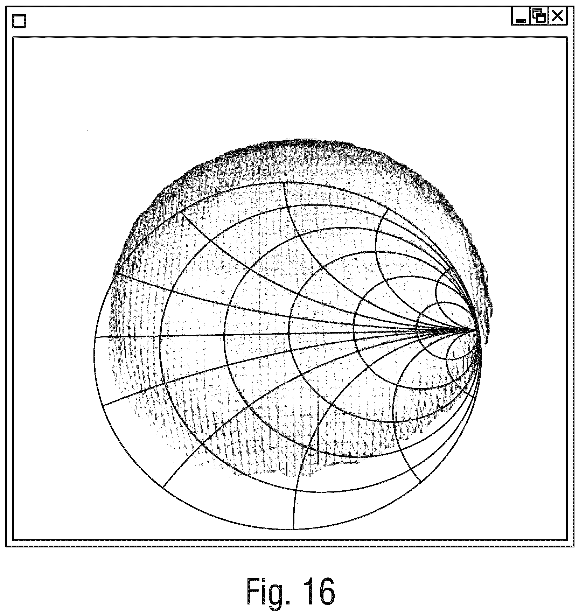

Daraus können zwei 3D Graphen erzeugt werden, die den Eingangsstrom und die Ausgangsleistung über der Antennenimpedanz zeigen, wie dies in den Fig. 15 und Fig. 16 dargestellt ist.

Im Detail zeigt Fig. 15 in einem Smith-Diagramm die Stromaufnahme der Sendeeinrichtung 102 aufgetragen über die Antennenimpedanz. Der untere Bereich des Smith-Diagramms zeigt dabei eine höhere Stromaufnahme, während der obere Bereich des Smith-Diagramms eine niedrigere Stromaufnahme zeigt. In der Mitte des Smith-Diagramms bei 50 Ohm nimmt die Sendeeinrichtung 102 ca. 100 mA auf.

Fig. 16 zeigt in einem Smith-Diagramm die Ausgangsleistung aufgetragen über der Antennenimpedanz. Der mittlere Bereich des Smith-Charts zeigt dabei eine Ausgangsleistung von ca. 18 dBm, wobei die Leistung zum Rande des Smith-Diagramms absinkt.

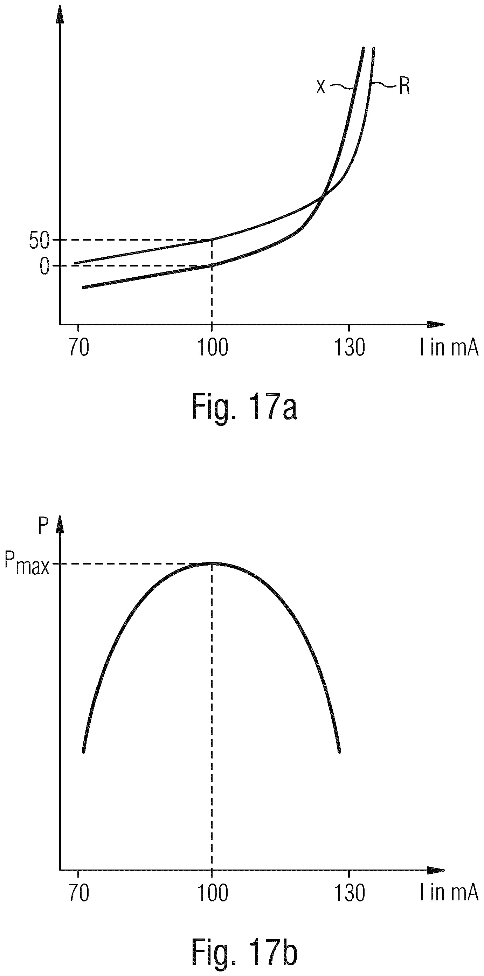

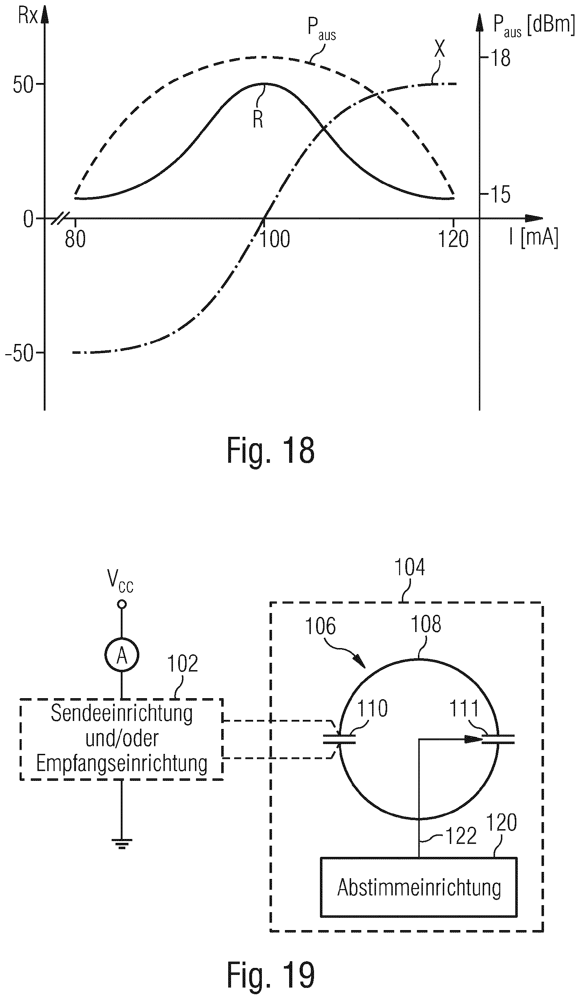

Wird nun der Impedanz- und Leistungsverlauf schematisch über den Eingangsstrom (der Sendeeinrichtung 102) aufgetragen, ergeben sich Verläufe wie in Fig. 17a, Fig. 17b und Fig. 18 gezeigt.

Im Detail zeigt Fig. 17a in einem Diagramm einen Verlauf eines Realteils R und eines Imaginärteils X der Antennenimpedanz aufgetragen über den Eingangsstrom der Sendeeinrichtung 102. Dabei beschreibt die Ordinate die Impedanz in Ohm und die Abszisse den Eingangsstrom der Sendeeinrichtung 102 in mA.

Fig. 17b zeigt in einem Diagramm einen Verlauf der Ausgangsleistung aufgetragen über den Eingangsstrom der Sendeeinrichtung 102. Dabei Beschreibt die Ordinate die Leistung und die Abszisse den Eingangsstrom der Sendeeinrichtung 102 in mA.

Fig. 18 zeigt in einem Diagramm einen Verlauf eines Realteils R und eines Imaginärteils X der Antennenimpedanz sowie einen Verlauf der Ausgangsleistung aufgetragen über den Eingangsstrom der Sendeeinrichtung 102. Dabei beschreibt in Fig. 18 die Ordinate die Impedanz in Ohm bzw. die Leistung in dBm und die Abszisse den Eingangsstrom der Sendeeinrichtung 102 in mA.

Es ergibt sich, dass der Imaginärteil X streng monoton steigend mit dem Eingangsstrom (der Sendeeinrichtung 102) ist. Von den Messpunkten "Kurzschluss" bis "offen", wie in Fig. 17a dargestellt, nimmt der Eingangsstrom (der Sendeeinrichtung 102) stetig zu. Der Verlauf der Ausgangsleistung über den Eingangsstrom zeigt, dass ein Eingangsstrom von ca. 100 mA mit der maximalen Ausgangsleistung korrespondiert (Pout über Iin). Dies ist bei dem Messpunkt (50 + 0j) Ohm.

Der Messaufbau zeigt somit, dass es möglich ist, über eine Messung des Eingangsstroms (der Sendeeinrichtung 102) eine Aussage über die Qualität der Antennenanpassung zu treffen.

2.3.2. Erzeugung des Abstimmsignals in Abhängigkeit von einer Leistungs- oder Stromaufnahme der Sendeeinrichtung

Fig. 19 zeigt ein schematisches Blockschaltbild einer Antennenanordnung 104, gemäß einem Ausführungsbeispiel der vorliegenden Erfindung. Die Antennenanordnung 104 umfasst eine Antenne 106 mit einem Abstimmelement 111, und die Abstimmeinrichtung 120 zur Abstimmung der Antenne 106. Die Abstimmeinrichtung 120 ist ausgebildet, um das Abstimmsignal 122 zur Abstimmung der Antenne 106 in Abhängigkeit von einer Leistungs- oder Stromaufnahme einer mit der Antenne 106 verbundenen Sendeeinrichtung 102 bereitzustellen, und um das Abstimmelement 111 mit dem Abstimmsignal 122 anzusteuern, um die Antenne 106 abzustimmen.

Wie in Fig. 19 gezeigt ist, kann die Antenne 106 bei Ausführungsbeispielen eine magnetische Antenne 106 mit einer einfach oder mehrfach unterbrochenen Schleife 108 sein. Bei Ausführungsbeispielen kann die Antenne 106 jedoch auch eine elektrische Antenne sein.

In der nachfolgenden Beschreibung wird beispielhaft davon ausgegangen, dass die Antenne 106 eine magnetische Antenne ist. Es sei jedoch darauf hingewiesen, dass die nachfolgend beschriebenen Ausführungsbeispiele hinsichtlich der Abstimmung der Antenne in Abhängigkeit von einer Leistungs- oder Stromaufnahme der mit der Antenne 106 verbundenen Sendeeinrichtung 102 bzw. von einer Leistungs- oder Stromaufnahme eines aktiven Bauelements der Sendeeinrichtung auch auf eine elektrische Antenne anwendbar sind.

Bei Ausführungsbeispielen kann die Stromaufnahme der Sendeeinrichtung z.B. mittels eines Strommessers 186 (z.B. Amperemeters) ermittelt werden. Anstelle der Stromaufnahme kann auch die Leistungsaufnahme der Sendeeinrichtung 102 ermittelt werden, beispielsweise mittels eines Leistungsmessers (z.B. Powermeters).

Bei Ausführungsbeispielen kann die Abstimmeinrichtung 102 ausgebildet sein, um das Abstimmelement 111 mit dem Abstimmsignal 122 anzusteuern, um die Leistungs- oder Stromaufnahme der Sendeeinrichtung 102 auf einen vorgegebenen (z.B. vordefinierten) Sollwertebereich hin zu regeln.

Beispielsweise kann die Abstimmeinrichtung 120 ausgebildet sein, um durch Ansteuerung des Abstimmelements 111 mit dem Abstimmsignal 122 (z.B. Steuersignal) die Leistungs- oder Stromaufnahme der Sendeeinrichtung 102 auf den vorgegebenen Sollwertebereich hin zu regeln.

Zum Beispiel kann die Abstimmeinrichtung 120 ausgebildet sein, um das Abstimmsignal 122 (z.B. Steuersignal) nachzuführen, um einer Abweichung der Leistungs- oder Stromaufnahme der Sendeeinrichtung 102 von dem vorgege- benen Wertebereich entgegenzuwirken.

Der vorgegebene Sollwerteberich (z.B. vordefinierte Wertebereich) kann beispielsweise

- durch eine Systemsimulation unter Annahme einer idealen oder nahezu idealen Anpassung der magnetischen Antenne,
- bei Abschluss der Sendeeinrichtung 102 mit einer vordefinierten Impedanz (z.B. 50 Ohm),
- basierend auf einer Antennenmessung (z.B. mittels eines Antennentuners),
- basierend auf einem Mittelwert der Leistungs- oder Stromaufnahme bei kurzgeschlossenem Abschluss und offenem Abschluss der Sendeeinrichtung 102,
- basierend auf einer Messung einer Abstrahlungsleistung,

ermittelt werden.

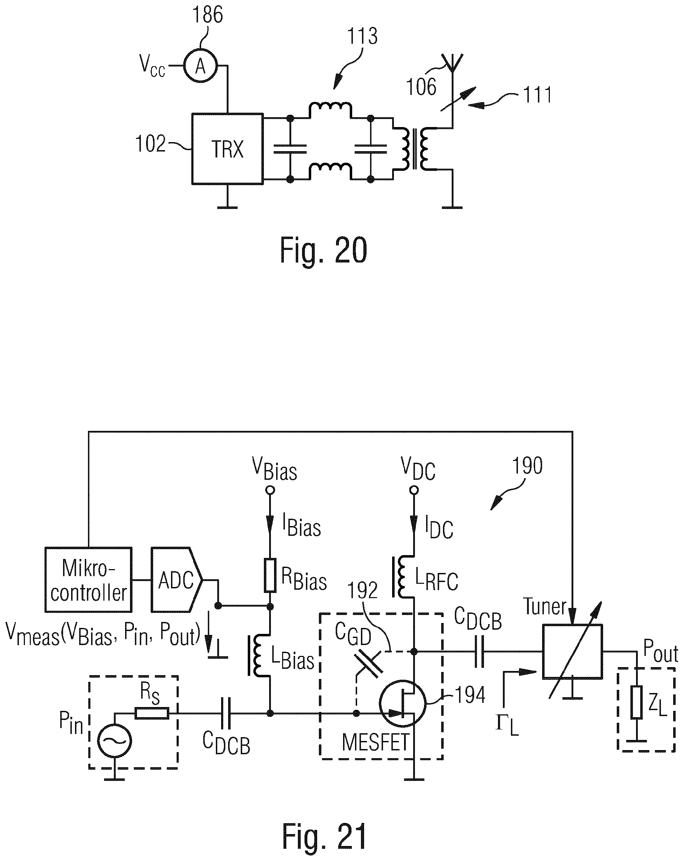

Fig. 20 zeigt einen Messaufbau zum Bestimmen der idealen Antennenanpassung, gemäß einem Ausführungsbeispiel der vorliegenden Erfindung. Der Messaufbau umfasst eine Sendeeinrichtung 102, eine magnetische Antenne 106 mit dem Abstimmelement 111, ein Anpassungsnetzwerk 113 zwischen der Sendeinrichtung 102 und der magnetischen Antenne 106 sowie ein Amperemeter 186 zur Messung der Stromaufnahme der Sendeeinrichtung 102, wobei das Abstimmsignal 122 zur Abstimmung der magnetischen Antenne 106 in Abhängigkeit von der gemessenen Stromaufnahme der Sendeeinrichtung 102 erzeugt wird. Der in Fig. 20 gezeigte Messaufbau kann beispielsweise in einem Gerät, wie z.B. einem Teilnehmer 100 eines Kommunikationssystems, implementiert werden.

Wie in Fig. 20 zu erkennen ist, kann das Gerät nun im Gegensatz zum Aufbau aus Fig. 13 stark vereinfacht werden, weil anstelle eines Richtkopplers 172 und zweier Powermeter 174 und 176 bei Ausführungsbeispielen nur noch ein Amperemeter 186 erforderlich ist. Die Strommessung kann für die Abstimmung der Sendeantenne 106 genutzt werden.

Die Kalibrierung des Aufbaus kann folgende Schritte umfassen:

1. Feststellen des idealen Stromwertes, und
2. Einstellen der (magnetischen) Antenne 106.

Im nächsten Schritt kann die (magnetische) Antenne 106 auf Grundlage der kalibrierten Stromwerte angepasst werden. Im laufenden Betrieb kann die Antennenanpassung solange verändert werden, bis der gewünschte Strom (Eingangsstrom der Sendeeinrichtung) erreicht ist. Durch die monoton steigende Impedanzkurve ist nach einmaligem verstellen der (magnetischen) Antenne 106 direkt die Richtung bekannt, in der das Optimum liegt. Das Einstellen ist auch während des laufenden Betriebes möglich. Als Sendesignal kann entweder ein CW-Signal (CW = Continuous wave, dt. eine ungedämpfte, also zeitlich konstante abgestrahlte Welle) oder auch direkt das modulierte Signal z.B. G-MSK (Gaussian Minimum Shift Keying) verwendet werden.

Das Einstellen der (magnetischen) Antenne 106 ist durch ein Testsignal (CW) möglich, wobei das Nutzsignal z.B. nur bei optimierten Bedingungen gesendet wird. Durch Optimierung der Antennenanpassung wird das System in einem optimalen Wirkungsgrad betrieben. Hierdurch kann der Energiebedarf gesenkt werden.

Das genutzte Anpassungsnetzwerk kann beispielsweise N-Zustände haben, die direkt mit entsprechenden Stromwerten verknüpft werden können. Somit ist die Anpassung der (magnetischen) Antenne 106 über wenige Schritte durch eine Tabelle möglich. Dies minimiert den Programmieraufwand.

Durch Veränderung der Phase des Sendesignals kann die (magnetische) Antenne 106 zusätzlich angepasst werden.

Wenn eine Anpassung nicht möglich ist, kann das System (z.B. der Teilnehmer 100 oder die Abstimmeinrichtung 120 des Teilnehmers 100) den Sendevorgang unterbrechen und zu einem späteren Zeitpunkt die Anpassung erneut überprüfen. Hierdurch kann Energie gespart werden, da der Teilnehmer (z.B. Knoten) immer mit optimalem Wirkungsgrad sendet.

Ausführungsbeispiele haben den Vorteil der Einsparung an Hardwarekosten, da kein HF-Koppler und kein Powermeter benötigt wird.

Ausführungsbeispiele haben den Vorteil, dass keine Dämpfung der Ausgangsleistung durch den HF-Koppler erfolgt.

Ausführungsbeispiele haben den Vorteil, dass ein steigender Strom die Richtung der benötigten Anpassung angibt. Es ist keine Minimumsuche erforderlich, wodurch der Idealwert schneller gefunden werden kann.

Ausführungsbeispiele haben den Vorteil, dass, im Falle einer digitalen bzw. softwarebasierten Implementierung, diese durch eine Zuweisungstabelle einfach zu programmieren ist.

Ausführungsbeispiele haben den Vorteil, dass diese auf verschiedene Sendesysteme anwendbar sind.

Ausführungsbeispiele haben den Vorteil der Energieeffizienz.

Bei Ausführungsbeispielen kann das Gerät (z.B. der Teilnehmer 100 bzw. die Abstimmeinrichtung 120 des Teilnehmers 100) den Stromverbrauch der Sendeeinrichtung 102 (z.B. Sende-IC bzw. Sendesystem) ermitteln (z.B. messen).

Bei Ausführungsbeispielen kann das Gerät (z.B. der Teilnehmer 100) eine abstimmbare (magnetische) Antenne 106 aufweisen.

Bei Ausführungsbeispielen kann das Gerät (z.B. der Teilnehmer 100 bzw. die Abstimmeinrichtung 120 des Teilnehmers 100) die (magnetische) Antenne 106 verstimmen (ggf. Sonderfall "Kurzschluss" und "offen", 50 $\Omega$).

Bei Ausführungsbeispielen kann das Gerät (z.B. der Teilnehmer 100 bzw. die Abstimmeinrichtung 120 des Teilnehmers 100) die Strominformation verwenden, um eine ideale Antenneneinstellung zu finden (siehe Ablauf oben).

Bei Ausführungsbeispielen kann das Gerät (z.B. der Teilnehmer 100 bzw. die Abstimmeinrichtung 120 des Teilnehmers 100) die veränderbare (z.B. abstimmbare) (magnetisch) Antenne 106 durch Messung des Stromverbrauches der Sendeeinrichtung 102 (z.B. Sende-IC) abstimmen.

Bei Ausführungsbeispielen kann das Gerät (z.B. der Teilnehmer 100 bzw. die Abstimmeinrichtung 120 des Teilnehmers 100) eine Abweichung von der Anpassung durch Abweichungen der Stromaufnahme bei idealer Anpassung (50 $\Omega$) erkennen.

### 2.3.3. Charakterisierung des Systems

Um eine Aussage von dem gemessenen Eingangsstromwert (der Sendeeinrichtung 102) auf die Antennenanpassung machen zu können, können dem System (z.B. dem Teilnehmer 100 bzw. der Abstimmeinrichtung 120 des Teilnehmers 100) Informationen über die Stromaufnahme bei idealer Anpassung gegeben werden.

Der Eingangsstrom (der Sendeeinrichtung 102) kann auf unterschiedliche Arten bestimmt werden. Jede Methode kann prinzipiell in jedem Stadium durchgeführt werden.

### 2.3.3.1. Simulation des Systems

Bei Ausführungsbeispielen kann der Eingangsstorm (der Sendeeinrichtung 102) bei idealer Anpassung (der magnetischen Antenne 106) mithilfe einer Systemsimulation z.B. in ADS ermittelt werden. Wenn hinreichend gute Modelle vorhanden sind, kann die Simulation eine Abhängigkeit von Stromverbrauch zu Anpassung der (magnetischen) Antenne 106 liefern.

### 2.3.3.2. Messungen bei idealem Impedanz Abschluss

Bei Ausführungsbeispielen kann der gewünschte Eingangsstrom (der Sendeeinrichtung 102) mit maximaler Ausgangsleistung z.B. bei der Inbetriebnahme über Speichern des aktuellen Stromwertes bei einem 50 Ohm abgeschlossenen Ausgang gemacht werden.

### 2.3.3.3. Einmalige Messung mit Tuner z.B. im Labor

Bei Ausführungsbeispielen kann über einen Aufbau wie in Fig. 14 mithilfe eines Antennentuners 182 jeder Punkt gemessen und die maximale Leistung gefunden werden.

### 2.3.3.4. Messung an jeder Hardware, z.B. Test bei Inbetriebnahme in der Fertigung

Bei Ausführungsbeispielen kann der ideale Punkt auch über Verbinden (z.B. Anschrauben) verschiedener Kalibriernormale erreicht werden. Beispielsweise kann ein 50 Ohm Abschluss verwendet werden, welcher direkt den idealen Strom angibt.

Es kann auch ein Abschluss (z.B. Stecker) mit "offenem" Ende bzw. "Kurzschluss" verwendet werden, um die Richtung des Impedanzverlaufs zu bestimmen. Der ideale Strom kann als Mittelwert zwischen den beiden (z.B. "offen" und "Kurzschluss") angenommen werden.

Es können alle der drei Kalibrierstandards ("offen", "Kurzschluss", "50 Ohm") zusammen oder einzeln genutzt werden, um eine Information über den Stromverlauf zu erhalten.

Es können auch weitere Standards abweichend von 50 $\Omega$ genutzt werden, wenn die ideale Impedanz für maximale Leistung davon abweicht.

### 2.3.3.5. Kalibrierung der Stromaufnahme durch Empfang mit einer Referenzantenne

Bei Ausführungsbeispielen kann zur Kalibrierung eine Funkstrecke aufgebaut werden, wobei das vom Sender mit einer (magnetischen) Antenne 106 abgestrahlte Signal durch eine weitere Antenne empfangen und die Empfangsleistung ausgewertet werden kann. Hierbei können die Abstimmelemente 111 der (magnetischen) Antenne 106 manuell verändert und die entsprechende Empfangsleistung und Stromaufnahme notiert werden. Die Stromaufnahme bei maximaler Empfangsleistung ist der Wert, auf den im Betrieb abgestimmt wird. Für eine bessere Reproduzierbarkeit kann die Messung in einer geschirmten und reflexionsarmen Umgebung, wie z.B. in Antennenmesshalle, durchgeführt werden.

### 2.3.3.6. Messung mit on Board Schaltung z.B. im Feld

Bei Ausführungsbeispielen können externe Kalibrierstecker auch direkt auf der Platine realisiert werden und z.B. über einen HF-Schalter umgeschaltet werden. So ist eine Ermittlung des idealen Stromes auch unter unterschiedlichen Betriebsmodi bzw. Umgebungsbedingungen, wie z.B. Temperatur (Kälte, Wärme), möglich.

### 2.3.3.7. Vorkenntnisse des Verlaufs der Impedanz der Antenne

Bei Ausführungsbeispielen kann durch Vorkenntnis des Impedanzverhaltens bei Verstimmung der verwendeten (magnetischen) Antenne 106 für den jeweiligen Verlauf der Impedanz eine Aussage über die ideale Stromaufnahme der Sendeeinrichtung 102 (z.B. Sendesystem) getroffen werden. Es kann eine Funktion ermittelt werden, die für die verwendete (magnetische) Antenne 106 den idealen Punkt zwischen den Fällen "Kurzschluss" und "Offen" geben kann. Dies ist nur nötig, falls der Verlauf von einer Geraden (Fall: Mitte zwischen "Kurzschluss" und "offen" ist ideal) abweicht.

### 2.3.3.8. Rückmeldung der ausgensendeten Leistung von einem anderen Teilnehmer

Bei Ausführungsbeispielen kann im normalen Betrieb (z.B. im Feld) das ausgesendete Signal von einem anderen Teilnehmer empfangen werden, wobei dieser an den sendenden Teilnehmer rückmelden kann, wie gut das empfangene Signal war, wodurch der sendende Teilnehmer eine Abstimmspannung erzeugen kann.

### 2.3.4. Vorteile und Ausführungsbeispiele

Ausführungsbeispiele haben den Vorteil, dass eine Kalibrierung des Geräts (z.B. Teilnehmers 100 bzw. der magnetischen Antenne 106) im Betrieb ("Kurzschluss", "Offen", 50 Ohm) vorgenommen werden kann.

Ausführungsbeispiele haben den Vorteil, dass das Gerät (z.B. der Teilnehmer 100 bzw. die Abstimmeinrichtung 120 des Teilnehmers 100) eine Anpassungsinformation durch vorherige Kalibrierung enthalten kann.

Ausführungsbeispiele haben den Vorteil, dass das Gerät (z.B. der Teilnehmer 100 bzw. die Abstimmeinrichtung 120 des Teilnehmers 100) eine Kalibrierung mit weniger Standards (z.B. nur "Kurzschluss" und "offen") vornehmen kann, wobei die Mitte als ideal angenommen werden kann.

Ausführungsbeispiele haben den Vorteil, dass das Gerät (z.B. der Teilnehmer 100 bzw. die Abstimmeinrichtung 120 des Teilnehmers 100) durch bekanntes Antennenverhalten die Kalibrierung vereinfachen / optimieren kann.

Bei Ausführungsbeispielen kann das Gerät (z.B. der Teilnehmer 100 bzw. die Abstimmeinrichtung 120 des Teilnehmers 100) den Stromverbrauch der Sendeeinrichtung (z.B. Sende-IC bzw. Sendesystem) messen.

Bei Ausführungsbeispielen kann das Gerät (z.B. der Teilnehmer 100) eine abstimmbare (magnetische) Antenne 106 aufweisen.

Bei Ausführungsbeispielen kann das Gerät (z.B. der Teilnehmer 100 bzw. die Abstimmeinrichtung 120 des Teilnehmers 100) die (magnetische) Antenne 106 verstimmen (ggf. Sonderfall Kurzschluss und Offen, 50 Ω).

Bei Ausführungsbeispielen kann das Gerät (z.B. der Teilnehmer 100 bzw. die Abstimmeinrichtung 120 des Teilnehmers 100) die Strominformation verwenden, um ideale Antenneneinstellung zu finden (siehe Ablauf oben).

Bei Ausführungsbeispielen kann das Gerät (z.B. der Teilnehmer 100 bzw. die Abstimmeinrichtung 120 des Teilnehmers 100) die veränderbare (z.B. abstimmbare) (magnetische) Antenne 106 durch Messung des Stromverbrauches der Sendeeinrichtung 102 (z.B. Sende-IC) abstimmen.

Bei Ausführungsbeispielen kann das Gerät (z.B. der Teilnehmer 100 bzw. die Abstimmeinrichtung 120 des Teilnehmers 100) die Anpassungsinformation durch vorherige Kalibrierung enthalten.

Bei Ausführungsbeispielen kann das Gerät (z.B. der Teilnehmer 100 bzw. die Abstimmeinrichtung 120 des Teilnehmers 100) eine Kalibrierung im Betrieb ("Kurzschluss", "Offen, "50 Ohm") vornehmen.

Bei Ausführungsbeispielen kann das Gerät (z.B. der Teilnehmer 100 bzw. die Abstimmeinrichtung 120 des Teilnehmers 100) eine Abweichung von der Anpassung durch Abweichungen der Stromaufnahme bei idealer Anpassung (50 Ω) erkennen.

Bei Ausführungsbeispielen kann das Gerät (z.B. der Teilnehmer 100 bzw. die Abstimmeinrichtung 120 des Teilnehmers 100) eine Kalibrierung z.B. im Betrieb mit weniger Standards (z.B. nur "Kurzschluss" und "offen") vornehmen, wobei die Mitte als ideal angenommen werden kann.

Bei Ausführungsbeispielen kann das Gerät (z.B. der Teilnehmer 100 bzw. die Abstimmeinrichtung 120 des Teilnehmers 100) eine Kalibrierung z.B. im Betrieb mit 50 Ohm als Referenz für eine ideale Anpassung der Antenne 106 vornehmen.

Bei Ausführungsbeispielen kann das Gerät (z.B. der Teilnehmer 100 bzw. die Abstimmeinrichtung 120 des Teilnehmers 100) eine Anpassungsinformation (Stromaufnahme) nutzen, um einen optimalen Sendezeitpunkt zu finden. Beispielsweise kann erst gesendet werden, wenn der optimale Wirkungsgrad erreicht ist.

Bei Ausführungsbeispielen kann das Gerät (z.B. der Teilnehmer 100 bzw. die Abstimmeinrichtung 120 des Teilnehmers 100) die Antennenanpassung nutzen, um Energie zu sparen.

Bei Ausführungsbeispielen kann das Gerät (z.B. der Teilnehmer 100 bzw. die Abstimmeinrichtung 120 des Teilnehmers 100) eine Phaseneinstellung nutzen, um die Antennenanpassung zu verändern.

Bei Ausführungsbeispielen kann das Gerät (z.B. der Teilnehmer 100) eine Rückmeldung über das ausgesendete Signal von einem anderen Teilnehmer im Funknetz erhalten.

### 2.4. Stromverbrauch / Sonstige Effekte einer Endstufe

In Abschnitt 2.3 wurde die Abstimmung (der magnetischen Antenne 106) durch Messung des Stromverbrauches der Sendeeinrichtung 102 (z.B. Sende-IC) beschrieben. Die Sendeeinrichtung 102 weist in der Regel einen Leistungsverstärker auf, der die zur Abstrahlung mit einer Antenne 106 nötige Sendeleistung bereitstellt.

Der Leistungsverstärker ist in der Regel aus mehreren aktiven sowie passiven elektronischen Komponenten aufgebaut. Diese können zur Erfassung von elektrischen Messgrößen genutzt werden, die Rückschlüsse auf die Antennenanpassung ermöglichen und somit zur Erzeugung des Abstimmsignals 122 (z.B. Abstimmspannung) eingesetzt werden können.

### 2.4.1. Messung des Versorgungsstroms der aktiven Bauelemente

Die Messung des Versorgungsstroms des bzw. der aktiven Bauelemente (z.B. Leistungstransistoren) des Leistungsverstärkers (der Sendeeinrichtung 102) ist äquivalent zur Messung des Stromverbrauches der Sendeeinrichtung (z.B. Sende-IC) und erlaubt eine präzisere Erfassung der Anpassungsinformation. Andere Verbraucher in der Sendeeinrichtung 102 (z.B. Sende-IC) stören die Messung nicht.

Bei zwei oder mehr aktiven Bauelementen kann über die Differenz der Versorgungsströme eine Aussage über die Anpassung getroffen werden. Beispiele wären hier Verstärker, die nach dem Balanced-, Gegentakt- (Push-Pull-) und Doherty-Verfahren aufgebaut sind. Insbesondere Gegentakt- und Doherty-Verstärker reagieren empfindlich auf rücklaufende Leistung, die sich wiederum in einem veränderten Betriebsverhalten und damit auch in den Versorgungsströmen zeigt.

### 2.4.2. Messung des Biasstroms der aktiven Bauelemente

Die direkte Messung des Stromverbrauchs ist bei höheren Leistungen durch die damit verbundenen höheren Spannungen aufwändiger (hochliegende Current-sense notwendig).

Metall-Halbleiter-Feldeffekttransistoren (MESFET) haben einen Schottky-Kontakt am Gate, der bei höheren HF-Eingangsleistungen $P_{in}$ gleichrichtend wirkt, es fließt ein Gatestrom $I_{Bias}$ (siehe Fig. 21). Über die parasitäre Gate-Drain-Kapazität ($C_{GD}$) 192 (des Transistors 194) ist dieser Gleichrichteffekt auch abhängig von der Ausgangsleistung $P_{out}$. Falls schaltungstechnisch Zugriff auf den Gate-Anschluss besteht, kann eine Spannung $V_{meas}$ am Transistor $R_{Bias}$ in Abhängigkeit des Gatestroms abgegriffen werden; diese Spannung ist bei gegebener Eingangsleistung $P_{in}$ abhängig von der Ausgangsleistung $P_{out}$ und somit der Anpassung der Last. Es besteht somit über die Messspannung $V_{meas}$ die Möglichkeit eine Aussage über die Anpassung der Last also der Antenne 106 zu treffen. $V_{meas}$ kann ggfs. direkt über einen Analog-Digital-Umsetzer abgegriffen und zur Steuerung des Antennen-Tuners zur Abstimmung verwendet werden, wie dies in Fig. 21 gezeigt ist.

Im Detail zeigt Fig. 21 ein schematisches Blockschaltbild einer Sendeeinrichtung mit einem Leistungsverstärker 190, gemäß einem Ausführungsbeispiel der vorliegenden Erfindung. Wie in Fig. 21 zu erkennen ist, kann eine Abstimmspannung zur Regelung des Antennen-Tuners basierend auf einer (z.B. durch eine) Messung des Biasstroms I_Bias der aktiven Bauelemente 194 erzeugt werden.

### 2.4.3. Erzeugen einer Abstimmspannung durch Messung der Gleichtaktmode der magnetischen Antenne

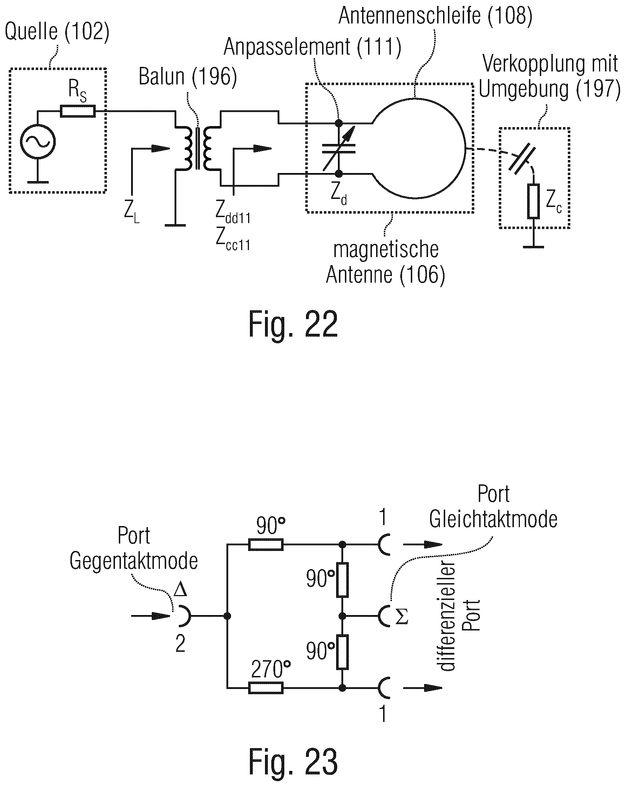

Die Antennenschleife 108 einer magnetischen Antenne 106 ist eine differenzielle Last. Mithilfe eines Transformators (Balun) kann diese zweipolige differenzielle Last von einer einpoligen Quelle angesteuert werden, wie dies in Fig. 23 gezeigt ist.

Im Detail zeigt Fig. 22 ein schematisches Blockschaltbild einer Antennenanordnung 104, gemäß einem Ausführungsbeispiel der vorliegenden Erfindung. Die Antennenanordnung 104 umfasst die magnetische Antenne 106 mit der Schleife 108 und dem Abstimmelement 111, wobei die magnetische Antenne 106 über einen Transformator 196 (Balun) mit einer Quelle 102, wie z.B. einer Sendeeinrichtung, verbunden ist. Die Antennenschleife 108 kann dabei differentiell angesteuert werden, so dass die Gleichtaktmode $Z_{cc11}$ vor dem Balun 196 nicht mehr sichtbar ist.

Wie in Fig. 22 zu erkennen ist, "sieht" die Quelle 102 dabei die Lastimpedanz $Z_L$.

Die magnetische Antenne 106 umfassend Antennenschleife 108 und Anpasselement 111 hat die differenzielle Impedanz $Z_d$. Über die Umgebung 197 ist die magnetische Antenne 106 mit der Impedanz $Z_c$ verkoppelt. Diese parasitäre Verkopplung führt zur Verstimmung der (magnetischen) Antenne 106 und kann mithilfe des Anpasselements 111 ausgeglichen werden.

Am Eingang der magnetischen Antenne 106 sind somit zwei Impedanzen messbar. Die Gegentaktimpedanz $Z_{dd11}$ beschreibt den Gegentaktbetrieb (Normalbetrieb der (magnetischen Antenne 106). Die Gleichtaktimpedanz $Z_{cc11}$ beschreibt den Gleichtaktbetrieb, der durch unerwünschte Verkopplung mit der Umgebung zustande kommt. Am Eingang des Baluns 196 ist nur mehr die Impedanz $Z_L$ messbar.

Die Erzeugung eines Abstimmsignals (z.B. Abstimmspannung) 122 zur Regelung des Anpasselements 111 kann durch Zugriff auf die Gleichtaktmode, die aus der Gleichtaktimpedanz $Z_{cc11}$ resultiert, erfolgen.

Wenn die magnetische Antenne 106 differenziell angesteuert wird, dann kann die (magnetische) Antenne 106 mit einem Gegentakt- oder mit einem Gleichtaktsignal beaufschlagt werden und über den Stromverbrauch eine Aussage über die Verstimmung getroffen werden.

Die Gleichtaktmode kann über zwei Methoden gemessen bzw. eingespeist werden, die nachfolgend beschrieben sind.

### 2.4.3.1. Messung und Einspeisung der Gleichtaktmode über den Gleichtaktzweig des Ausgangsbaluns

Spezielle Baluns 196 ermöglichen einen Zugriff auf die Gleichtaktmode des differenziellen Ports. Ein Beispiel ist der sogenannte Ringkoppler (auch Rat-Race-Koppler) in Fig. 23. Die Gleichtakteigenschaften der magnetischen Antenne können dann entweder über eine aktive Messung mithilfe eines Messsignals oder über die reflektierte Leistung bestimmt werden und daraus eine Abstimmspannung abgeleitet werden.

### 2.4.3.2. Messung der Gleichtaktmode über die Nichtlinearität des Magnetkerns

Um die Baugröße des Baluns 196 insbesondere bei niedrigen Frequenzen zu optimieren, werden Magnetkerne mit einer von Vakuum (bzw. Luft) abweichenden Permeabilitätszahl eingesetzt. Diese Magnetkerne weisen ein nichtlineares Verhalten auf.

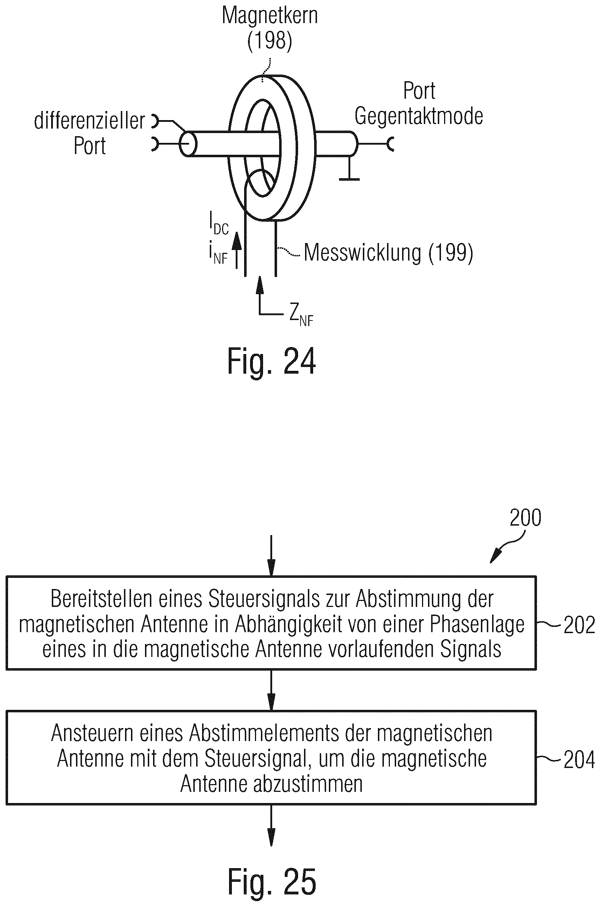

Mithilfe einer Messwicklung oder eines Hallsensors können magnetische Gleichströme, die durch das nichtlineare verhalten des Magnetkerns entstehen, erfasst werden, wie dies in Fig. 24 gezeigt ist.

Im Detail zeigt Fig. 24 eine schematische Ansicht eines Magnetkerns 198 eines Baluns 196 sowie einer Messwicklung 199 um den Magnetkern 198 zur Erfassung der Gleichtakteigenschaften des Baluns über die nichtlinearen Eigenschaften des Magnetkerns 198 mithilfe der Messwicklung.

2.4.4. Ausführungsbeispiele

Bei Ausführungsbeispielen kann das Gerät (z.B. der Teilnehmer 102 bzw. die Abstimmeinrichtung 120 des Teilnehmers 100) den Stromverbrauch des bzw. der Leistungstransistoren (aktiven Bauelemente) messen (z.B. zur Erzeugung des Abstimmsignals (z.B. Abstimmspannung)).

Bei Ausführungsbeispielen kann das Gerät (z.B. der Teilnehmer 102 bzw. die Abstimmeinrichtung 120 des Teilnehmers 100) die Differenz der Versorgungsströme von zwei Leistungstransistoren zur Erzeugung einer Abstimmspannung bestimmen.

Bei Ausführungsbeispielen kann das Gerät (z.B. der Teilnehmer 102 bzw. die Abstimmeinrichtung 120 des Teilnehmers 100) einen Biasstrom des bzw. der Leistungstransistoren (z.B. der Sendeeinrichtung 102) zur Erzeugung einer Abstimmspannung 122 erfassen (z.B. messen).

Bei Ausführungsbeispielen kann das Gerät (z.B. der Teilnehmer 102 bzw. die Abstimmeinrichtung 120 des Teilnehmers 100) einen Biasstrom des bzw. der Leistungstransistoren (z.B. der Sendeeinrichtung 102) durch Messung einer Spannung über einen Widerstand im Biaszweig ermitteln (z.B. bestimmen).

Bei Ausführungsbeispielen kann das Gerät (z.B. der Teilnehmer 102 bzw. die Abstimmeinrichtung 120 des Teilnehmers 100) eine Differenz der Biasströme von zwei Leistungstransistoren (z.B. der Sendeeinrichtung 102) zur Erzeugung eines Abstimmsignals 122 (z.B. Abstimmspannung) ermitteln (z.B. bestimmen).

Bei Ausführungsbeispielen kann das Gerät (z.B. der Teilnehmer 102 bzw. die Abstimmeinrichtung 120 des Teilnehmers 100) eine Differenz der Ströme eines Verstärkers im Balanced-Betrieb zur Erzeugung eines Abstimmsignals 122 (z.B. Abstimmspannung) ermitteln (z.B. bestimmen).

Bei Ausführungsbeispielen kann das Gerät (z.B. der Teilnehmer 102 bzw. die Abstimmeinrichtung 120 des Teilnehmers 100) eine Differenz der Ströme eines Verstärkers im Doherty-Betrieb zur Erzeugung eines Abstimmsignals 122 (z.B. Abstimmspannung) ermitteln (z.B. bestimmen).

Bei Ausführungsbeispielen kann das Gerät (z.B. der Teilnehmer 102 bzw. die Abstimmeinrichtung 120 des Teilnehmers 100) eine Differenz der Ströme eines Verstärkers im Gegentakt-Betrieb zur Erzeugung eines Abstimmsignals 122 (z.B. Abstimmspannung) ermitteln (z.B. bestimmen).

Bei Ausführungsbeispielen kann das Gerät (z.B. der Teilnehmer 102 bzw. die Abstimmeinrichtung 120 des Teilnehmers 100) eine Gleichtaktimpedanz einer magnetischen Antenne 106 zur Erzeugung eines Abstimmsignals (z.B. Abstimmspannung) ermitteln (z.B. bestimmen).

Bei Ausführungsbeispielen kann das Gerät (z.B. der Teilnehmer 102 bzw. die Abstimmeinrichtung 120 des Teilnehmers 100) eine Gleichtaktimpedanz (z.B. der magnetischen Antenne 106) mithilfe eines Messsignals ermitteln (z.B. bestimmen).

Bei Ausführungsbeispielen kann das Gerät (z.B. der Teilnehmer 102 bzw. die Abstimmeinrichtung 120 des Teilnehmers 100) abwechselnd ein Gegentakt- und ein Gleichtaktsignal in die magnetische Antenne 106 einspeisen und den Stromverbrauch ermitteln und diese Information zur Erzeugung eines Abstimmsignals 122 (z.B. Abstimmspannung) nutzen.

Bei Ausführungsbeispielen kann das Gerät (z.B. der Teilnehmer 102 bzw. die Abstimmeinrichtung 120 des Teilnehmers 100) ein Gleichtaktsignal (z.B. in die magnetische Antenne 106) mithilfe eines Baluns 196 einspeisen, das einen Zugriff auf die Gleichtaktmode ermöglicht.

Bei Ausführungsbeispielen kann das Gerät (z.B. der Teilnehmer 102 bzw. die Abstimmeinrichtung 120 des Teilnehmers 100) ein reflektiertes Gleichtaktsignal einer magnetischen Antenne 106 zur Erzeugung eines Abstimmsignals (z.B. Abstimmspannung) ermitteln (z.B. messen).

Bei Ausführungsbeispielen kann das Gerät (z.B. der Teilnehmer 102 bzw. die Abstimmeinrichtung 120 des Teilnehmers 100) ein Gleichtaktsignal (z.B. der magnetischen Antenne 106) mithilfe eines Baluns ermitteln (z.B. messen), das einen Zugriff auf die Gleichtaktmode ermöglicht.

Bei Ausführungsbeispielen kann das Gerät (z.B. der Teilnehmer 102 bzw. die Abstimmeinrichtung 120 des Teilnehmers 100) Zugriff auf die Gleichtaktmode (z.B. der magnetischen Antenne) mithilfe eines Ringkopplers haben.

Bei Ausführungsbeispielen kann das Gerät (z.B. der Teilnehmer 102 bzw. die Abstimmeinrichtung 120 des Teilnehmers 100) Zugriff auf die Gleichtaktmode (z.B. der magnetischen Antenne) über die nichtlinearen Eigenschaften eines Magnetkerns haben.

Bei Ausführungsbeispielen kann das Gerät (z.B. der Teilnehmer 102 bzw. die Abstimmeinrichtung 120 des Teilnehmers 100) nichtlineare Eigenschaften eines Magnetkerns (z.B. eines Baluns 196) zur Messung eines magnetischen Gleichstroms mithilfe eines Hallsensors nutzen.

Bei Ausführungsbeispielen kann das Gerät (z.B. der Teilnehmer 102 bzw. die Abstimmeinrichtung 120 des Teilnehmers 100) nichtlineare Eigenschaften eines Magnetkerns (z.B. eines Baluns 196) zur Messung eines magnetischen Gleichstroms mithilfe einer Messwicklung am Magnetkern nutzen.

3. Weitere Ausführungsbeispiele

Fig. 25 zeigt ein Flussdiagramm eines Verfahrens 200 zum Abstimmen einer magnetischen Antenne mit einer einfach oder mehrfach unterbrochenen Schleife, gemäß einem Ausführungsbeispiel der vorliegenden Erfindung. Das Verfahren 200 umfasst einen Schritt 202 des Bereitstellens eines Steuersignals zur Abstimmung der magnetischen Antenne in Abhängigkeit von einer Phasenlage eines in die magnetische Antenne vorlaufenden Signals. Ferner umfasst das Verfahren 220 einen Schritt 222 des Ansteuerns eines Abstimmelements der magnetischen Antenne mit dem Steuersignal, um die magnetische Antenne abzustimmen.

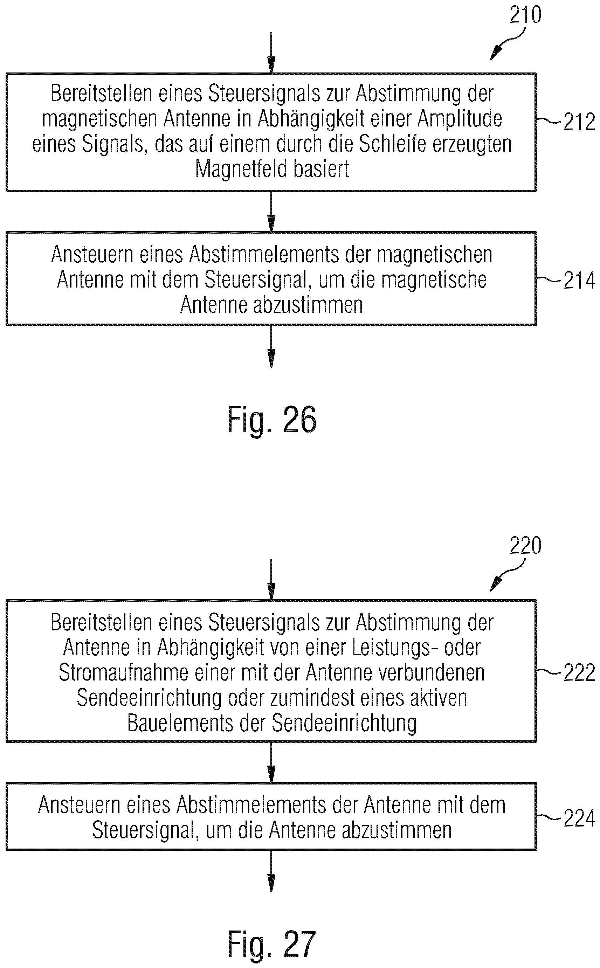

Fig. 26 zeigt ein Flussdiagramm eines Verfahrens 210 zum Abstimmen einer magnetischen Antenne mit einer einfach oder mehrfach unterbrochenen Schleife, gemäß einem Ausführungsbeispiel der vorliegenden Erfindung. Das Verfahren 210 umfasst einen Schritt 212 des Bereitstellens eines Steuersignals zur Abstimmung der magnetischen Antenne in Abhängigkeit einer Amplitude eines Signals, das auf einem durch die Schleife erzeugten Magnetfeld basiert. Ferner umfasst das Verfahren 210 einen Schritt 212 des Ansteuerns eines Abstimmelements der magnetischen Antenne mit dem Steuersignal, um die magnetische Antenne abzustimmen.

Fig. 27 zeigt ein Flussdiagramm eines Verfahrens 220 zum Abstimmen einer Antenne, gemäß einem Ausführungsbeispiel der vorliegenden Erfindung. Das Verfahren 220 umfasst einen Schritt 222 des Bereitstellens eines Steuersignals zur Abstimmung der Antenne in Abhängigkeit von einer Leistungs- oder Stromaufnahme einer mit der Antenne verbundenen Sendeeinrichtung oder zumindest eines aktiven Bauelements der Sendeeinrichtung. Ferner umfasst das Verfahren 220 einen Schritt 222 des Ansteuerns eines Abstimmelements der Antenne mit dem Steuersignal, um die Antenne abzustimmen.

Ausführungsbeispiele der vorliegenden Erfindung schaffen (z.B. selbstabstimmende) magnetische Antennen für z. B. Sensorknoten. Mit dem IoT, dem Internet der Dinge (engl. Internet of Things) wächst die Anzahl der drahtlos kommunizierenden Sensorknoten. Hierbei werden auch immer stärkere Anforderungen an einen kleinen Formfaktor und eine einfache Handhabbarkeit gestellt. Diese Anforderungen können mit bestehenden elektrischen Antennen nur schlecht erfüllt werden. Ausführungsbeispiele der vorliegenden Erfindung ermöglichen es magnetische Antennen in Sensorknoten einzusetzen und somit die vorgenannten Anforderungen zu erfüllen.

Die hierin beschriebenen Ausführungsbeispiele der Antennenanordnung bzw. der Erzeugung des Abstimmsignals zur Abstimmung einer magnetischen Antenne können in einem Kommunikationssystem, wie es Beispielsweise im ETSI Standard TS 103 357 [7] spezifiziert ist, Anwendung finden. Natürlich können die hierin beschriebenen Ausführungsbeispiele auch in anderen Kommunikationssystemen Anwendung finden, wie z.B. WLAN, Bluetooth, ZigBee, usw.

Im Folgenden werden weitere Ausführungsbeispiele der vorliegenden Erfindung beschrieben, die in Kombination mit den oben beschriebenen Ausführungsbeispielen oder aber auch für sich allein genommen angewendet werden können.

Ausführungsbeispiele schaffen einen Teilnehmer eines drahtlosen Kommunikationssystems, wobei der Teilnehmer eine Sende- und/oder Empfangseinrichtung [z.B. einen Transmitter, Receiver oder Transceiver] und eine mit der Sende- und/oder-Empfangseinrichtung verbundene Antennenanordnung aufweist, wobei die Antennenanordnung eine magnetische Antenne mit einer einfach oder mehrfach [z.B. zumindest zweifach] unterbrochenen [z.B. unterteilten] Schleife [z.B. Stromschleife] aufweist.

Bei Ausführungsbeispielen kann die Schleife durch ein oder mehrere Kapazitätselemente [z.B. Kondensatoren, Kapazitätsdioden] unterbrochen [z.B. unterteilt] sein.

Beispielsweise kann die Schleife der magnetischen Antenne durch zumindest zwei Kapazitätselemente [z.B. zumindest zweifach] unterbrochen sein.

Bei Ausführungsbeispielen kann die mehrfach unterbrochene Schleife durch die Kapazitätselemente in zumindest zwei Segmente unterbrochen [z.B. unterteilt] sein.

Beispielsweise kann die Schleife durch n Kapazitätselemente in n Segmente unterteilt sein, wobei n eine natürliche Zahl größer gleich zwei ist.

Bei Ausführungsbeispielen können die zumindest zwei Segmente der mehrfach unterbrochenen Schleife durch die Kapazitätselemente verbunden sein.

Beispielsweise können die zumindest zwei Segmente der mehrfach unterbrochenen Schleife und die zumindest zwei Kapazitätselemente in Reihe geschaltet sein. Mit anderen Worten, jeweils zwei Segmente der mehrfach unterbrochenen Schleife können durch jeweils ein Kapazitätselement, das in Reihe zwischen den zwei Segmenten geschaltet ist, verbunden sein.

Bei Ausführungsbeispielen können die einfach oder mehrfach unterbrochene Schleife [z.B. die zumindest zwei Segmente der Schleife] und die Kapazitätselemente einen Schwingkreis bilden.

Bei Ausführungsbeispielen kann die Schleife eine Spule bilden.

Bei Ausführungsbeispielen kann die Sende- und/oder Empfangseinrichtung mit der magnetischen Antenne über eines der Kapazitätselemente verbunden sein [z.B. wobei das eine Kapazitätselement und die einfach oder mehrfach unterbrochene Schleife [z.B. mit den anderen Kapazitätselementen] einen Parallelschwingkreis bilden].

Bei Ausführungsbeispielen kann die Schleife ringförmig oder m-eckförmig ist, wobei m eine natürliche Zahl größer gleich vier ist.

Beispielsweise kann die Schleife viereckförmig, fünfeckförmig, sechseckförmig, siebeneckförmig, achteckförmig, neuneckförmig, zehneckförmig, elfeckförmig, zwölfeckförmig usw. sein.

Bei Ausführungsbeispielen kann die magnetische Antenne auf einer Leiterplatte implementiert [z.B. realisiert] sein.

Bei Ausführungsbeispielen kann die Antennenanordnung eine Abstimmungsschaltung zur Abstimmung der magnetischen Antenne aufweisen.

Bei Ausführungsbeispielen können die Abstimmungsschaltung und die magnetische Antenne auf der gleichen Leiterplatte implementiert sein.

Bei Ausführungsbeispielen kann die magnetische Antenne eine erste magnetische Antenne sein, wobei die Antennenanordnung ferner eine zweite magnetische Antenne aufweisen kann, wobei die einfach oder mehrfach unterbrochene Schleife der ersten magnetischen Antenne und eine Schleife der zweiten magnetische Antenne im Wesentlichen orthogonal zueinander angeordnet sind.

Beispielsweise können eine durch die einfach oder mehrfach unterbrochene Schleife der ersten magnetischen Antenne aufgespannte erste Fläche und eine durch die Schleife der zweiten magnetischen Antenne aufgespannte zweite Fläche orthogonal zueinander sein.

Beispielsweise können eine Hauptabstrahlrichtung/Hauptempfangsrichtung der ersten magnetischen Antenne und eine Hauptabstrahlrichtung/Hauptempfangsrichtung der zweiten magnetischen Antenne orthogonal zueinander sein.

Beispielsweise können eine Nullstelle der ersten magnetischen Antenne und eine Nullstelle der zweiten magnetischen Antenne unterschiedlichen sein.

Bei Ausführungsbeispielen kann eine aufgespannte Fläche der Schleife der zweiten magnetischen Antenne zumindest um den Faktor zwei [z.B. um den Faktor drei, vier, fünf, oder zehn] kleiner sein als eine aufgespannte Fläche der Schleife der ersten magnetischen Antenne.

Beispielsweise kann die Schleife der zweiten magnetischen Antenne "plattgedrückt" sein.

Bei Ausführungsbeispielen kann die Schleife der zweiten magnetischen Antenne nicht rund ausgeführt sein, um sich einer Form des Gehäuses des Teilnehmers anzupassen.

Beispielsweise kann die Schleife der zweiten magnetischen Antenne im Wesentlichen rechteckförmig sein.

Bei Ausführungsbeispielen können die erste magnetische Antenne und die zweite magnetische Antenne benachbart zueinander angeordnet sein.

Bei Ausführungsbeispielen kann ein Leiter der Schleife der zweiten magnetischen Antenne zumindest um den Faktor zwei [z.B. um den Faktor drei, vier oder fünf] dicker oder breiter ist als ein Leiter der Schleife der ersten magnetischen Antenne.

Bei Ausführungsbeispielen kann die Schleife der zweiten magnetischen Antenne mehrfach unterbrochen sein.

Beispielsweise kann die Schleife der zweiten magnetischen Antenne durch zumindest zwei Kapazitätselemente [zumindest zweifach] unterbrochen sein.

Bei Ausführungsbeispielen kann der Teilnehmer ausgebildet sein, um eine der magnetischen Antennen der Antennenanordnung [z.B. die erste magnetische Antenne oder die zweite magnetische Antenne] zu deaktivieren, um eine Strahlungscharakteristik [z.B. Abstrahlrichtung oder Empfangsrichtung; z.B. Hauptkeule] der Antennenanordnung zu verändern.

Beispielsweise kann der Teilnehmer ausgebildet sein, um eine Strahlungscharakteristik [z.B. Abstrahlrichtung oder Empfangsrichtung; z.B. Hauptkeule] der Antennenanordnung durch Deaktivieren einer der magnetischen Antennen der Antennenanordnung [z.B. der ersten magnetischen Antenne oder der zweiten magnetischen Antenne] zu verändern.

Bei Ausführungsbeispielen kann eine der magnetischen Antennen der Antennenanordnung durch Verstimmen der jeweiligen magnetischen Antenne [z.B. der ersten magnetischen Antenne oder der zweiten magnetischen Antenne] deaktiviert werden.

Bei Ausführungsbeispielen kann eine der magnetischen Antennen der Antennenanordnung durch Parallelschalten einer Spule zu einem der Kapazitätselemente der Schleife der jeweiligen magnetischen Antenne [z.B. der ersten magnetischen Antenne oder der zweiten magnetischen Antenne] deaktiviert werden.

Bei Ausführungsbeispielen kann der Teilnehmer ausgebildet sein, um ein Abstrahlverhältnis der Antennenanordnung durch Verstimmen der Eigenresonanz zumindest einer der zwei magnetischen Antennen [z.B. der ersten magnetischen Antenne oder der zweiten magnetischen Antenne] zu verändern.

Bei Ausführungsbeispielen können die erste magnetische Antenne und die zweite magnetische Antenne phasenverschoben [z.B. um 90°] angesteuert werden.

Bei Ausführungsbeispielen kann der Teilnehmer ausgebildet sein, um ein zu übertragenes Datenpaket [z.B. der Bitübertragungsschicht] auf eine Mehrzahl von Sub-Datenpaketen aufzuteilen und um die Mehrzahl von Sub-Datenpaketen nicht zusammenhängend zu senden [z.B. unter Verwendung eines Zeit- und/oder Frequenzsprungverfahrens], wobei der Teilnehmer ausgebildet sein kann, um die Strahlungscharakteristik der Antennenanordnung zumindest einmal zwischen der Aussendung zweier Sub-Datenpakten zu verändern.

Beispielsweise kann der Teilnehmer ausgebildet sein, um die Strahlungscharakteristik der Antennenanordnung nach jedem ausgesendeten Sub-Datenpaketes oder nach einer vorgebenden Anzahl von Sub-Datenpaketen zu verändern [z.B. durch deaktivieren der jeweils anderen magnetischen Antenne der Antennenanordnung].

Bei Ausführungsbeispielen kann der Teilnehmer ausgebildet sein, um ein zu übertragenes Datenpaket [z.B. der Bitübertragungsschicht] auf eine Mehrzahl von Sub-Datenpaketen aufzuteilen und um die Mehrzahl von Sub-Datenpaketen nicht zusammenhängend unter Verwendung eines Frequenzsprungverfahrens [z.B. und Zeitsprungverfahrens] zu senden, wobei die Resonanzfrequenzen der ersten magnetischen Antenne und der zweiten magnetischen Antenne absichtlich etwas verstimmt sein können, so dass bei der Aussendung der Mehrzahl von Subdatenpaketen bedingt durch die durch das Frequenzsprungmuster definierten Frequenzen eine Strahlungscharakteristik [z.B. Abstrahlrichtung; z.B. Hauptkeule] der Antennenanordnung variiert.

Beispielsweise kann die Resonanzfrequenz der ersten magnetischen Antenne und/oder der zweiten magnetischen Antenne in einem Größenbereich verstimmt werden, der der reziproken Güte entspricht. Bei einer Güte von Q = 100 kann die Verstimmung in einem Fenster von nicht mehr als +/- 1% erfolgen, weil bei noch stärkerer Verstimmung dann kaum mehr Leistung raus geht.

Bei Ausführungsbeispielen kann die Antennenanordnung eine Abstimmeinrichtung zum Abstimmen der magnetischen Antenne aufweisen, wobei die Antennenanordnung ausgebildet ist, um die Antenne automatisch abzustimmen.

Bei Ausführungsbeispielen kann die Antennenanordnung ferner eine elektrische Antenne aufweisen.

Bei Ausführungsbeispielen kann die Sende- und/oder Empfangseinrichtung eine Sendeeinrichtung [z.B. Transmitter], eine Empfangseinrichtung [z.B. Receiver] oder eine Sendeempfangseinrichtung [Transceiver] sein.

Bei Ausführungsbeispielen kann der Teilnehmer ausgebildet sein, um im ISM Band zu kommunizieren.

Bei Ausführungsbeispielen kann der Teilnehmer ein Endpunkt des Kommunikationssystems sein.

Bei Ausführungsbeispielen kann der Endpunkt ein Sensorknoten oder Aktorknoten sein.

Bei Ausführungsbeispielen kann der Endpunkt batteriebetrieben sein.

Bei Ausführungsbeispielen kann der Endpunkt ein Energy Harvesting Element zur elektrischen Energiegewinnung aufweisen.

Bei Ausführungsbeispielen kann der Teilnehmer eine Basisstation des Kommunikationssystems sein.

Weitere Ausführungsbeispiele schaffen ein Kommunikationssystem mit zumindest zwei der hierin beschriebenen Teilnehmer.

Beispielsweise kann es sich bei den zumindest zwei Teilnehmern um einen oder mehrere Endpunkte [z.B. eine Vielzahl von Endpunkten] und eine oder mehrere Basisstation handeln. Natürlich kann es sich bei den zumindest zwei Teilnehmern auch um zumindest zwei Endpunkte oder Basisstationen handeln.

Weitere Ausführungsbeispiele schaffen ein Verfahren zum Betreiben eines Teilnehmers eines Kommunikationssystems, wobei der Teilnehmer eine Antennenanordnung aufweist, wobei die Antennenanordnung eine magnetische Antenne mit einer einfach oder mehrfach unterbrochenen Schleife aufweist. Das Verfahren umfasst einen Schritt des Sendens und/oder Empfangens von Kommunikationssignalen unter Verwendung der magnetischen Antenne.

Ausführungsbeispiele der vorliegenden Erfindung schaffen einen Teilnehmer (z.B. einen Endpunkt) eines Kommunikationssystems mit einer magnetischen Antenne.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder eine elektronische Schaltung ausgeführt werden. Bei einigen Ausführungsbeispielen können einige oder mehrere der wichtigsten Verfahrensschritte durch einen solchen Apparat ausgeführt werden.

Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer Blu-ray Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein.

Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft.

Der Programmcode kann beispielsweise auch auf einem maschinenlesbaren Träger gespeichert sein.

Andere Ausführungsbeispiele umfassen das Computerprogramm zum Durchführen eines der hierin beschriebenen Verfahren, wobei das Computerprogramm auf einem maschinenlesbaren Träger gespeichert ist.

Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft.

Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist. Der Datenträger, das digitale Speichermedium oder das computerlesbare Medium sind typischerweise gegenständlich und/oder nichtvergänglich bzw. nichtvorübergehend.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Ein weiteres Ausführungsbeispiel gemäß der Erfindung umfasst eine Vorrichtung oder ein System, die bzw. das ausgelegt ist, um ein Computerprogramm zur Durchführung zumindest eines der hierin beschriebenen Verfahren zu einem Empfänger zu übertragen. Die Übertragung kann beispielsweise elektronisch oder optisch erfolgen. Der Empfänger kann beispielsweise ein Computer, ein Mobilgerät, ein Speichergerät oder eine ähnliche Vorrichtung sein. Die Vorrichtung oder das System kann beispielsweise einen Datei-Server zur Übertragung des Computerprogramms zu dem Empfänger umfassen.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die hierin beschriebenen Vorrichtungen können beispielsweise unter Verwendung eines Hardware-Apparats, oder unter Verwendung eines Computers, oder unter Verwendung einer Kombination eines Hardware-Apparats und eines Computers implementiert werden.

Die hierin beschriebenen Vorrichtungen, oder jedwede Komponenten der hierin beschriebenen Vorrichtungen können zumindest teilweise in Hardware und/oder in Software (Computerprogramm) implementiert sein.

Die hierin beschriebenen Verfahren können beispielsweise unter Verwendung eines Hardware-Apparats, oder unter Verwendung eines Computers, oder unter Verwendung einer Kombination eines Hardware-Apparats und eines Computers implementiert werden.

Die hierin beschriebenen Verfahren, oder jedwede Komponenten der hierin beschriebenen Verfahren können zumindest teilweise durch Hardware und/oder durch Software ausgeführt werden.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

<u>Literaturverzeichnis</u>

[1] https://de.wikipedia.org/wiki/Schwingkreis

[2] J. Bollenbeck, R. Oppelt: "Ein neuartiges Tracking-Filter für hochwertige LO-Signale", UKW-Berichte 3/2013, S.

157 - 176

[3] US 7,890,070

[4] https://de.wikipedia.org/wiki/Gilbertzelle

[5] J. v. Parpart: "Breitbandige Ferrit-Hochfrequenztransformatoren", Hüthig GmbH, Heidelberg, 1997

[6] DE 10 2011 082 098 B4

[7] ETSI TS 103 357

[8] Klaus W. Kark: "Antennen und Strahlungsfelder", 5. Auflage, Springer Verlag, S. 233

**Patentansprüche**

1. Antennenanordnung (104), mit folgenden Merkmalen:

   einer magnetischen Antenne (106) mit einer einfach oder mehrfach unterbrochenen Schleife (108) und zumindest einem Abstimmelement (111) zur Abstimmung der magnetischen Antenne (106), und
   einer Abstimmeinrichtung (120), die mit dem Abstimmelement (111) verbunden ist,
   wobei die Abstimmeinrichtung (120) ausgebildet ist, um ein Steuersignal (122) zur Abstimmung der magnetischen Antenne (106) in Abhängigkeit von einer Phasenlage eines in die magnetische Antenne (106) vorlaufenden Signals (124) bereitzustellen, und um das Abstimmelement (111) mit dem Steuersignal (122) anzusteuern, um die magnetische Antenne (106) abzustimmen,
   wobei die Abstimmeinrichtung (120) ausgebildet, um das Steuersignal (122) zur Abstimmung der magnetischen Antenne (106) in Abhängigkeit von einer Phasenbeziehung zwischen des in die magnetische Antenne (106) vorlaufenden Signals (124) und einem Phasensignal (126) bereitzustellen,
   wobei die Abstimmeinrichtung (120) ausgebildet ist, um von dem in die magnetische Antenne (106) vorlaufenden Signals (124) ein Signal abzuleiten, um ein abgeleitetes Signal (132) zu erhalten,
   wobei die Abstimmeinrichtung (120) ausgebildet, um das Steuersignal (122) zur Abstimmung der magnetischen Antenne (106) in Abhängigkeit von einer Phasenbeziehung zwischen dem abgeleiteten Signal (132) und dem Phasensignal (126) bereitzustellen,
   wobei die Abstimmeinrichtung (120) einen Signalkombinierer (136) aufweist, der ausgebildet ist, um

   - das Phasensignal (126) oder eine phasenverschobene Version des Phasensignals (126), und
   - das abgeleitete Signal (132) oder eine phasenverschobene Version (138) des abgeleiteten Signals (132),

   zu kombinieren, um ein kombiniertes Signal (140) zu erhalten,
   wobei die Abstimmeinrichtung (120) ausgebildet ist, um das Abstimmelement (111) mit dem Steuersignal (122) anzusteuern, um einen Gleichanteil des kombinierten Signals (140) oder eine tiefpassgefilterte Version (146) des kombinierten Signals (140) auf einen vorgegebenen Sollwert hin zu regeln.

2. Antennenanordnung (104) nach Anspruch 1,
   wobei das Phasensignal (126) auf einem in zumindest einem Abschnitt der Schleife (108) fließenden Strom basiert.

3. Antennenanordnung (104) nach einem der Ansprüche 1 bis 2,
   wobei das Phasensignal (126) auf einem durch die Schleife (108) erzeugten Magnetfeld basiert.

4. Antennenanordnung (104) nach einem der Ansprüche 1 bis 3,
   wobei das Phasensignal (126) eine aus der magnetischen Antenne (106) ausgekoppelte Leistung ist.

5. Antennenanordnung (104) nach einem der Ansprüche 1 bis 4,
   wobei die Abstimmeinrichtung (120) ausgebildet ist, um das Abstimmelement (111) mit dem Steuersignal (122) anzusteuern, um eine Phasendifferenz zwischen des in die magnetische Antenne (106) vorlaufenden Signals (124) und dem Phasensignal (126) auf einen vorgegebenen Sollwert hin zu regeln.

**6.** Antennenanordnung (104) gemäß einem der Ansprüche 1 bis 5,

wobei die Schleife (108) einfach unterbrochen ist,
wobei die Schleife (108) durch das Abstimmelement (111) unterbrochen ist.

**7.** Antennenanordnung (104) gemäß einem der Ansprüche 1 bis 6,

wobei die Schleife (108) mehrfach unterbrochen ist,
wobei die Schleife (108) durch das Abstimmelement (111) und durch ein oder mehrere Kapazitätselemente (110) unterbrochen ist.

**8.** Antennenanordnung (104) nach einem der Ansprüche 1 bis 7,
wobei das Abstimmelement (111) ein variabler Kondensator oder eine Kapazitätsdiode ist.

**9.** Antennenanordnung (104) nach einem der Ansprüche 1 bis 8,
wobei ein Schleifenumfang der einfach oder mehrfach unterbrochenen Schleife 1/2 bis 1/10 einer Wellenlänge des in die magnetische Antenne vorlaufenden Signals oder eines mit der magnetischen Antenne auszusendenden Sendesignals oder zu empfangenden Empfangssignals beträgt.

**10.** Antennenanordnung (104) nach einem der Ansprüche 1 bis 9,
wobei eine Frequenz des in die magnetische Antenne vorlaufenden Signals oder eines mit der magnetischen Antenne auszusendenden Sendesignals oder zu empfangenden Empfangssignals größer gleich 149 MHz, 400 MHz oder 800 MHz ist oder im Bereich von 149 MHz bis 930 MHz liegt.

**11.** Antennenanordnung (104) nach einem der Ansprüche 1 bis 10,
wobei eine Frequenz des in die magnetische Antenne vorlaufenden Signals oder eines mit der magnetischen Antenne auszusendenden Sendesignals oder zu empfangenden Empfangssignals innerhalb eines ISM Bands liegt.

**12.** Antennenanordnung (104) nach einem der Ansprüche 1 bis 11,
wobei die magnetische Antenne eine Güte von 20 bis 500 aufweist.

**13.** Teilnehmer (100) eines drahtlosen Kommunikationssystems,
wobei der Teilnehmer (100) eine Sende- und/oder Empfangseinrichtung (102) und eine mit der Sende- und/oder Empfangseinrichtung (102) verbundene Antennenanordnung (104) gemäß einem der Ansprüche 1 bis 12 aufweist.

**14.** Verfahren (200) zum Abstimmen einer magnetischen Antenne (106) mit einer einfach oder mehrfach unterbrochenen Schleife (108), mit folgenden Schritten:

Bereitstellen (202) eines Steuersignals (122) zur Abstimmung der magnetischen Antenne (106) in Abhängigkeit von einer Phasenlage eines in die magnetische Antenne (106) vorlaufenden Signals (124), und
Ansteuern (204) eines Abstimmelements (111) der magnetischen Antenne (106) mit dem Steuersignal, um die magnetische Antenne (106) abzustimmen,
wobei das Steuersignal (122) zur Abstimmung der magnetischen Antenne (106) in Abhängigkeit von einer Phasenbeziehung zwischen des in die magnetische Antenne (106) vorlaufenden Signals (124) und einem Phasensignal (126) bereitgestellt wird,
Ableiten eines Signals von dem in die magnetische Antenne (106) vorlaufenden Signals (124), um ein abgeleitetes Signal (132) zu erhalten,
wobei das Steuersignal (122) zur Abstimmung der magnetischen Antenne (106) in Abhängigkeit von einer Phasenbeziehung zwischen dem abgeleiteten Signal (132) und dem Phasensignal (126) bereitgestellt wird,
wobei

- das Phasensignal (126) oder eine phasenverschobene Version des Phasensignals (126), und
- das abgeleitete Signal (132) oder eine phasenverschobene Version (138) des abgeleiteten Signals (132),

kombinier werden, um ein kombiniertes Signal (140) zu erhalten,
Ansteuern des Abstimmelements (111) mit dem Steuersignal (122), um einen Gleichanteil des kombinierten Signals (140) oder eine tiefpassgefilterte Version (146) des kombinierten Signals (140) auf einen vorgegebenen Sollwert hin zu regeln.

**15.** Computerprogramm zur Durchführung des Verfahrens nach Anspruch 14.

**Claims**

**1.** Antenna arrangement (104), comprising:

a magnetic antenna (106) comprising a loop (108) interrupted one or several times and at least one tuning element (111) for tuning the magnetic antenna (106), and
tuning means (120) connected to the tuning element (111),
wherein the tuning means (120) is configured to provide a control signal (122) for tuning the magnetic antenna (106) in dependence on a phase position of a signal (124) advancing into the magnetic antenna (106), and to control the tuning element (111) with the control signal (122) to tune the magnetic antenna (106),
wherein the tuning means (120) is configured to provide the control signal (122) for tuning the magnetic antenna (106) in dependence on a phase relationship between the signal (124) advancing into the magnetic antenna (106) and a phase signal (126),
wherein the tuning means (120) is configured to derive a signal from the signal (124) advancing into the magnetic antenna (106) to obtain a derived signal (132),
wherein the tuning means (120) is configured to provide the control signal (122) for tuning the magnetic antenna (106) in dependence on a phase relationship between the derived signal (132) and the phase signal (126),
wherein the tuning means (120) comprises a signal combiner (136) configured to combine

- the phase signal (126) or a phase-shifted version of the phase signal (126), and
- the derived signal (132) or a phase-shifted version (138) of the derived signal (132),

to obtain a combined signal (140),
wherein the tuning means (120) is configured to control the tuning element (111) with the control signal (122) to regulate a DC component of the combined signal (140) or a low-pass filtered version (146) of the combined signal (140) to a predetermined set value.

**2.** Antenna arrangement (104) according to claim 1,
wherein the phase signal (126) is based on a current flowing in at least a portion of the loop (108).

**3.** Antenna arrangement (104) according to one of claims 1 to 2,
wherein the phase signal (126) is based on a magnetic field generated by the loop (108).

**4.** Antenna arrangement (104) according to one of claims 1 to 3,
wherein the phase signal (126) is a power coupled out of the magnetic antenna (106).

**5.** Antenna arrangement (104) according to one of claims 1 to 4,
wherein the tuning means (120) is configured to control the tuning element (111) with the control signal (122) to regulate a phase difference between the signal (124) advancing into the magnetic antenna (106) and the phase signal (126) to a predetermined set value.

**6.** Antenna arrangement (104) according to one of claims 1 to 5,

wherein the loop (108) is interrupted once,
wherein the loop (108) is interrupted by the tuning element (111).

**7.** Antenna arrangement (104) according to one of claims 1 to 6,

wherein the loop (108) is interrupted several times,
wherein the loop (108) is interrupted by the tuning element (111) and by one or several capacitance elements (110).

**8.** Antenna arrangement (104) according to one of claims 1 to 7,
wherein the tuning element (111) is a variable capacitor of a capacitance diode.

**9.** Antenna arrangement (104) according to one of claims 1 to 8,
wherein a loop circumference of the loop interrupted one or several times is 1/2 to 1/10 of a wavelength of the signal advancing into the magnetic antenna or of a transmitting signal to be transmitted or a receiving signal to be received with the magnetic antenna.

**10.** Antenna arrangement (104) according to one of claims 1 to 9,
wherein a frequency of the signal advancing into the magnetic antenna or of a transmitting signal to be transmitted or of a receiving signal to be received with the magnetic antenna is equal to or higher than 149 MHz, 400 MHz or 800 MHz or is in the range of 149 MHz to 930 MHz.

**11.** Antenna arrangement (104) according to one of claims 1 to 10,
wherein a frequency of the signal advancing into the magnetic antenna or of a transmitting signal to be transmitted or of a receiving signal to be received with the magnetic antenna is within an ISM band.

**12.** Antenna arrangement (104) according to one of claims 1 to 11,
wherein the magnetic antenna comprises a Q of 20 to 500.

**13.** Participant (100) of a wireless communication system,
wherein the participant (100) comprises a transmitting and/or receiving means (102) and an antenna arrangement (104) connected to the transmitting and/or receiving means according to one of claims 1 to 12.

**14.** Method (200) for tuning a magnetic antenna (106) with a loop (108) interrupted one or several times, comprising:

providing (202) a control signal (122) for tuning the magnetic antenna (106) in dependence on a phase position of a signal (124) advancing into the magnetic antenna (106), and
controlling (204) a tuning element (111) of the magnetic antenna (106) with the control signal (122) to tune the magnetic antenna (106),
wherein the control signal (122) for tuning the magnetic antenna (106) is provided in dependence on a phase relationship between the signal (124) advancing into the magnetic antenna (106) and a phase signal (126),
deriving a signal from the signal (124) advancing into the magnetic antenna (106) to obtain a derived signal (132),
wherein the control signal (122) for tuning the magnetic antenna (106) is provided in dependence on a phase relationship between the derived signal (132) and the phase signal (126),
wherein

- the phase signal (126) or a phase-shifted version of the phase signal (126), and
- the derived signal (132) or a phase-shifted version (138) of the derived signal (132),

are combined to obtain a combined signal (140),
controlling the tuning element (111) with the control signal (122) to control a DC component of the combined signal (140) or a low-pass filtered version (146) of the combined signal (140) to a predetermined set value.

**15.** Computer program for performing the method according to claim 14.

**Revendications**

**1.** Système d'antenne (104) doté des caractéristiques suivantes :

une antenne magnétique (106) avec une boucle interrompue une ou plusieurs fois (108) et au moins un élément d'accordage (111) pour accorder l'antenne magnétique (106), et
un composant d'accordage (120) qui est relié à l'élément d'accordage (111),
dans lequel le composant d'accordage (120) est configuré pour fournir un signal de commande (122) pour accorder l'antenne magnétique (106) en fonction d'une position de phase d'un signal (124) avançant dans l'antenne magnétique (106) et pour contrôler l'élément d'accordage (111) avec le signal de commande (122) afin d'accorder l'antenne magnétique (106),
dans lequel le composant d'accordage (120) est configuré pour fournir le signal de commande (122) pour accorder l'antenne magnétique (106) en fonction d'un rapport de phase entre le signal (124) avançant dans l'antenne magnétique (106) et un signal de phase (126),

dans lequel le composant d'accordage (120) est configuré pour dériver un signal du signal (124) avançant dans l'antenne magnétique (106) afin d'obtenir un signal dérivé (132),

dans lequel le composant d'accordage (120) est configuré pour fournir le signal de commande (122) pour accorder l'antenne magnétique (106) en fonction d'un rapport de phase entre le signal dérivé (132) et le signal de phase (126),

dans lequel le composant d'accordage (120) comporte un combineur de signaux (136) qui est configuré pour combiner

- le signal de phase (126) ou une version déphasée du signal de phase (126) et
- le signal dérivé (132) ou une version déphasée (138) du signal dérivé (132) afin d'obtenir un signal combiné (140).

2. Système d'antenne (104) selon la revendication 1,
dans lequel le signal de phase (126) se base sur un courant circulant dans au moins un segment de la boucle (108).

3. Système d'antenne (104) selon une des revendications 1 à 2,
dans lequel le signal de phase (126) se base sur un champ magnétique produit par la boucle (108).

4. Système d'antenne (104) selon une des revendications 1 à 3,
dans lequel le signal de phase (126) est une puissance découplée de l'antenne magnétique (106).

5. Système d'antenne (104) selon une des revendications 1 à 4,
dans lequel le composant d'accordage (120) est configuré pour contrôler l'élément d'accordage (111) avec le signal de commande (122) afin de régler une différence de phase entre le signal (124) avançant dans l'antenne magnétique (106) et le signal de phase (126) sur une valeur de consigne prédéfinie.

6. Système d'antenne (104) selon une des revendications 1 à 5,

dans lequel la boucle (108) est interrompue une fois et
dans lequel la boucle (108) est interrompue par l'élément d'accordage (111).

7. Système d'antenne (104) selon une des revendications 1 à 6,

dans lequel la boucle (108) est interrompue plusieurs fois et
dans lequel la boucle (108) est interrompue par l'élément d'accordage (111) et par un ou plusieurs éléments de capacité (110).

8. Système d'antenne (104) selon une des revendications 1 à 7,
dans lequel l'élément d'accordage (111) est un condensateur variable ou une diode capacitive.

9. Système d'antenne (104) selon une des revendications 1 à 8,
dans lequel une étendue de boucle de la boucle interrompue une ou plusieurs fois correspond à 1/2 ou 1/10 d'une longueur d'onde du signal avançant dans l'antenne magnétique ou d'un signal d'émission à émettre ou d'un signal de réception à recevoir avec l'antenne magnétique.

10. Système d'antenne (104) selon une des revendications 1 à 9,
dans lequel une fréquence du signal avançant dans l'antenne magnétique ou d'un signal d'émission à émettre ou d'un signal de réception à recevoir avec l'antenne magnétique est égale ou supérieure à 149 MHz, 400 MHz ou 800 MHz ou se trouve sur la plage de 149 MHz à 930 MHz.

11. Système d'antenne (104) selon une des revendications 1 à 10,
dans lequel une fréquence du signal avançant dans l'antenne magnétique ou d'un signal d'émission à émettre ou d'un signal de réception à recevoir avec l'antenne magnétique trouve dans une bande une bande ISM.

12. Système d'antenne (104) selon une des revendications 1 à 11,
dans lequel l'antenne magnétique présente une présente une valeur de 20 à 500.

13. Membre (100) d'un système de communication sans fil,

lequel membre (100) comporte un composant d'émission et/ou de réception (102) et un système d'antenne (104) selon une des revendications 1 à 12 relié au composant d'émission et/ou de réception (102).

14. Procédé (200) pour accorder une antenne magnétique (106) avec une boucle interrompue une ou plusieurs fois (108), comportant les étapes suivantes :

fournir (202) un signal de commande (122) pour accorder l'antenne magnétique (106) en fonction en fonction d'une position de phase d'un signal (124) avançant dans l'antenne magnétique (106) et
contrôler un élément d'accordage (111) de l'antenne magnétique (106) avec le signal de commande afin d'accorder l'antenne magnétique (106),
le signal de commande (122) étant fourni pour accorder l'antenne magnétique (106) en fonction d'un rapport de phase entre le signal (124) avançant dans l'antenne magnétique (106) et un signal de phase (126),
dériver un signal du signal (124) avançant dans l'antenne magnétique (106) afin d'obtenir un signal dérivé (132),
le signal de commande (122) étant fourni pour accorder l'antenne magnétique (106) en fonction d'un rapport de phase entre le signal dérivé (132) et le signal de phase (126) et

- le signal de phase (126) ou une version déphasée du signal de phase (126) et
- le signal dérivé (132) ou une version déphasée (138) du signal dérivé (132) étant combinés afin d'obtenir un signal combiné (140), et

contrôler l'élément d'accord (111) avec le signal de commande (122) afin de régler une composante continue du signal combiné (140) ou une version filtrée par un filtre passe-bas (146) du signal combiné (140) sur une valeur de consigne prédéfinie.

15. Programme informatique pour mettre en œuvre le procédé selon la revendication 14.

100

104

106    108

102

Sendeeinrichtung

110

## Fig. 1a

100

104

106    108

102

Sendeeinrichtung

110    110

## Fig. 1b

100

114 — Sensor / Aktor
(optional)

112 — Prozessor
(optional)

102 — Sendeeinrichtung

104

106    108

110

## Fig. 1c

108    106

110

## Fig. 2

Fig. 3

Fig. 4

Fig. 5

Fig. 6a

Fig. 6b

104 — 106    108

102

124

Quelle z.B.
Sendeeinrichtung

110    111

128

126    122    120

Abstimmeinrichtung

## Fig. 7

180°

Phasenverschiebung

geringe
Dämpfung

90°

starke
Dämpfung

0°

Resonanzfrequenz $f_0$    Frequenz

Phasenverschiebung am
Schwingkreis bei geringer und starker
Dämpfung

## Fig. 8

Fig. 9

Stand der Technik

Fig. 10a

traforeduzierte Version 1

Fig. 10b

traforeduzierte Version 2

Fig. 10c

Fig. 11a

Fig. 11b

Fig. 12

Fig. 13

Fig. 14

Fig. 15

Fig. 16

Fig. 17a

Fig. 17b

Fig. 18

Fig. 19

Fig. 20

Fig. 21

EP 3 949 018 B1

Fig. 22

Fig. 23

Magnetkern
(198)

Port
Gegentaktmode

differenzieller
Port

$I_{DC}$

$i_{NF}$

Messwicklung (199)

$Z_{NF}$

Fig. 24

200

Bereitstellen eines Steuersignals zur Abstimmung der magnetischen Antenne in Abhängigkeit von einer Phasenlage eines in die magnetische Antenne vorlaufenden Signals ⟩~202

Ansteuern eines Abstimmelements der magnetischen Antenne mit dem Steuersignal, um die magnetische Antenne abzustimmen ⟩~204

Fig. 25

210

Bereitstellen eines Steuersignals zur Abstimmung der magnetischen Antenne in Abhängigkeit einer Amplitude eines Signals, das auf einem durch die Schleife erzeugten Magnetfeld basiert ~212

Ansteuern eines Abstimmelements der magnetischen Antenne mit dem Steuersignal, um die magnetische Antenne abzustimmen ~214

Fig. 26

220

Bereitstellen eines Steuersignals zur Abstimmung der Antenne in Abhängigkeit von einer Leistungs- oder Stromaufnahme einer mit der Antenne verbundenen Sendeeinrichtung oder zumindest eines aktiven Bauelements der Sendeeinrichtung ~222

Ansteuern eines Abstimmelements der Antenne mit dem Steuersignal, um die Antenne abzustimmen ~224

Fig. 27

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5225847 A
- US 2013016018 A1
- US 7890070 B
- DE 102011082098 B4

**In der Beschreibung aufgeführte Nicht-Patentliteratur**

- **J. BOLLENBECK** ; **R. OPPELT**. Ein neuartiges Tracking-Filter für hochwertige LO-Signale. *UKW-Berichte*, March 2013, 157-176
- **J. V. PARPART**. Breitbandige Ferrit-Hochfrequenztransformatoren. Hüthig GmbH, 1997
- **KLAUS W. KARK**. Antennen und Strahlungsfelder. Springer Verlag, 233